Europäisches Patentamt

European Patent Office

Office européen des brevets

(19)

(11)  EP 1 211 583 A2

(12)  **EUROPEAN PATENT APPLICATION**

(43) Date of publication:
    **05.06.2002 Bulletin 2002/23**

(51) Int Cl.$^7$: **G05B 19/418**

(21) Application number: **01126892.7**

(22) Date of filing: **12.11.2001**

(84) Designated Contracting States:
    **AT BE CH CY DE DK ES FI FR GB GR IE IT LI LU
    MC NL PT SE TR**
    Designated Extension States:
    **AL LT LV MK RO SI**

(30) Priority: **29.10.2001 JP 2001331550
        10.08.2001 JP 2001243870
        27.11.2000 JP 2000359553
        13.11.2000 JP 2000345417**

(71) Applicant: **SUMITOMO HEAVY INDUSTRIES, LTD.
    Shinagawa-ku, Tokyo 141-8686 (JP)**

(72) Inventors:
  • **Ibaraki, Toshihide
    Kyoto-shi, Kyoto 606-0024 (JP)**
  • **Yagiura, Mutsunori, 288,Imadegawadori
    Kyoto-shi, Kyoto 602-0846 (JP)**
  • **Nonobe, Koji
    Kyoto-shi, Kyoto 603-8045 (JP)**
  • **Nishimura, Takuya
    Kamakura-shi, Kanagawa 247-0051 (JP)**
  • **Okudaira, Yasuyuki
    Chigasaki-shi, Kanagawa 253-0085 (JP)**

(74) Representative: **Wagner, Karl H., Dipl.-Ing. et al
    WAGNER & GEYER
    Patentanwälte
    Gewürzmühlstrasse 5
    80538 München (DE)**

(54)  **Method and device for working planning**

(57)    With a two-unit area placement planning device, the distance between left and right galvano units (unit interval value) A is optimized so that the number of beam scanning and the number of moving the stage are minimized. With an area placement planning device, the area position is optimized so that the number of areas is minimized. With a stage/galvano path planning device, the distance of moving the stage and the distance of scanning by the galvano scanner are shortened by solving a traveling salesman problem. Thus, the working time with a laser drilling machine is shortened.

FIG.2

**Description**

The present invention relates generally to a method and device for working planning at the time of working a workpiece placed on a stage movable in multiple directions using working means capable of scanning or moving in multiple directions, and a method and device for producing working data therefor. The invention more particularly relates to a working planning method allowing the working time to be shortened, a working method for performing working determined by the working planning method, a computer readable recording medium recorded with a program for performing the working planning method, a working planning device achieving the working planning, a working device including the working planning device, and a method and device for producing working data therefor. The working planning method is preferably applied to a laser drilling machine for perforating a plurality of holes in a printed circuit board or the like by laser beam irradiation. According to the method, the distribution state of working positions such as perforation positions in a two-dimensional plane is mathematically interpreted and the operation of the machines is optimally planned.

In recent years, as there has been an increasing demand for electronic devices having a reduced size and an increased packaging density, multi-layer printed circuit boards having multiple layers of printed circuit boards placed on one another have been provided. In such a multi-layer printed circuit board, conductive layers formed in printed circuit boards layered on one another are electrically connected and therefore these boards are provided with through holes or via holes. A conductive film is formed in these holes in order to connect the conductive layers in the printed circuit boards.

Such holes formed in a printed circuit board tend to have a reduced size (diameter) as small as 0.1 mm or less as recent printed circuit boards have a smaller size and a higher function. A pulse oscillation type laser beam is used to precisely form holes having such a small diameter.

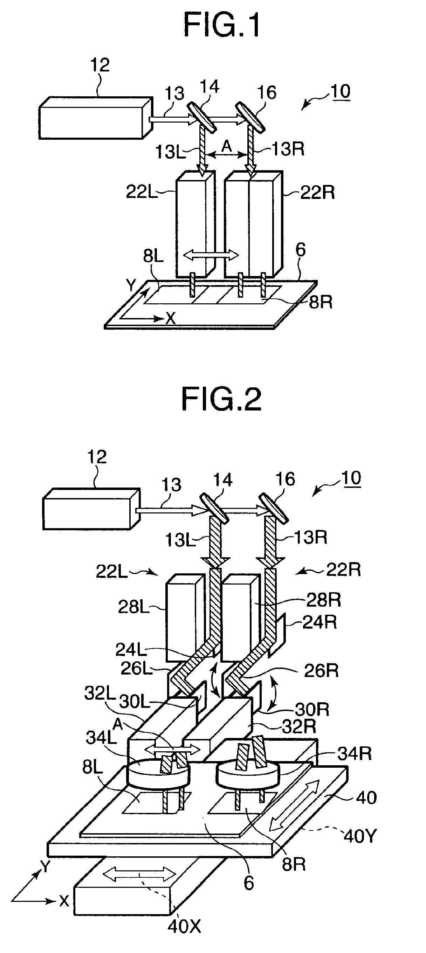

The construction of an example of a conventional laser drilling machine using a pulse oscillation type laser is shown in Fig. 1 (general overview) and Fig. 2 (detailed view). The laser drilling machine 10 mainly includes a laser oscillator 12, a beam splitter 14, a left galvano unit (also referred to as galvano system) 22L, a right galvano unit 22R, and an XY stage 40 (see Fig. 2). The laser oscillator 12 generates a pulsed laser beam. The beam splitter 14 guides the laser beam output 13 generated by the laser oscillator 12 into two scanning areas 8L and 8R (working areas) of a printed circuit board 6 to be worked (also referred to as workpiece) and halves the output to allow simultaneous working on the right and left sides. The left galvano unit 22L is used to scan the scanning area 8L in the X-axis direction (from the left to the right in Fig. 2) and in the Y-axis direction (from the front to the back in Fig. 2) with the laser beam 13L on the left side reflected by the beam splitter 14. The right galvano unit 22R is used to scan the right scanning area 8R in the X- and Y- directions with the right laser beam 13R passed through the beam splitter 14 and reflected upon a mirror 16. The XY stage 40 includes an X stage 40X for moving the printed circuit board 8 in the X-direction and a Y stage 40Y for moving the printed circuit board 8 in the Y-direction on the X stage 40X.

As shown in detail in Fig. 2, the galvano units (also simply referred to as left and right units) 22L and 22R include mirrors 24L and 24R, first galvano mirrors 26L and 26R, first galvano scanners 28L and 28R (also simply referred to as first scanners), second galvano mirrors 30L, 30R, and second galvano scanners 32L and 32R (also simply referred to as second scanners), and fθ lenses 34L and 34R, respectively. The mirrors 24L and 24R are used to reflect the laser beams 13L and 13R, respectively. The first galvano mirrors 26L and 26R are used for scanning with the laser beams reflected by the mirror 24L and 24R, respectively for example in the Y-direction. The second galvano mirrors 30L and 30R direct the laser beams directed in the Y-direction by the first galvano mirrors 26L and 26R in the X-direction perpendicular to the Y-direction. The fθ lenses 34L and 34R deflect the laser beams directed in the X- and Y-directions by the first and second galvano mirrors 26L and 26R, and 30L and 30R, respectively in the direction perpendicular to the surface of the printed circuit board 8 and let the beams out from irradiation apertures (not shown).

The left galvano unit 22L is for example secured, while the right galvano unit 22R has a variable position in the X-direction, and the unit interval (referred to as L-axis value) A is changeable before working.

Since the size of fθ lenses 34L and 34R is limited for the cost and quality, the beam irradiation range on the board 6 is limited to rectangular ranges 8L and 8R (referred to as scanning areas) of for example 40 mm × 40 mm having both sides parallel to the X- and Y-axes and centered around the position immediately below the beam irradiation aperture whose position is completely secured during working.

Meanwhile, the board 6 is about as large as 500 mm × 600 mm at most for example, and typically larger than the scanning areas. Therefore, in order to perform perforation working over the entire board, the XY stage 40 supporting the board is driven in a desired direction in an XY plane to move the board 6.

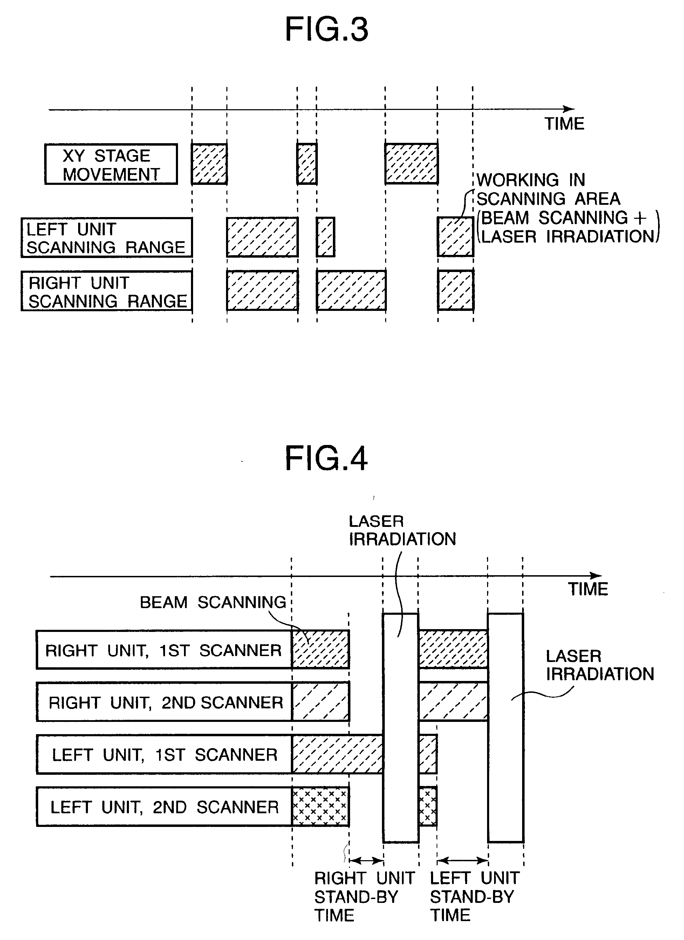

The laser drilling machine as described above generally operates as follows as shown in Fig. 3.

(1) The board 6 is moved by the XY stage 40.
(2) The left and right scanning areas 8L and 8R are subjected to laser perforation working. These two steps are repeated (referred to as step and repeat) in order to perforate over the entire board. The part of the worked surface irradiated with a laser beam is evaporated, and a hole results in the printed circuit board 6. Since the laser beam is split into two, two areas on the left and right sides are worked at a time, and the interval of the areas to be worked at a time is equal to the working head interval.

As shown in Fig. 4, during working in the scanning areas 8L and 8R, a laser beam is irradiated upon the completion of the moving scanning (also referred to as beam scanning) from the perforation completed point on the board to the next intended perforation point using the first and second scanners 28L, 28R, 32L and 32R in the left and right units 22L and 22R, and the step is repeated.

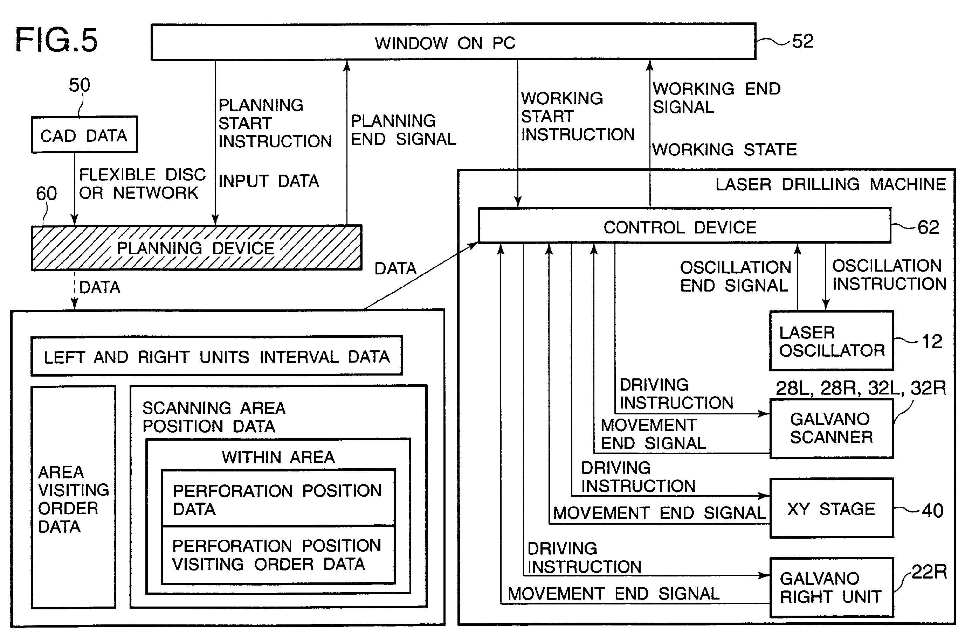

How the devices in the laser drilling machine operate as a system to achieve perforation working will be now described in conjunction with Fig. 5.

There are two inputs used in the operation of the laser drilling machine 10, i.e., CAD data 50 and a GUI input from a window 52 on a PC.

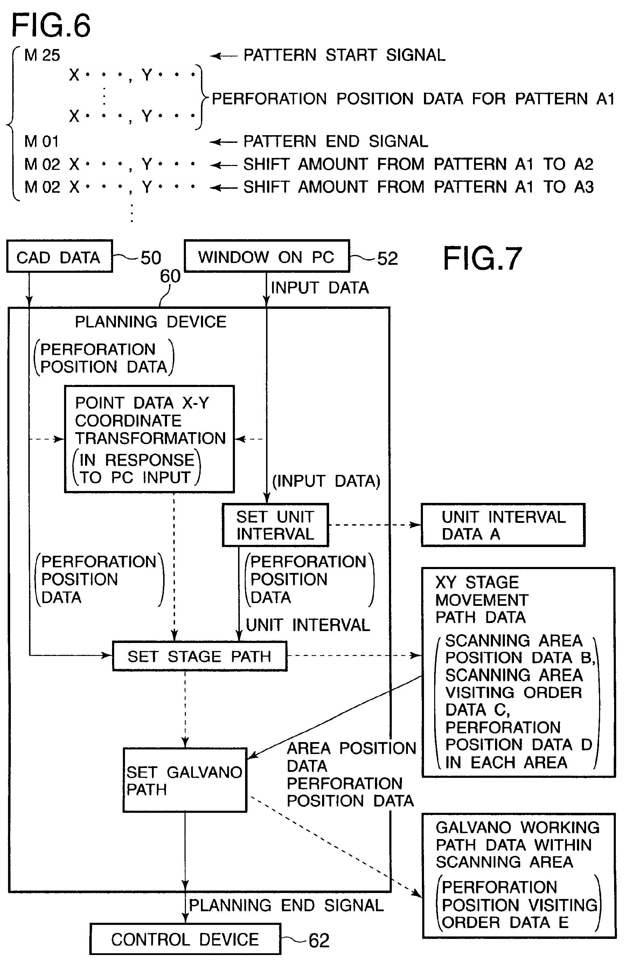

More specifically, the perforation conditions such as perforation positions, alignment mark positions for board position registration, and the number of laser irradiation (referred to as shot number) are produced by a CAD system which is not shown and stored in data files. The kind of the board is mostly a packaged board such as a board for mobile phone and a mother board and therefore the arrangement of hole coordinates often has several arranged groups (patterns) of some points. As a result, as shown in Fig. 6, the CAD data 50 is produced by arranging hole coordinates between the start and end signals of a pattern and writing shift amounts for the patterns as many as the number of patterns rather than arranging all the hole position data.

A person in charge of working selects a data file in the CAD data 50 on a flexible disc or a network for the input position under the name of working data file using the input window 52 on the PC. Other selective inputs are performed. The selective inputs include information on several items such as whether or not point data is subjected to XY transformation (transformation of the X-coordinate and Y-coordinate of the point data to change the dividing line for the processing regions of the galvano units from the vertical direction to the X-axis to the vertical direction to Y-axis), the position of the right unit 22R (L-axis value), the format of the CAD data 50 (such as Excellon, SHI, and HZ formats).

After all the items are input, and the person in charge presses an input end button (a switch button mainly for input), a planning device 60 performs planning based on the input items, and returns an planning end signal. Then, a plan view is produced and displayed on a PC screen. In the plan view, the perforation positions, processings to be separately performed by the left and right units, placement of scanning areas and the like are visibly expressed. The operator checks the plan view and presses the working start button on the window if there is no problem in the view.

The operation allows the laser drilling machine 10 to start operating.

The data planned and produced by the planning device 60 includes five kinds of data, i.e., unit interval data A, stage stop position (scanning area position) data B, visiting order data C for the stage stop positions, perforation position data D in each scanning area, and visiting order data E for the perforation positions in each scanning area.

In the conventional manner, the planning device 60 conduct setting by a method as shown in Fig. 7, using the CAD data 50 and the window input values.

The data planned and produced by the planning device 60 will be now described.

(1) Unit interval data A

The interval between the left and right galvano units 22L and 22R (unit interval) A can be set about in the range, for example, from 150 to 300 mm. According to the input window 52 in the PC, the interval is set. The data is used as an instruction value when the right unit 20R is driven.

(2) Scanning area position data B

The operation regions of the units are divided into a regular square lattice at a lattice point interval of 40 mm. An entire rectangular area of 40 mm $\times$ 40 mm surrounded by four lattice points is set as a scanning area.

(3) Scanning area position visiting order data C

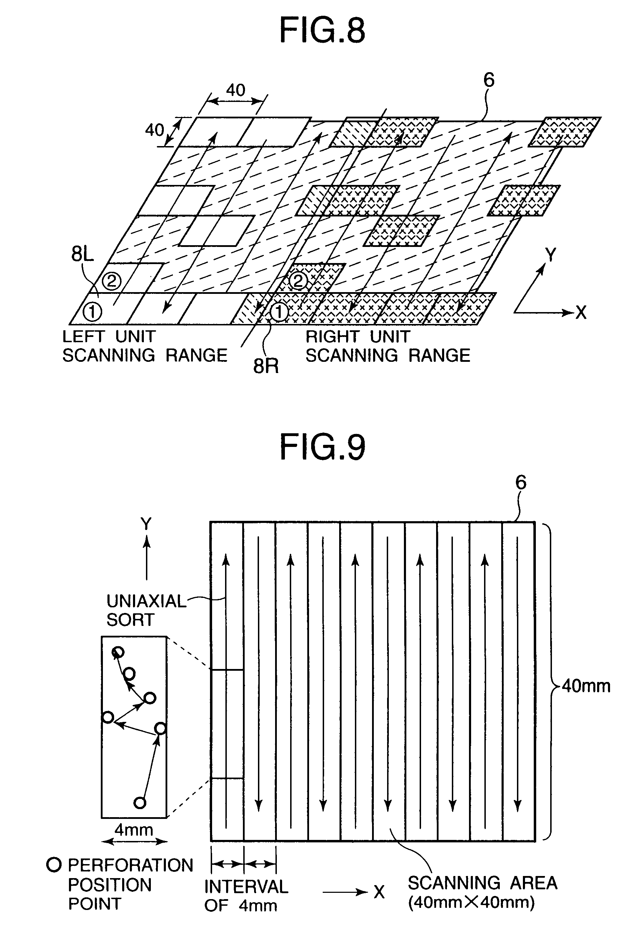

The initial point is at the scanning area in the lower left corner of each unit. As shown in Fig. 8, the trajectory of the stage visiting the scanning areas (referred to as stage path) can take a zigzag path with the line advancing in the X-direction.

(4) Perforation position data D in each scanning area

All the perforation positions are labeled for example to specify an area to which each position belongs.

(5) Perforation position visiting order data E in each scanning area

The scanning areas are each for example in the shape of a regular square of 40 mm $\times$ 40 mm. Meanwhile, as shown in Fig. 9, the regular square region is for example equally divided into ten parts with respect to the X-axis, and then lines parallel to the Y-axis are drawn from the left end of the area at intervals of 4 mm. As a result, ten strip-like regions of 40 mm in the X-direction and 4 mm in the Y-direction are formed. The perforation positions of the strip-like regions are sorted with the Y coordinate values. Note however that among adjacent strip regions, one is always in the ascending order and the other in the descending order. The point visited next to the final point in a strip-like region is the initial point of an adjacent strip-shaped region in the right. The trajectory of the beam irradiation positions (referred to as galvano path) passing through the perforation positions in the scanning area determined by the above operation can generally take a zigzag path with the line advancing in the X-direction.

The devices of the laser drilling machine operate in response to an instruction from the control device 62.

More specifically, the right unit 22R is driven in the timing in which the control device 62 receives a working start signal. Once the movement ends, a movement end signal is transmitted to the control device 62.

The laser oscillator 12 lasses in the timing in which the control device 62 receives both movement end signals output from the units 22L and 22R and two scanners 32L and 32R. After a necessary shot number, the lasing end signal is returned to the control device 62. At the point visited last in the area, a signal indicating the end of the laser perforation working at all the perforation positions in the scanning area is returned to the control device 62. If the point is the point visited last in the scanning area and the scanning area is the scanning area visited last, a working end signal is transmitted to the window 52 on the PC.

The scanners 28L, 28R, 32L, and 32R are driven in the timing in which the control device 62 transmits the lasing end signal output from the laser oscillator 12 or a movement end signal output from the XY stage 40. When the movement to the next perforation position is complete, the movement end signal is returned to the control device 62.

The XY stage 40 is driven in the timing in which the control device 62 receives a signal output from the scanners 28L, 28R, 32L and 32R indicating the end of the perforation working at all the perforation positions in a scanning area. When the movement to the next scanning area is complete, the movement end signal is returned to the control device 62.

According to the conventional planning method, however, planning is adapted to fill a previously produced form regardless of the distribution of perforation positions, which cannot be always optimal, and a device capable of optimal setting for the following four aspects has been in demand.

(1) Point data X-Y coordinate transformation

(2) Unit interval setting

These are set by only simple either-or selection in an input window according to the conventional method, which by no means provides optimal setting.

(3) Stage path setting

According to the setting method as described above, there could be a scanning area having only one perforation position, in other words the number of scanning areas is not optimized.

(4) Galvano path setting

According to the setting method as described above, one movement could wastefully cover the end-to-end distance of a scanning area, in other words, 40 mm.

Note that according to the disclosure of Japanese Patent Laid-Open Publication No. Hei. 11(1999)-149317, when a fuse to be worked in a chip of interest in a semiconductor wafer is fused, the relative positional relation between two heads is determined and maintained, while the optimal inter chip path connecting all the chips to be worked and the optimal path connecting all the fuses and blocks in the chip are determined. However, according to the method, the load of fuse positions to be worked is allocated to two working portions so that ratio of (the number of fuses in two head fly blocks) / (two head fly blocks) can be maximized when the heads are moved into the chip areas to be worked, rather than dividing the region into two. Therefore, the method cannot suitably be applied to the laser drilling machine

EP 1 211 583 A2

as intended according to the present invention.

The applicant suggests in Japanese Patent Application No. 2000-3180 a method of optimizing a galvano path in a scanning area by solving a traveling salesman problem, while this application is silent about the stage path and the disclosed idea is yet to be developed.

Programs in the working planning as described above are normally incorporated in software used by the laser beam machine, but the calculation load is large and could adversely affect the operation of the working machine which cannot afford a high speed processing machine for calculation. Meanwhile, in order to use up-to-date programs, they must always be upgraded. This applies to the case of extracting a program for working planning and providing a single kind of software. The working position data could be mailed from the user using a recording medium such as a flexible disc, and a working plan can be produced based on the data by the manufacturer's support center and sent back by mail. The exchange by mail however takes too long.

The present invention is directed to a solution to the conventional disadvantages described above. It is a first object of the present invention to improve the throughput of a working machine without changing the responsiveness by a laser oscillator, a laser scanning mechanism, a workpiece moving mechanism and the like. According to the invention, two objectives of shortening the total time for moving a workpiece, and shortening the total scanning time by working means such as a laser beam are solved by mathematically interpreting the distribution state of working positions in a two-dimensional plane, and planning an optimum path.

A second object of the invention is to shorten the computation time required for planning without lowering the precision of planning directed to shortening the working time by introducing a data structure to efficiently store geometrical point data.

A third object of the invention is to provide a working planning device to carry out the working planning.

A fourth object of the invention is to provide the capability of quickly producing working data always in the up-to-date version using a high speed processing machine dedicated for computing.

According to the present invention, the first object is achieved in allocating a plurality of working positions scattered on a workpiece to a plurality of working areas to be simultaneously worked, by determining an optimal working path for the working positions in each working area, and subsequently determining order of working in the working positions in each working area so that a total working time is minimized in the working areas to be simultaneously worked.

According to the present invention, the first object is achieved in determining order of working in a plurality of working areas scattered on a workpiece, by shifting an start point of a working path in each of the plurality of simultaneous working areas so that time for scanning or moving simultaneously performed can be equal, thereby shortening a total working time.

According to the present invention, the first object is achieved, in determining order of working by applying a traveling salesman problem to a plurality of working positions scattered on a workpiece or working areas set in a workpiece, by solving the traveling salesman problem, thereby minimizing a tour length, and subsequently eventually detecting a longest movement, and determining start and end points so that the longest movement is removed.

According to the present invention, the first object is also achieved, in determining order of working by applying a traveling salesman problem to a plurality of working positions scattered on a workpiece or working areas set in a workpiece, by solving a traveling salesman problem varied to minimize a value produced by removing a longest movement from a tour, thereby obtaining a tour, and eventually removing the longest movement to determining start and end points.

According to the present invention, the first object is also achieved, in determining placement of working areas to be worked by working means based on working positions scattered on a workpiece, by provisionally setting a next working area so as to enclose an end point in a first direction not yet enclosed by the working area, moving the provisionally set working area in a second direction different from the first direction to enclose an end point in the second direction, again moving the moved working area in the first direction so as to enclose the end point in the first direction in the position after the movement, and moving the re-moved working area again in the second direction so as to enclose the end point in the second direction in a position after the re-movement. The steps of moving are repeated to define the next working area.

The working area has a square frame orthogonal to the first and second directions.

The first and second directions are set to correspond to the moving direction of a workpiece.

According to the present invention, the first object is achieved in determining placement of working areas to be worked by working means based on working positions scattered on a workpiece, by simply dividing an entire surface of the workpiece into the working areas, and subsequently removing all the working areas without any working position.

The first object is achieved, in determining placement of working areas to be worked by working means based on working positions scattered on a workpiece, by repeating the step of placing a working area in a position with a largest number of working positions not yet enclosed until all the working positions are enclosed.

The first object is achieved, in determining placement of working areas to be worked by working means based on working positions scattered on a workpiece, by provisionally determining area placement, and subsequently shifting a working area to a neighborhood and removing an unnecessary working area.

The working area may be shifted to a neighborhood and an unnecessary neighboring area is removed, provided that a point independently belonging to the working area stays within the area.

Alternatively, among the working areas, at least two areas joined at an overlapping location may be each shifted to a neighborhood and an unnecessary neighboring area is removed, provided that a point independently belonging to the at least two areas stays within the working areas.

According to the present invention, in determining placement of working areas to be worked by working means based on working positions scattered on a workpiece, by determining areas to be worked so that the number of working positions belonging to each of a plurality of simultaneous working areas is equal when the same working position belongs to the plurality of areas.

Some of the working positions belonging to the plurality of areas may be allocated to an area having a greater difference among a plurality of simultaneous working areas, some of the remaining working positions are allocated to an area having a smaller difference, and the eventually remaining working positions are distributed equally among both areas.

According to the present invention, the first object is solved, in determining placement of working areas to be worked by working means based on working positions scattered on a workpiece, by adjusting an area position so that working positions are gathered around the center of each working area.

The area position may be adjusted so that the center of an extent of the working positions matches the center of the working area.

Alternatively, the area position may be set as near as the center of gravity of the working positions, provided that the working positions are within the working area.

According to the present invention, the first object is achieved, in working a workpiece placed on a stage which is movable in a plurality of directions, by determining a moving path for the stage by solving a traveling salesman problem with fixed edge points in which a position to load the workpiece to the stage from a loader is set as a start point of the moving path for the stage, a position before transferring the workpiece to an unloaded is set as an end point.

According to the present invention, the first object is achieved, in working a workpiece placed on a movable stage by a plurality of working units capable of scanning or moving working means within a working area, by determining an interval between the working units so that the number of scanning or moving the working means (such as the number of beam scanning and the number of moving the drill) or the number of moving the stage is minimized. The units are for example a beam irradiation unit capable of scanning with a laser beam in a scanning area and a drill moving unit capable of moving a mechanical drill in a moving area.

The number of scanning or moving the working means and the number of moving the stage may be weighted depending on difference in scanning or moving time.

The interval of the working units may be set, and the scanning or moving ranges of the working units at the time may be overlapped, thereby obtaining area placement to minimize the number of working areas, and the number of scanning or moving of the working means and the number of moving the stage at the time may be calculated.

According to the present invention, the first object is achieved, by performing the above-described process in a different workpiece direction, and automatically employing the workpiece direction to minimize the number of scanning or moving the working means or the number of moving the stage.

According to the present invention, the second object described above is achieved, in working a workpiece using working means capable of scanning or moving in a plurality of directions, by expressing point position data representing working positions or working areas scattered on the workpiece in a tree type data structure.

The above-described tree may be a k-dimensional binary search tree.

After the position of working areas scattered on the workpiece is determined, the tree may be used to list point data in each working area.

From a root node of the tree, for internal nodes, whether or not to search a child node of a node may be determined based on the degree of overlapping between a region corresponded to the child node of the node and a search region, and only when a leaf node is reached, the point data may be directly accessed.

Using the tree, the nearest neighbor point to a point of interest may be searched.

The process of searching the nearest neighbor point may be started from the root node of the tree.

When a circle centered on the point of interest and having a radius as long as the distance to the present nearest neighbor point overlaps a region corresponded to a node, the node may be searched.

If said node is a leaf node, distances to all the points corresponded to the node in the region are obtained, and it may be determined whether each distance is short.

Each point data piece may have information related to a leaf node to which the data piece belongs, the process of searching the nearest neighbor point may be performed by directly accessing the leaf node having the point of interest whose nearest neighborhood is searched, and then the search may be performed in a direction toward the root node of the tree, provided that there is a node to be searched.

If a circle centered on the point of interest and having a radius as long as the distance to the present nearest neighbor and a region corresponded to a node are outside a region corresponding the present node, a brother node thereof or a brother node of a parent node thereof may be searched depending on a degree of how much outside they are.

The process of searching the nearest neighbor point and the process of searching the next nearest neighbor point, using a tree removed of a found nearest neighbor point may be repeated, so that neighbor points are listed in order of their nearness to the point of interest.

The process of searching the nearest neighbor point not yet connected to a working path by the process of searching the nearest neighbor point and connecting a new found point of interest to the working path, and the process of searching the next nearest neighbor point using a tree removed of the found point of interest and connecting a new found point of interest to the working path may be repeated from a start point to an end point to produce the working path.

The process of removing a found point from the tree may be performed by reducing ending number of an index attached to each point data or by increasing starting number.

If a found point is removed from the tree, and all point data in a node disappears, the node may be attached with information indicating that it is not necessary to visit the node.

A working path determined by the working planning method according to any one of the above working planning methods may be set as an initial solution in determining order of working by applying a traveling salesman problem.

The second object is achieved by removing an unnecessary, high load operation by finding a set of areas in which the placement of point data in one of the working areas and the placement of point data in another working area are relatively matched.

The process of searching a set of areas having relatively matched point data placements may be performed by producing point position data by adding a prescribed coordinate shift to all the points in one area, visiting one node after another representing a region having the point position data from the root node of a tree in the other area, and checking whether or not point position data matched with the point position data is present only when a leaf node is reached.

In the process of enclosing point data in the working area with the minimum number of equal size rectangles, every time a provisional working area is produced by calling a loop, the tree may be built both for the provisional working area and provisional point position data in each working area.

The tree may be built both for the working area and point position data in each working area when the working area is defined.

According to the present invention, a working method performing working (such as laser machining and drilling)determined by any one of the above-described working planning methods is provided.

According to the present invention, a computer program for implementing any one of the above-described working planning methods is provided.

According to the present invention, the third object is achieved by a working planning device for allocating a plurality of working positions scattered on a workpiece to a plurality of working areas to be simultaneously worked. The device includes working path determining means for determining an optimal working path for working positions in each working area, and working order determining means for determining order of working in the working positions in each working area so that the total working time in the working areas to be simultaneously worked is minimized.

According to the present invention, the third object is achieved by a working planning device for planning working in determining order of working in a plurality of working areas scattered on a workpiece. The device includes working order shift means for shifting a start point of a working path for each of the plurality of simultaneous working areas so that the time for scanning and moving performed simultaneously can be equal among the simultaneous working areas, and shortening the total working time.

According to the present invention, the third object is achieved by a working planning device for planning working in determining order of working by applying a traveling salesman problem to a plurality of working positions scattered on a workpiece or working areas set in the workpiece. The unit includes scanning path determining means for detecting a longest movement after minimizing a round path by solving the traveling salesman problem, and determining start and end points so that the longest movement is removed.

According to the present invention, the third object is achieved by a working planning device for planning working in determining order of working by applying a traveling salesman problem to a plurality of working positions scattered on a workpiece or working areas set in the workpiece. The device includes scanning path determining means for solving a traveling salesman problem improved to minimize a value produced by removing a longest movement from a round path, thereby obtaining a round path, and eventually removing the longest movement to determine start and end points.

According to the present invention, the third object is achieved by a working planning device for planning working in determining placement of working areas to be worked by working means based on working positions scattered on a workpiece. The device includes area placement determining means for repeating a process for defining the next working area. The process includes provisionally setting the next working area so as to enclose an end point in a first direction not yet enclosed by a working area, moving the provisionally set working area in a second direction different from the first direction so that the area encloses an end point in the second direction, again moving the moved working area in the first direction so that the moved working area encloses the end point in the first direction, and again moving the moved working area to enclose the end point in the second direction in a position after the movement.

According to the present invention, the third object is achieved by a working planning device for planning working in determining placement of working areas to be worked by working means based on working positions scattered on a workpiece. The device includes area placement determining means for simply dividing an entire surface of the workpiece into working areas, and removing all working areas having no working position.

According to the present invention, the third object is achieved by a working planning device for planning working in determining placement of working areas to be worked by working means based on working positions scattered on a workpiece. The device includes area placement determining means for repeating a process of placing a working area in a position having the largest number of working positions not yet enclosed until all the working positions are enclosed.

According to the present invention, the third object is achieved by a working planning device for planning working in determining placement of working areas to be worked by working means based on working positions scattered on a workpiece. The device includes area placement determining means for provisionally determining area placement, shifting a working area to a neighborhood, and removing an unnecessary working area.

According to the present invention, the third object is achieved by a working planning device for planning working in determining placement of working areas to be worked by working means based on working positions scattered on a workpiece. The unit includes belonging area determining means for determining scanning areas to be worked. When the same working positions belong to a plurality of working areas, the means determines the scanning areas so that the number of working positions belonging to each of the plurality of simultaneous working areas is equal.

According to the present invention, the third object is achieved by a working planning device for working planning in determining placement of working areas to be worked by working means based on working positions scattered on a workpiece. The device includes area position adjusting means for adjusting area positions so that working positions are gathered around the center of each working area.

According to the present invention, the third object is achieved by a working planning device for planning working in working a workpiece placed on a stage movable in a plurality of directions. The device includes moving path determining means for determining a moving path for the stage by solving a traveling salesman problem with fixed edge points in which a position to load the workpiece to the stage from a loader is set as a start point of the moving path for the stage, a position before transferring the workplace to an unloaded is set as an end point..

According to the present invention, the third object is achieved by a working planning device for planning working in working a workpiece placed on a movable stage simultaneously using a plurality of working units capable of scanning working means in a working area. The device includes unit interval determining means for determining an interval of the working units so that the number of scanning or moving the working means or the number of moving the stage is minimized.

According to the present invention, the third object is achieved by workpiece direction determining means for performing the processing by the unit interval determining means in a different workpiece direction, and automatically employing a workpiece direction allowing the number of scanning or moving the working means or the number of moving the stage to be minimized.

According to the present invention, the third object is achieved by a working planning device for planning working in working a workpiece using working means capable of scanning or moving in a plurality of directions. The device includes means for storing point position data expressed in a tree type data structure on points representing working positions or working areas scattered on the workpiece and means for determining working area positions and order of working using the position data expressed in the tree type data structure.

According to the present invention, a working device includes any one of the above-described working planning devices is provided.

According to the present invention, a computer program for implementing any one of the above-described working planning devices is provided.

According to the present invention, the above-described fourth object is achieved by determining a working plan based on working position data received from a working device side through a communication line, and returning the plan to the working device side.

The working plan may be determined by any one of the above-described methods.

According to the present invention, a computer program for implementing the above-described working data producing method is provided.

According to the present invention, the fourth object is achieved by a working data producing device. The device includes means for receiving working position data from a working device side through a communication line, planning means for determining a working plan based on the received working position data, and transmission means for transmitting the determined working plan back to the working device side.

The working plan may be determined according to any one of the above-described methods.

According to the present invention, a computer program for implementing the working data producing device described above is provided.

According to the present invention, a computer readable recording medium recorded with the above-described computer program is provided.

According to the present invention, the working position information is mathematically interpreted and the operation of the devices is planned in the optimal manner, so that the time for laser working can be reduced.

The computation time required for planning working can be shortened without lowering the precision of the plan directed to shortening of the working time.

The processing at higher speed according to the present invention are used at the time of determining each area in a provisional region in a later described orthogonal range query and therefore the number of use may substantially be "number of producing provisional regions $\times$ area number average", for example.

A later described neighbor-list is produced as a preparation for a traveling salesman problem and used once for each of all the point data and area position data, and therefore the number of use may substantially correspond to "number of perforation positions + number of areas in half region."

A later described nearest neighbor method is used once for each traveling salesman problem, and therefore the number of use is at most "1 + number of areas in entire substrate." ("1" is a traveling salesman problem when a stage pass is planned.)

The number of comparison between the areas in a later described exact match query is at most about "(area number in entire board) $^2$/2." (It might appear that the amount of calculation is large with a square term, but in the exact match query in hole placement between areas, if there is even one point not in exact match, the determination is over. Therefore, the amount of calculation is generally not significant.)

Among the above, the flow process to produce a neighbor-list and solve a traveling salesman problem (a solution belonging to iterative improvement methods are basically according to the flow) occupies a larger percentage in all the computation, and therefore the processing speed is significantly increased.

Meanwhile, additional time should be necessary for building a tree, but the number of producing a tree is "number of producing provisional regions + 1 + area number in entire board," which is sufficiently less than the number of processing to have an increase speed by producing a tree, and time for producing a tree is not so long and is insignificant. Accordingly, the overall computation time is sufficiently shortened.

Furthermore, if a working plan is determined based on working position data received from the side of a working device through a communication line, and the plan is returned to the working device side, working data can quickly be produced always in the up-to-date version using a high speed processing machine dedicated for computation.

The preferred embodiments will be described with reference to the drawings, wherein like embodiments have been noted throughout the figures with like reference numerals and wherein:

Fig. 1 is a perspective view of a laser drilling machine to which the present invention is applied;

Fig. 2 is a detailed perspective view thereof;

Fig. 3 is a timing chart for use in illustration of overall working operation by step and repeat;

Fig. 4 is a timing chart for use in illustration of working operation in each scanning area;

Fig. 5 is a block diagram of the conventional device system configuration of a laser drilling machine;

Fig. 6 shows an example of CAD data;

Fig. 7 is a flowchart for use in illustration of the process of a conventional data setting method;

Fig. 8 is a perspective view of an example of a conventional stage position and path;

Fig. 9 is a plan view showing an example of a conventional galvano scanner path;

Fig. 10 is a block diagram of the structure of an embodiment of a laser drilling machine planning device according to the present invention;

Fig. 11 is a flowchart for use in illustration of overall process according to the embodiment;

Fig. 12 is a flowchart for use in illustration of the processing by an example of a two-unit area placement planning device;

Fig. 13 is a plan view for use in illustration of the principle of how the unit interval is set;

Fig. 14 is a diagram showing the relation among the beam scanning number, the stage moving number, and the optimal unit interval;

Fig. 15 is a diagram showing an example of a board for use in illustration of the usefulness of the XY coordinate transformation;

Fig. 16 is a diagram showing how the XY coordination transformation is performed;

Fig. 17 is a plan view showing an example of area placement when there is an overlap, for use in illustration of the principle of how perforation positions are distributed when there is such an overlap between areas;

Fig. 18 is a diagram showing an example of how the perforation positions are distributed;

Fig. 19 is a flowchart for use in illustration of an example of specific process of overlap distribution processing;

Fig. 20 is a diagram showing an example of distribution;

Fig. 21 is a diagram showing another example of distribution;

Fig. 22 is a plan view showing how the area positions are fine-adjusted in the center of the extent of perforation positions;

Fig. 23 is a plan view showing how area positions are fine-adjusted in the center of gravity of perforation positions;

Fig. 24 is a flowchart for use in illustration of the processing by a variation of a two-unit area placement planning device according to a variation;

Fig. 25 is a plan view showing an example of candidate for the unit interval according to the variation;

Fig. 26 is a flowchart for use in illustration of the area placement planning device according to the embodiment;

Fig. 27 is a plan view showing how the next area position is searched, for use in specific illustration of the process;

Fig. 28 is a plan view showing the state when the leftmost point not yet enclosed is found;

Fig. 29 is a plan view showing the state when the lowermost point not yet enclosed in a band region for the area width is found;

Fig. 30 is a plan view showing an exception processing when there is a large overlap with a defined area;

Fig. 31 is a plan view showing the state when the leftmost point in the next area is found;

Fig. 32 is a plan view showing the state when an overlap is avoided;

Fig. 33 is a plan view showing the state when the next area is defined;

Fig. 34 is a plan view showing the principle of how an area determining method according to a variation works;

Fig. 35 is a flowchart for use in illustration of the process;

Fig. 36 is a diagram showing an example of how an area neighbor is searched according to the variation;

Fig. 37 is a diagram of another example;

Fig. 38 is a flowchart for use in illustration of a stage/galvano path planning device according to the embodiment;

Fig. 39 is a diagram showing an example of difference in the moving time by the stage, for use in illustration of the principle of the present invention;

Fig. 40 is a plan view showing an example of the positional relation between a loader, an unloader and an XY stage and the optimal path;

Fig. 41 is a diagram showing the difference in the moving time by a galvano scanner, for use in illustration of the principle of the present invention;

Fig. 42 is a timing chart for use in illustration of the principle of matching the moving pattern of the left and right units executed with the stage/galvano path planning device;

Fig. 43 includes a plan view and a related timing chart showing the effect of shifting the order of visiting one of the left and right scanning areas;

Fig. 44 is a plan view showing how the longest movement is removed after a round path is determined in relation with the start and end points;

Fig. 45 is a flowchart for use in illustration of the process of determining a round path by "(round path)-(longest movement)";

Fig. 46 is a plan view thereof;

Fig. 47 is a plan view showing an example of the effect by the area placement planning device;

Fig. 48 is a plan view showing another example of the effect;

Fig. 49 is a table generally showing how the area number changes;

Fig. 50 is a diagram showing the relation between the beam scanning number and the stage moving number relative to the unit interval, for showing the effect of optimization of the unit interval;

Fig. 51 is a table generally showing the numerical results;

Fig. 52 is a diagram showing in comparison a conventional galvano path and a galvano path to which the present invention is applied;

Fig. 53 is a diagram showing in comparison the relation between the number of perforation positions and the galvano scanner moving distance according to the conventional example and the present invention;

Fig. 54 is a table generally showing the numerical results;

Fig. 55 is a diagram for use in illustration of terms representing the relation between nodes of a tree;

Fig. 56 is a plan view showing an example of two dimensional data used according to the present invention;

Fig. 57 is a diagram showing how data is stored in a tree;

Fig. 58 is a diagram showing an example of data description;

Fig. 59 is a plan view showing how a rectangular region is searched according to the present invention;

Fig. 60 is a plan view showing how nearest neighbor point search is performed and a neighbor point search list is produced;

Fig. 61 is a plan view showing an example of the process of producing a traveling path by the nearest neighbor method according to an embodiment of the present invention;

Fig 62 is a flowchart for use in illustration of an example of the process by the iterate improvement method (local search method);

Fig. 63 is a flowchart for use in illustration of an example of the process by the top-down method;

Fig. 64 is a plan view showing how a region to be searched is determined according to the top-down method;

Fig. 65 is a flowchart for use in illustration of the process by the bottom-up method according to the present invention;

Fig. 66 is a plan view showing how a region to be searched is determined according to the bottom-up method;

Fig. 67 is a plan view showing the effectiveness of the exact match query according to an embodiment of the present invention;

Fig. 68 is a block diagram showing the configuration of a system according to an embodiment of the present invention;

Fig. 69 is a flowchart showing the process;

Fig. 70 is a block diagram showing the configuration of a system according to a variation of the embodiment;

Fig. 71 is a block diagram showing the configuration of a system according to another variation of the embodiment; and

Fig. 72 is a plan view showing a variation of the scanning direction.

A laser drilling machine according to an embodiment of the present invention will be now described in detail in conjunction with the accompanying drawings.

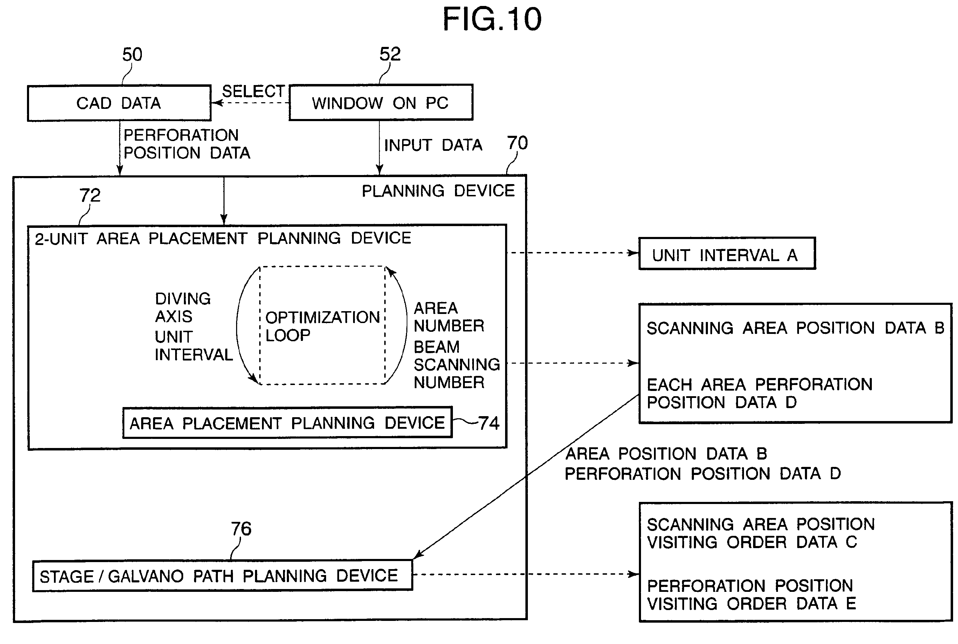

As shown in Fig. 10, a working planning device 70 for a laser drilling machine according to the embodiment of the invention includes an area placement planning device 72 for a multiple-unit (two units in the present embodiment) and a stage/galvano path planning device 76.

The two-unit area placement planning device 72 determines the operation regions of left and right galvano unites 22L and 22R based on the coordinate values of perforation points so that the number of scanning areas (working areas) is minimized, executes X-Y coordinate transformation if necessary, and determines the unit interval A to produce scanning area position data B and perforation position data D in each scanning area.

The two-unit area placement planning device 72 incorporates an area placement planning device 74 to enclose all the points in the two-dimensional region with a minimum number of equal size rectangles and determine placement of the rectangles. The loop process is repeated until the optimal unit interval is determined.

The area placement planning device 74 plans such area placement that the minimum number of scanning areas is obtained for an area and perforation positions in the area.

The input of the stage/galvano path planning device 76 is the scanning area position data B and the perforation position data D, the order of visiting the scanning areas (stage path) and the order of visiting the perforation positions in each of the areas (galvano path) are planned, and scanning area position visiting order data C and perforation position visiting order data E are produced.

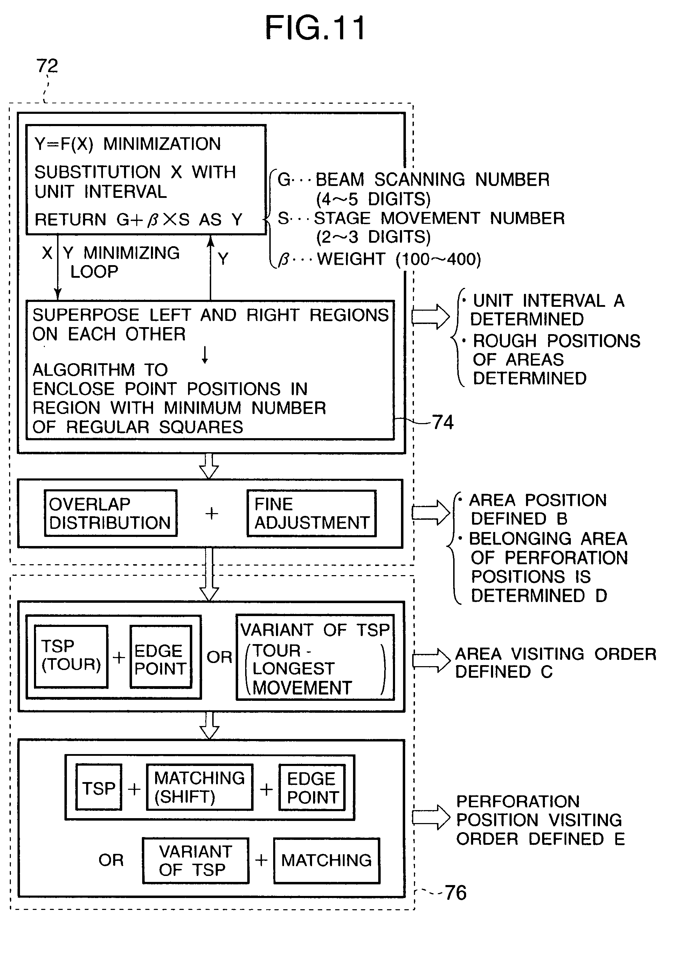

The processing by each of the devices will be now described in detail in conjunction with Fig. 11.

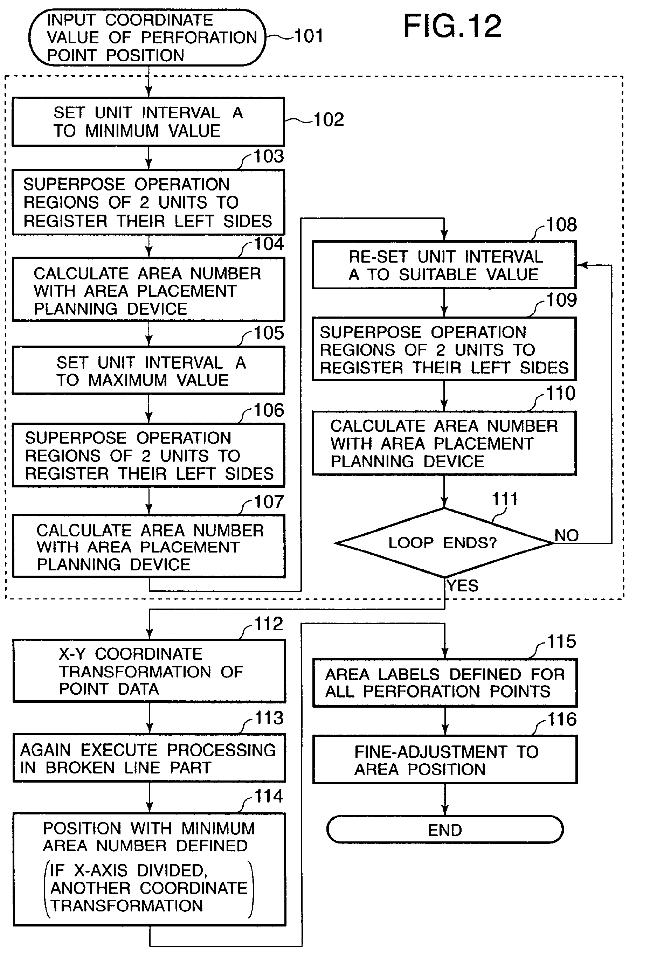

The two-unit area placement planning device 72 performs what is called "minimization of a one-variable function" as shown in Fig. 12. According to the embodiment, the golden section search, generally known as a minimalizing algorithm for a one-variable function is used. More specifically, when the unit interval A is input to the area placement planning device 74, the stage movement number and "the beam scanning number" or parameters (which will be detailed later) produced by weighting these values can be calculated, and the results of calculation can be regarded as the output values of a function. This is utilized to determine the unit interval which minimizes the output values.

Before describing the process of planning in detail, the meaning of the term "the beam scanning number", the reason for minimizing the number of stage movement and "the beam scanning number" and the method of using the area placement planning device 74 incorporated in the two-unit area placement planning device 72 will be described. Between the perforation numbers in certain simultaneous working areas by the left and right units, the larger number is selected and one is subtracted from the larger number to produce a beam scanning number in the certain simultaneous working areas. The sum of the beam scanning numbers obtained for all the simultaneous working areas is referred to as "the beam scanning number." The smaller the beam scanning number is, the better balanced the numbers of holes are between the left and right simultaneous working area. While the irradiation for working with one unit only causes a lot of shots to be wasted, this is less likely to happen in the above case, which could reduce the total working time. It is easily conceivable that the total working time should be reduced for a smaller number of stage movements.

This is because the total beam scanning time and total stage moving time occupy a large part of the total working time, and they can roughly be obtained from the following expressions:

$$\text{Sum of total beam scanning time} = (\text{average beam scanning time}) \times (\text{beam scanning number})$$

$$\text{Sum of total stage moving time} = (\text{average stage moving time}) \times (\text{stage moving number})$$

If the average values of the beam scanning time and the stage moving time should be/could be reduced by the stage/galvano path planning device 76 and if the beam scanning number and the stage moving number can be minimized using the two-unit area placement planning device 72, the total working time must be reduced.

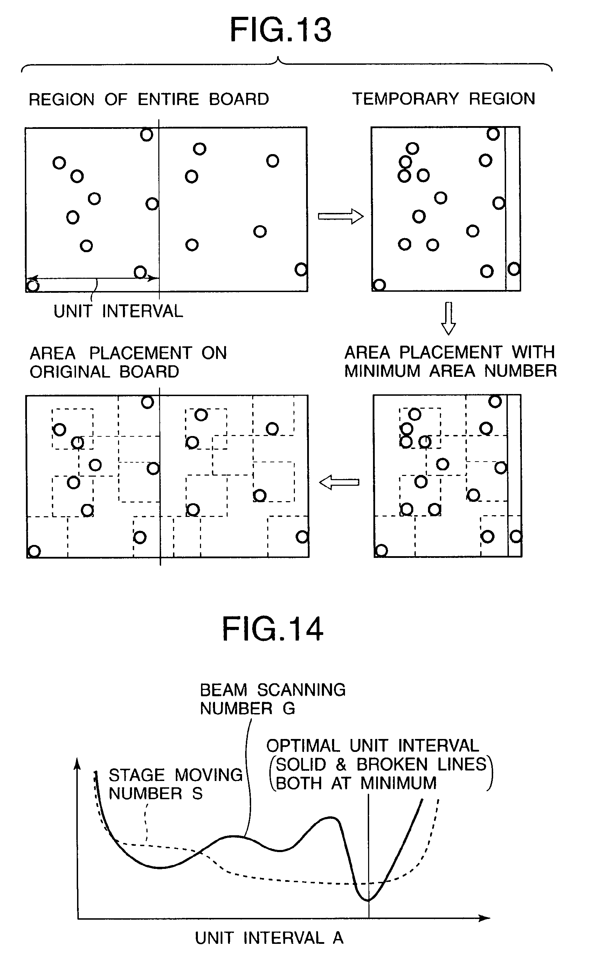

The area placements in the left and right beam irradiation regions at the time point of the determination are in full coincidence when one is horizontally shifted to the other by the unit interval, because the unit interval is constant during working. As the unit interval A is set to a value, as shown in Fig. 13, the left ends, for example, of the left and right areas are superimposed, and a temporary region is produced. For the region, the placement of the minimum scanning areas is determined using the area placement planning device 74 and the beam scanning number and the stage moving number for the placement can be calculated.

The use of the area placement planning device 74 as described above allows the stage moving number and the beam scanning number to be produced for an arbitrary unit interval as shown in Fig. 14. More specifically, the object is basically achieved if the unit interval allowing these values to be minimized is for example obtained by the iteration process of several steps according to the method of making a one-variable function minimum such as golden section search.

Strictly speaking, the golden section search is "minimalizing" algorithm (an algorithm to discover a local optimum) for a one-variable function rather than a "minimizing" algorithm (an algorithm to discover the global algorithm). Since it is very difficult to obtain the minimum value for a multimodal function in reality, the golden section search which allows the minimal value to be discovered by several steps is employed. In order to obtain a minimal value closer to the minimum value, a heuristic solution such as simulated annealing method may be applied.

In reality, the two functions have complicated shapes, and it would be difficult to determine the positions optimizing them both (generally referred to as "multi-purpose optimization problem" (here with two purposes)).

Therefore, the average beam scanning time is about in the range from 1 to 3 msec, the average stage moving time is about in the range from 0.2 to 0.4 sec, and therefore the beam scanning and the stage movement with a weight of about 100 to 400 ($=\beta$) can be set, so that

$$G \text{ (beam scanning number)} + \beta \times S \text{ (stage moving number)}$$

can be minimized. Here, $\beta$ is obtained from experiments. This is sometimes referred to as a "weighting parameter method."

By the operation, the two-purpose optimization problem can also be reduced to a one-purpose optimization problem.

Note that the beam scanning number G can be multiplied by a coefficient $\gamma$ as follows:

$$\gamma \times G + \beta \times S$$

Since a calculator generally operates faster with integers than with decimal fractions, if the value of $\beta$ obtained from experiments is a decimal fraction in the general expression, the $G + \beta \times S$ as a whole may be multiplied by a suitable integer (times $\gamma$) as follows:

$$\gamma \times G + \gamma \times \beta \times S$$

wherein $\beta$ could be considered as being substituted by $\gamma \times \beta$.

If $\beta = 0$ and $\gamma = 1$, the expression represents G, in other words, the beam scanning number. If $\beta = 1, \gamma = 0$, the expression represents S, in other words the stage moving number. In this problem, the unit intervals to minimize G and S are expected to be close, and therefore the time required for calculation can be shortened by optimizing only one of them.

More specifically, as shown in Fig. 12, the coordinates of perforation positions are input in step 101.

Then, by steps 102 to 104 and steps 105 and 107, the area placement planning device 74 calculates the scanning area number and the beam scanning number at the minimum value for the unit interval (about 100 mm) and the maximum value for the unit interval (about 300 mm) or parameters produced by weighting these numbers.

Herein, the unit interval A is at least 100 mm and at most 300 mm as is the conventional case. The optimal unit interval is clearly at a position near the position of width $\times$ 1/2, while it could be smaller than 100 mm or larger than 300 mm depending on the kind of board. The lower limit, 100 mm might not be changeable because of the physical width of the unit, while the upper limit of 300 mm may be variable. The minimum and maximum values, 100 mm and 300 mm are set at the initial position in the process described above (steps 102 and 105), while the area minimum position could not be included in the range or any interval in the vicinity of 100 mm might be apparently too short and might not be worth checking depending on the size of the board. As a result, the initial position can be set in a flexible manner depending on the size of the board.

Then in step 108, the unit interval A is set again at an appropriate position (based on the golden section ratio for example) between the immediate two previous positions, and the scanning area number in the position is calculated by the area placement planning device 74 in steps 109 and 110.

In the step 110 in Fig. 12, if the calculation result of $\gamma \times G + \beta \times S$ is judged to be minimum, the loop ends in the step 111, and if it is not minimum, the loop returns to the step 108.

If the process exits the loop in the step 111, the area number and the unit interval at the time are stored, and the point data is subjected to X-Y coordinate transformation in step 112, and the loop process from the steps 102 to 111 enclosed by the broken line is executed again.

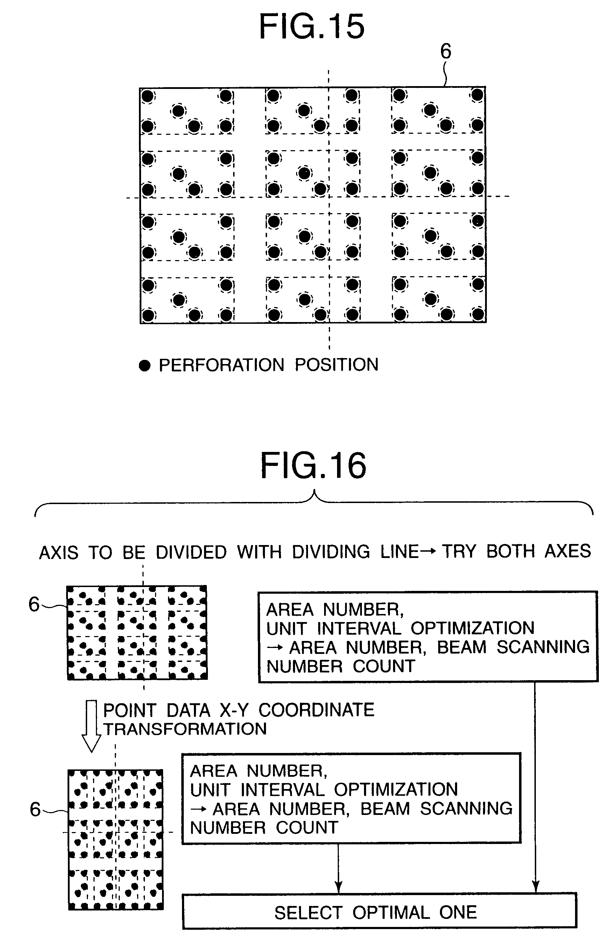

Thus, the X-Y coordinate transformation of data allows the X- and Y- axes of the original data to be vertically sectioned, the unit interval A can be optimized for both and the more suitable interval is selected so that the beam scanning number and the stage moving number are less. For a board as shown in Fig. 15, for example, calculation can be executed for sectioning both in the X- and Y- directions and the optimal one among the results can be selected as shown in Fig. 16.

Note that if the board is shifted by 90°, the operator must be notified of the shift. Alternatively, there may be a rotating mechanism at the loader loading the board onto the laser working machine, and the board may be rotated automatically.

By the comparison as described above, in step 114 in Fig. 12, the unit interval with the minimum stage moving number and the minimum beam scanning number is defined. If the X-axis of the original CAD data is sectioned, X-Y coordinate transformation is once again performed for returning to the original.

In this stage, the unit interval and approximate area placement are obtained. While the area number is minimized, scanning areas might sometimes overlap. Therefore, the process proceeds to step 115, and it is determined in which scanning area perforation positions in the overlapped part are included in. More specifically, the labels (numbers) of scanning areas to which all the perforation point positions belong are defined.

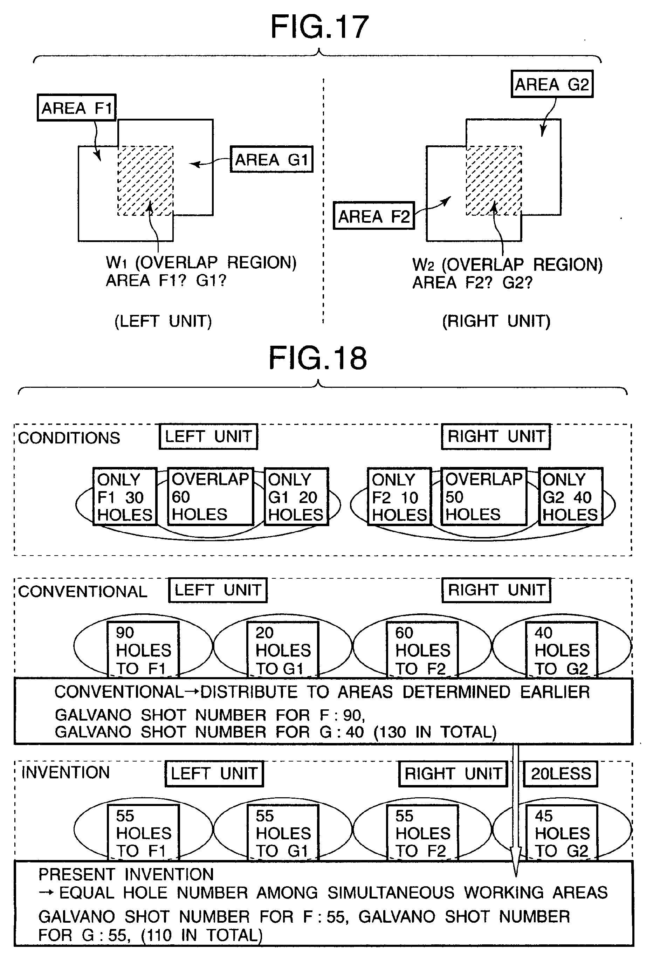

More specifically, in Fig. 17, the areas F and G overlap, and there are regions W(1) and W(2) overlapping both areas F(1), F(2) and G(1) and G(2) ((1) for the left unit and (2) for the right unit). In this case, as given by the following expression, the number of holes in the left and right simultaneous working areas are equally distributed so as to minimize the sum of the number of holes in the area with the larger number of holes between the left and right areas F and the number of holes in the area with the larger number of holes between the left and right areas G. This process can reduce the time for processing.

$$Min(Max(\text{number of holes in } F(1), \text{number of holes in } F(2)) +$$

$$Max(\text{number of holes in } G(1), \text{number of holes in } G(2)) \tag{1}$$

Now, assume that as shown in the upper part in Fig. 18, there are perforation positions in the left unit for 30 holes belonging only to the area F(1), for 20 holes belonging only to the area G(1) and for 60 holes belonging to the overlapping area W(1), while in the right unit, there are perforation positions for 10 holes only belonging to the area F(2), for 40 holes only belonging to the area G(2), and for 50 holes belonging to the overlapping area W(2). If all the holes are mechanically and automatically made to belong to the area previously determined for example, as shown in the middle part in Fig. 18, there are 90 holes in F(1), 20 holes in G(1) in the left unit, while there are 60 holes in F(2) and 40 holes in G(2) in the right unit. Therefore, the number of galvano shots in the areas F is 90, and the number of galvano shots in the areas G is 40, i.e., 130 in total.

In contrast, when the number of holes to be worked at a time is equalized according to the present invention, as shown in the lower part in Fig. 18, there are 55 holes in F(1) and 55 holes in G(1) in the left unit, while there are 55 holes in F(2) and 45 holes in G(2) in the right unit. Therefore, the number of galvano shots is 55 in the areas F and 55 in areas G, i.e., 110 in total, which is 20 shots less than that by the conventional method.

The process of distributing holes in overlapped part will be described. Here, it is assumed that the order of executing overlapped part distribution process is determined for example a random order or an order from the largest overlapped number to the smallest overlapped number. Here, the number of holes is expressed with small characters as f(1), and g(1). Here, f(1) and f(2) are the numbers of holes belonging to positions in the areas F in the left and right units, respectively and not overlapping G, g(1) and g(2) are the numbers of holes belonging to positions in the areas G in the left and right units, respectively and not overlapping F and fg(1) and fg(2) are the number of holes in the overlapping parts W1 and W2 between areas F and G in the left and right units. |f(1)|, |g(1)|, |f(2)|, and |g(2)| are the numbers of holes belonging to the areas F(1) and G(1) in the left unit and the areas F(2) and G(2) in the right units.

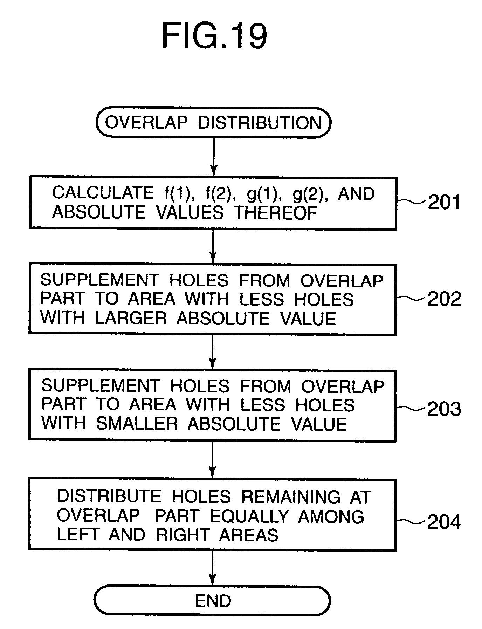

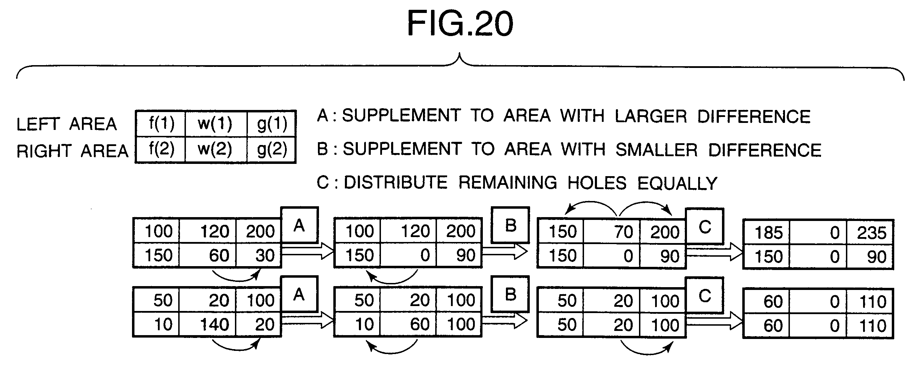

Then, the specific process is as shown in Fig. 19 for example and in step 201, f(1)-f(2) and g(1)-g(2) and their absolute values are calculated. Then in step 202, as denoted by the arrow A in Fig. 20 showing examples of numerical values, a number of holes is taken from the overlapping part and added to the area having a greater absolute value and a smaller number of holes. Then in step 203, as denoted by the arrow B in Fig. 20, a number of holes is taken from the overlapping part to the area having the smaller absolute value and a smaller number of holes. Then in step 204, as denoted by the arrow C in Fig. 20, the number of holes remaining in the overlapping part is equally distributed to areas F and G, and the process is completed.

The above steps determine how many perforation positions in the overlapping part are taken and distributed to areas F and G. Meanwhile, which perforation position is distributed to area F or G is not determined. The distance from the center of F is obtained for all the perforation positions in the overlapping part, and positions nearer to the center F are distributed based on the number to be distributed to F, in other words, a heuristic method is applied.

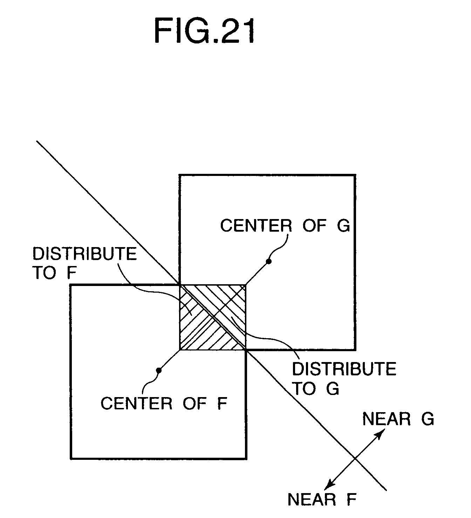

Note that the method of distributing the holes in the overlapping part is not limited to this, and as shown in Fig. 21, positions nearer to the center of each area may be distributed to the area.

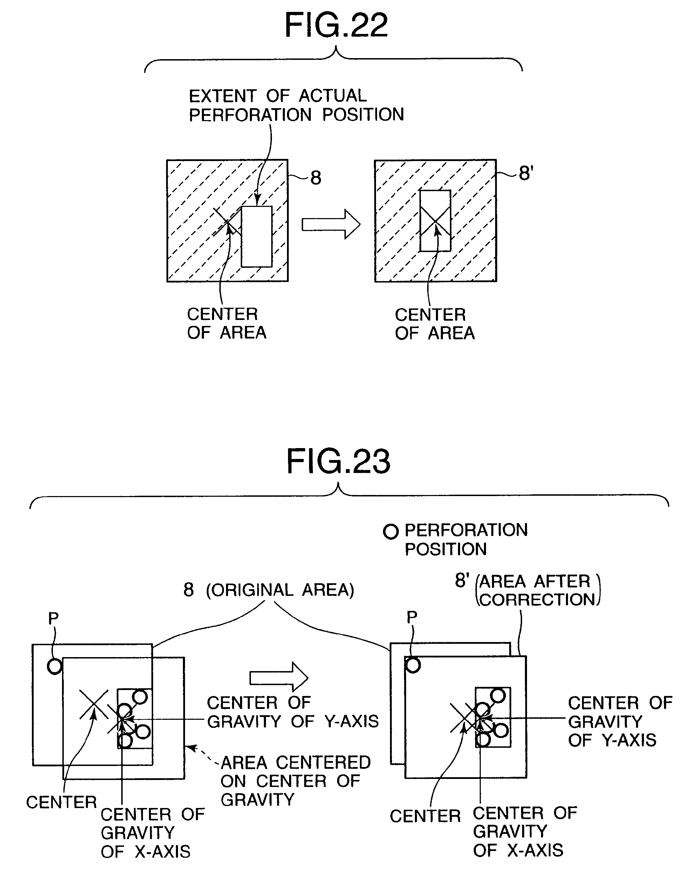

After the step 115 in Fig. 12, in step 116, the center of the scanning area is fine-adjusted using the present position of point data in the original area 8, and the points are gathered in the center of the adjusted area 8', so that the working precision is improved. More specifically, as shown in Fig. 22, the fine-adjustment is made with the center of the extent of the perforation position (the average of the minimum and maximum values for each axis). Alternatively, as shown in Fig. 23, the adjustment is made so that the center of the gravity of the perforation positions is in the center of the adjusted area 8'. In the latter case, if there is a point P apart from the area, adjustment is made to the further extent to cover all the perforation positions by the area. In the example shown in Fig. 23, the Y-axis may be shifted to the position of center of the gravity but if the X-axis is shifted to the position of the center of the gravity, a point P is out of the area, and therefore the central position is shifted to the limit position to cover all the perforation positions.

The operation is not particularly effective in reducing time, while it is effective in improving the working precision. This is because the central part provides high precision in connection with aberration of the fθ lenses 34L and 34R.

In practice, this can be implemented by the following method. The method can be a substitute processing according to which data is input using a window 52 on a PC and the above steps are simplified.

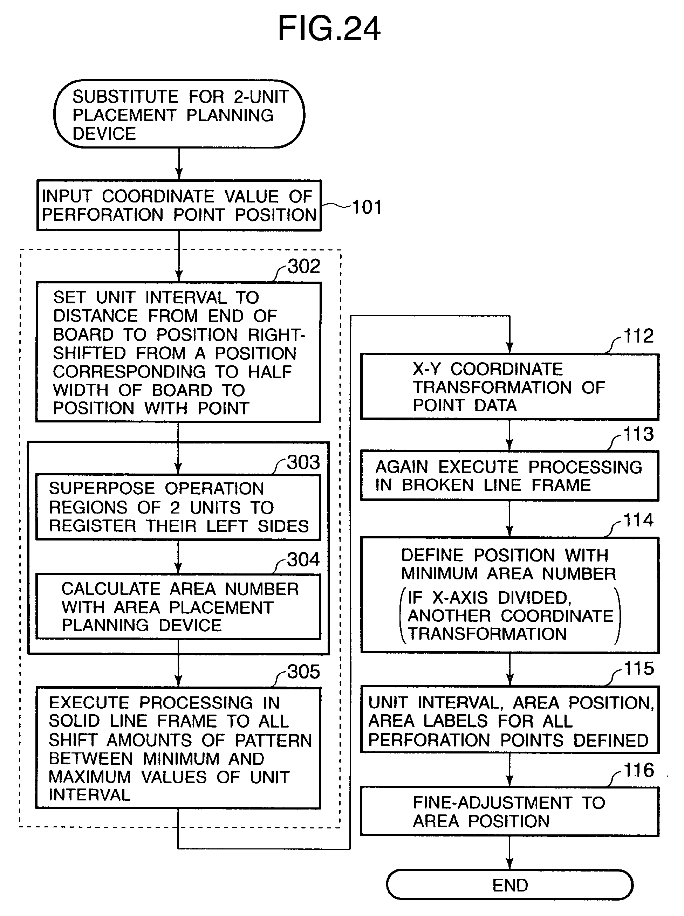

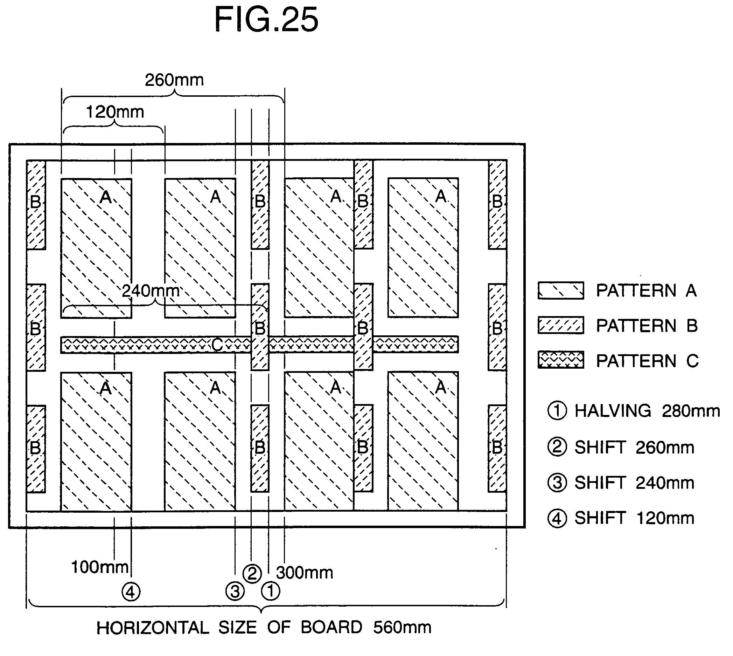

According to the substitute processing method, point data patterns are used, and a general process of processing according to the method is shown in Fig. 24. Fig. 25 shows a candidate for the unit interval according to the method.

According to the method, for both cases of dividing the unit operation region perpendicularly to the X-axis and Y-axis, the area number for each of the following cases is obtained by the area placement planning device 74. In other words, they are the case of determining as the unit interval "the distance from a left end in which area a point is located to a position where a dividing line of the unit is shifted from a position corresponding to half the width in which area the point is located to the point location" and the case of determining as the unit interval "the shift of a pattern all between the minimum value for the unit interval (about 100 mm) and the maximum value (about 300 mm), when CAD data includes pattern information." Then the smallest area number among all is selected.

In the example shown in Fig. 25, the optimal unit interval is the shift amount of the maximum pattern A, i.e., 260 mm or a half (board horizontal size 560 mm/2) i.e., 280 mm.

According to the method, unlike the example shown in Fig. 12 in which the unit interval is determined by the calculation to an appropriate position, those unit intervals between the minimum value and the maximum value among the pattern shift amounts are all subjected to the golden section search in steps 302 to 305. The other features are the same, therefore denoted by the same reference characters and not described.

Meanwhile, the area placement planning device 74 incorporated in the two-unit area placement planning device 72 determines placement of rectangular areas when a minimum number of equal size rectangles (regular square for example) enclose all the points in the two-dimensional region. The device allows the minimized scanning areas (and therefore the minimized stage moving number).

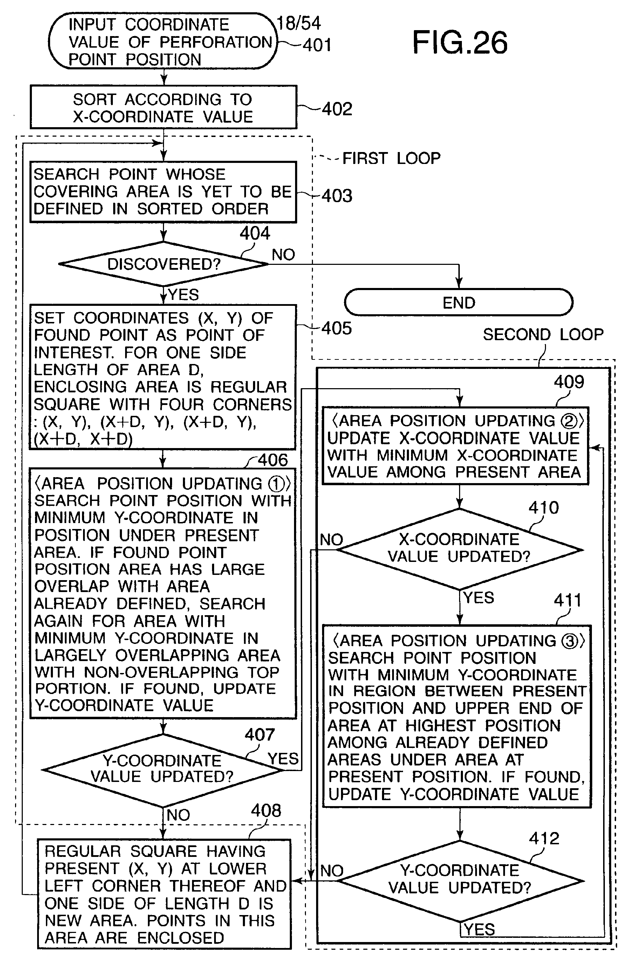

The process of determining the area placement using the device will be now described in conjunction with Fig. 26.

Here, assume that in each process, the present position (X, Y) of interest is at the lower left corner vertex of an area (regular square). In each process, the position of the area is updated.

In step 401, the coordinates of perforation positions are input.

Then, in step 402, the perforation positions are sorted based on the values of the X-coordinates. In steps 406, 409, and 411, the area position is updated in the negative or positive direction on the X-axis. This is because to enclose perforation positions (1) from a perforation position with a small value on the X-axis generally, and (2) from a perforation position with a small value on the Y-axis while the X-axis and Y-axis values are updated so that in one area determination loop, areas can be prevented from overlapping as much as possible.

The device performs two steps of updating the area position in the negative direction (downward) on the Y-axis (steps 406, 411) and the step of updating the area position in the positive direction on the X-axis (rightward) (step 409).

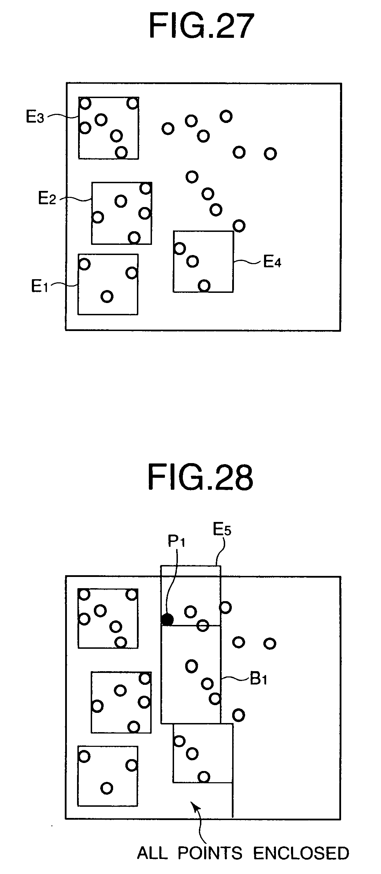

The specific process will be now described in conjunction with Figs. 27 to 32.

In Fig. 27, if four areas E1 to E4 are defined and the position of the fifth area E5 is searched, points whose covering areas are not defined are searched in the sorted order in step 403. The leftmost point P1 not enclosed is found in step 404 as shown in Fig. 28, and the area E5 enclosing the point P1 is provisionally produced in step 405. Then in step 406, the lowermost point not enclosed in a band region B1 corresponding to the width of the area, more specifically, a part under the present area position E5 whose area is yet to be determined with the minimum Y-coordinate value is searched in order to update the area position downward (area position updating (1)). If no such point is found, the previous position is defined.

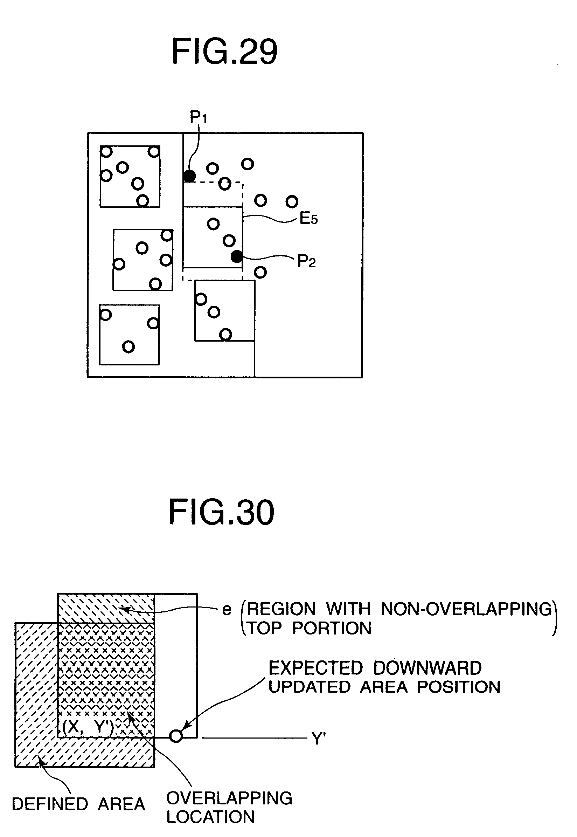

Meanwhile, as shown in Fig. 29, if the lowermost point P2 is found, the position of the area E5 is moved downward so that the point P2 is positioned on the lower side. If the point is discovered, the value of the Y-coordinate is updated by Y', while if the area at (X, Y') and the already defined area overlaps for an area more than a certain value as shown in Fig. 30, the point with the minimum Y-coordinate value is once again searched in the nonoverlapping region e above the greatly overlapping region. If the point is discovered in the region e (Y"), the value of the Y-coordinate is updated by Y" which is the minimum Y-coordinate value in the region e, and overlapping is prevented. If no such point is discovered in the region e, the area position to be processed next is updated rightward, so that the position should be updated rightward to avoid overlapping, and therefore the value of Y-coordinate is directly updated by Y'.

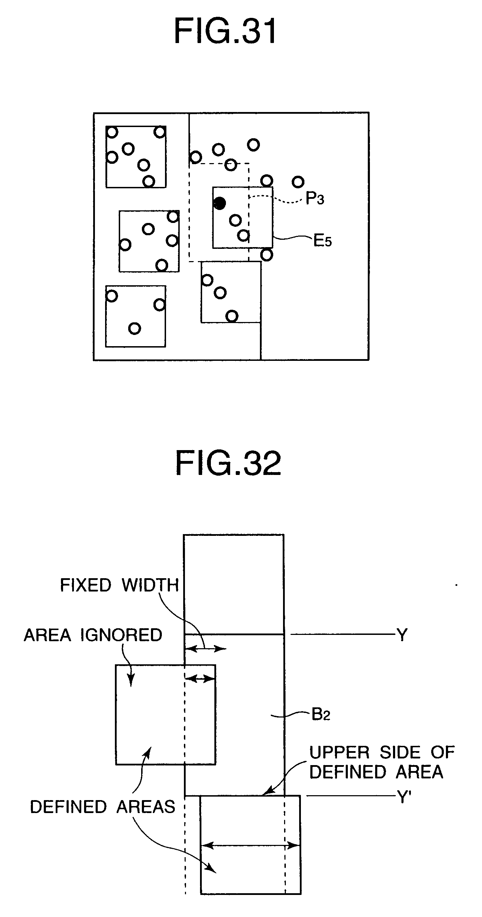

When the value of the Y-coordinate is updated in step 407, the process proceeds to step 409, the position of the area E5 is moved rightward as shown in Fig. 31 in order to update the area position, and the value of the X-coordinate is updated by the value of a point P3 with the minimum X-coordinate value in the present area (updating of the area position (2)).

If the value of the X-coordinate is updated in step 409, the process proceeds to step 411, and the step of again updating the area position downward is performed (updating of area (3)). More specifically, as shown in Fig. 32, the side having the maximum Y-coordinate value on the upper side among the four sides of the already determined areas is searched in the negative direction on the Y-axis from the present area positions (X, Y). Note however that areas which do not have overlapping sides in a prescribed level or more by the downward movement is ignored. The Y-coordinate of the discovered side is Y'. Points with the minimum Y coordinate value whose area has not be determined is searched in the rectangular region B2 which is under the lower part of the present area and whose Y-coordinate value is equal to or larger than Y'. If the point is discovered, the Y-coordinate value is updated by the value.

In the processing using the device, there are a first loop for determining one area and a second loop for fine adjustment of an area position rightward and downward. Once the area position is determined, the process exits the first loop and if the area position is not updated in the area position updating steps 409, 411, the process exits the second loop.

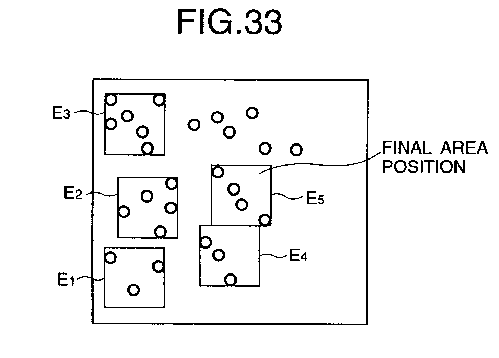

The above processing is repeated until the area positions are defined, and as shown in Fig. 33, the final position of the area E5 is defined. Then, the process proceeds to the loop for searching the next area. Note that the scanning direction or the updating direction of the area positions is not limited to the described examples, and they may be reversed.

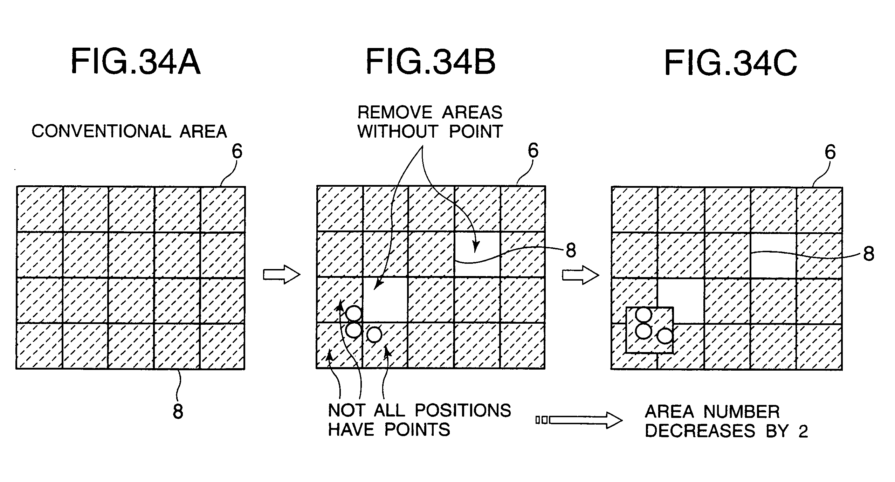

As a variation of the processing by the area placement planning device 74, as shown in Fig. 34, local search in combinatorial optimization problem (also referred to as "iterative improvement method") may be applied, area placement excluding areas without points may be produced based on the conventional area placement, and then the area position may be shifted up and down, and rightward and leftward, so that unnecessary areas can be removed one after another.

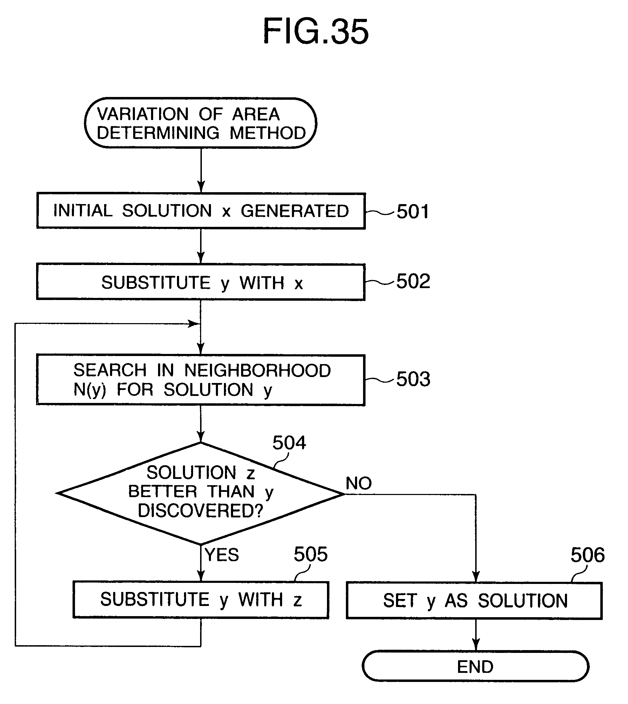

More specifically, as shown in Fig. 35, areas without points are excluded from the conventional areas as shown (A) in Fig. 34, so that the area placement as shown (B) in Fig. 34 is generated as an initial solution. Note that the "solution" is one of possible combinations (solution set) of "area placements (and area numbers) enclosing all the points." A "good solution" refers to a solution with a small area number.

The initial solution can be generated by various other methods than the above method. For example, one possible method may be so-called greedy algorithm known for combinatorial optimization problem which repeats the process of "discovering positions enclosing the largest number of non-enclosed points and placing areas" until all the points are enclosed.

Alternatively, the area placement determined by the process as shown in Fig. 26 may be an initial solution.

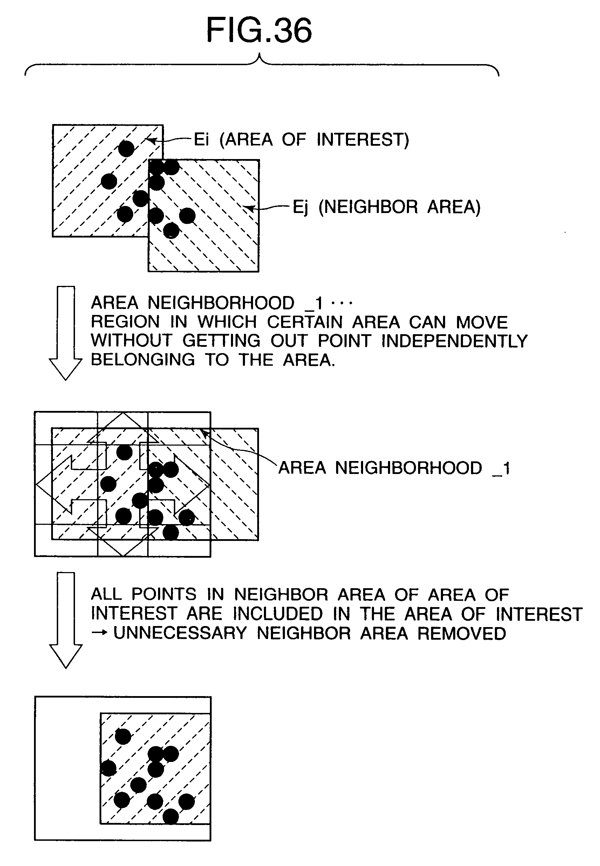

Subsequently, in step 502, y is substituted with an initial solution x, and in step 503, a neighborhood N(y) of the solution y is searched. More specifically, as shown in Fig. 36, provided that points independently belonging to an area Ei of interest stay within the area, if the area position is moved to a position in a movable region, and points independently belonging to an area Ej, one of areas neighboring the area of interest Ei are included in the area resulting from the movement, the neighbor area Ej is not necessary. Therefore, the neighbor area Ej is deleted to discover a solution z better than y, and in step 505, the value of the thus discovered solution z is submitted for y, and the step 503 is repeated.

In the process of the step 503, once a solution better than y can no longer be discovered in N(y), the process proceeds to step 506 and the value of the present y is set as a solution, and the processing ends.

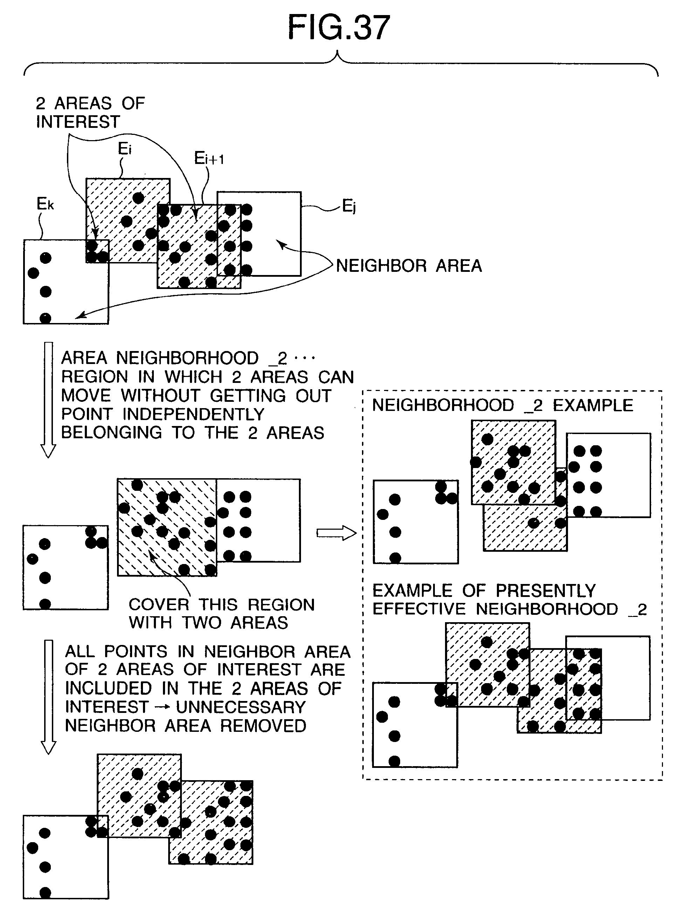

Alternatively, as shown in Fig. 37, provided that points independently belonging to two neighbor areas Ei and Ei+1 joined by an overlapping region, in other words points present in regions other than the overlapping region stay within the two areas, if the area positions are moved to positions in the movable region, and points belonging to a neighbor area Ej are all included in the two areas, the neighbor area Ej is not necessary and may be deleted.

Note that the number of areas joined by the overlapping region may by two or more. More specifically, provided that points independently belonging to n areas Ei, ...., Ei+n-1 joined by an overlapping region (n: 2 or more), in other words points present in the regions other than the overlapping region stay within the n areas, if the n areas are moved to positions in the movable range of the area, and all the points independently belonging to one neighbor area Ej are included in the n areas, the neighbor area Ej is not necessary and may be deleted.

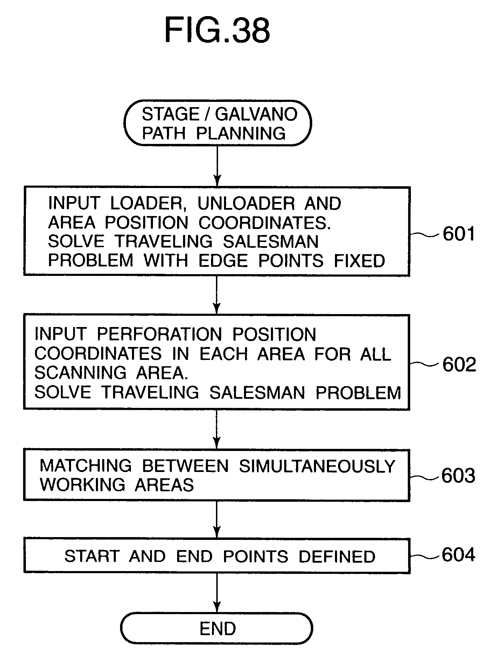

The stage/galvano path planning device 76 plans optimization of the order of visiting scanning areas (stage path) and the order of visiting points at the positions to be worked (perforation positions) in each of the scanning areas (galvano path). The basic process by the device is shown in Fig. 38. The device is mainly characterized by application of a generally well known "traveling salesman problem" (a problem to obtain the shortest traveling path through all the cities to come back to the first city: also abbreviated as TSP) or an variation of this general TSP (referred to as varied TSP) as the case may be. In other cases, if it is not necessary to come back after visiting the points, the start and end points for scanning or moving must be determined.

Application of the traveling salesman problem depending upon the situation and the determination of the start and end points should be performed particularly in consideration of the following points.

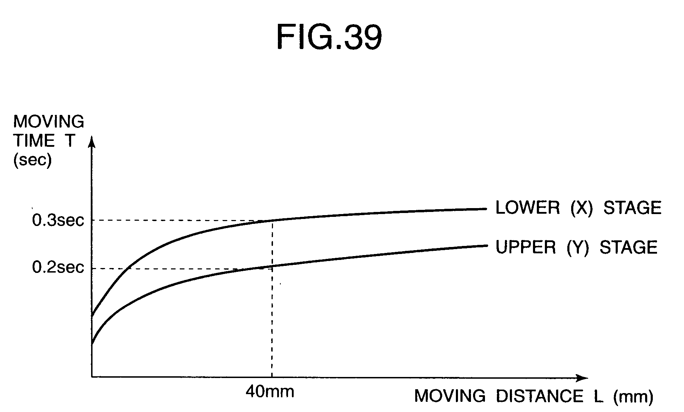

In planning a stage path in step 601, an XY stage 40 includes an X stage 40X to cause movement only in the X-direction and a Y-stage 40Y to cause movement only in the Y-direction as shown in Fig. 1, and therefore the end of one movement of the XY stage 40 is at the end of the movement by the two stages 40X and 40Y. In general, the X stage 40X positioned under the Y stage 40Y is heavy, and is less responsive as shown in Fig. 39.

Therefore, the moving distance L based on working positions (x1, y1) to (x2, y2) is provided by the following expression, assuming that if the moving distance is equal, the moving time period in the X-direction is a prescribed number ($\alpha$) multiple of the moving time period in the Y-direction. The constant $\alpha$ is obtained by experiments.

$$L = \max \{|x1\text{-}x2|,\ \alpha|y1\text{-}y2|\} \qquad\qquad (2)$$

wherein max{p, q} represents the larger one of p and q.

Alternatively, the moving time period Tx(l) and Ty(l) in the X- and Y- directions can be obtained for a moving distance l and the moving distance can be obtained from the following expression accordingly.

$$L = \max \{Tx(|x1-x2|), Ty(|y1-y2|)\} \tag{3}$$

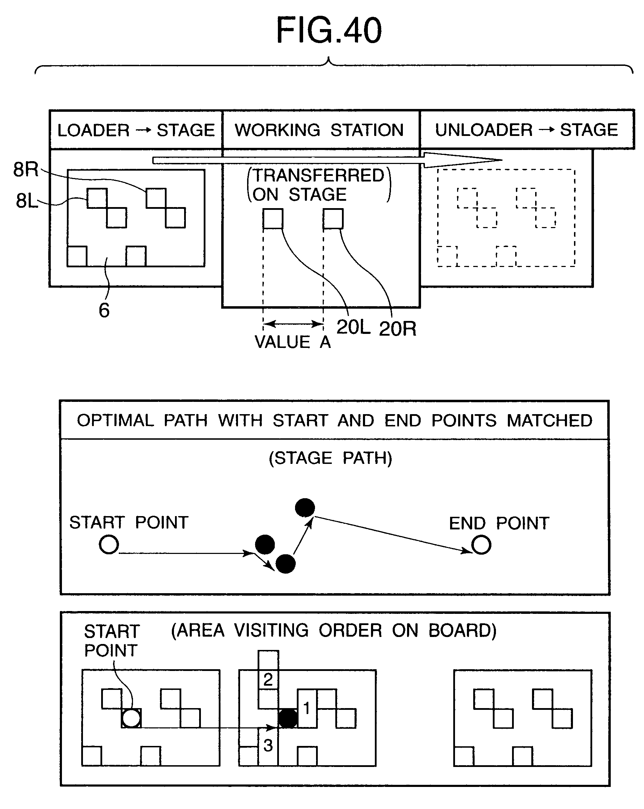

With regard to the start and end points of the stage path, the start point of a stage path is at the position to load from the loader to the stage, and the end point is at the position of the stage before moving to the unloader as shown in the upper part of Fig 40. A traveling salesman problem with fixed edge points may be solved to effectively shorten the stage operation time.

The optimal path for the stage including the start and end points is shown in the middle part of Fig. 40, and the order of visiting on the board at the time (the area visiting direction on the board and the stage moving direction are 180° shifted (reversed) from one another) are shown in the lower part in Fig. 40.

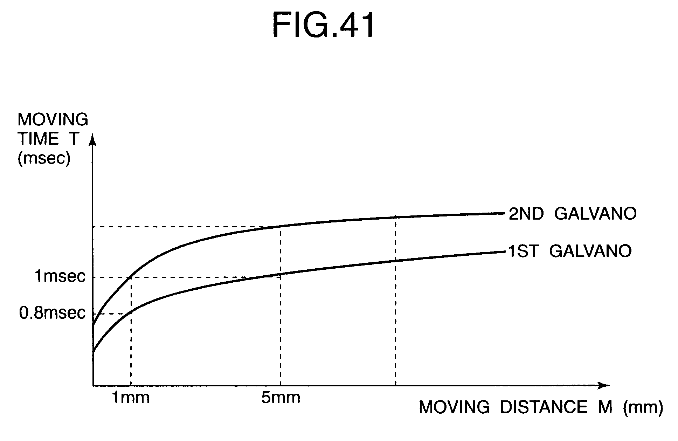

In galvano path planning from steps 602 to 604, as for the distance, first and second galvano scanners 28L, 28R, 32L and 32R are provided so that one axis (the X- or Y- axis) independently changes the other axis. Therefore, the end of one scanning operation by the galvano scanners in one scanning area must be the end of scanning by both the first and second galvano scanners. However, the irradiation range to the second mirrors 30L and 30R is generally larger than the irradiation range to the first mirrors 26R and 26L, and therefore the second mirrors have a larger weight than the first mirrors do. Therefore as shown in Fig. 41, the response of the second mirrors is lower.

For the above reason, the moving distance M from the perforation positions (x1, y1) to (x2, y2) can be obtained from the following expression (assuming that the moving time of the second mirror is a prescribed number ($\alpha'$) multiple of the moving time of the first mirror for the same distance). The constant $\alpha'$ is obtained by experiments.

$$M = \max\{|x1-x2|, \alpha'|y1-y2|\} \tag{4}$$

Alternatively, the moving distance M can be obtained based on the scanning angles $\theta$ and $\delta$ of the galvano mirrors from the following expression rather than based on the coordinates on the board.

$$M = \max\{|\theta1-\theta2|, \alpha'|\delta1-\delta2|\} \tag{5}$$

Another method of setting the distance is from the following expression, while the moving time T'x(m) and T'y (m) in the X- and Y- directions for the moving distance M are obtained by experiments.

$$M = \max\{T'x(|x1-x2|), T'y(|y1-y2|)\} \tag{6}$$

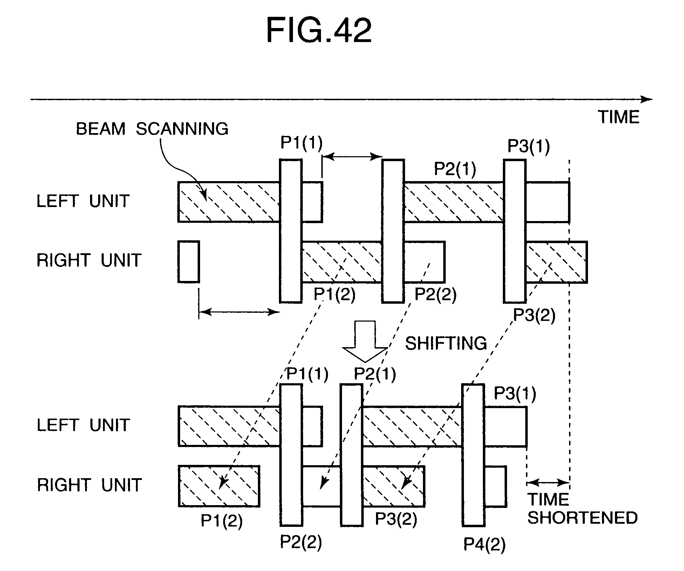

Note that if for example the beam scanning time is unequal between simultaneous working areas in the right and left units as shown in the upper part in Fig. 42, and there is a stand-by time period on one unit side, the start points may be shifted for matching in step 603, so that the beam scanning time periods can be equal, and the total working time period can be shortened.

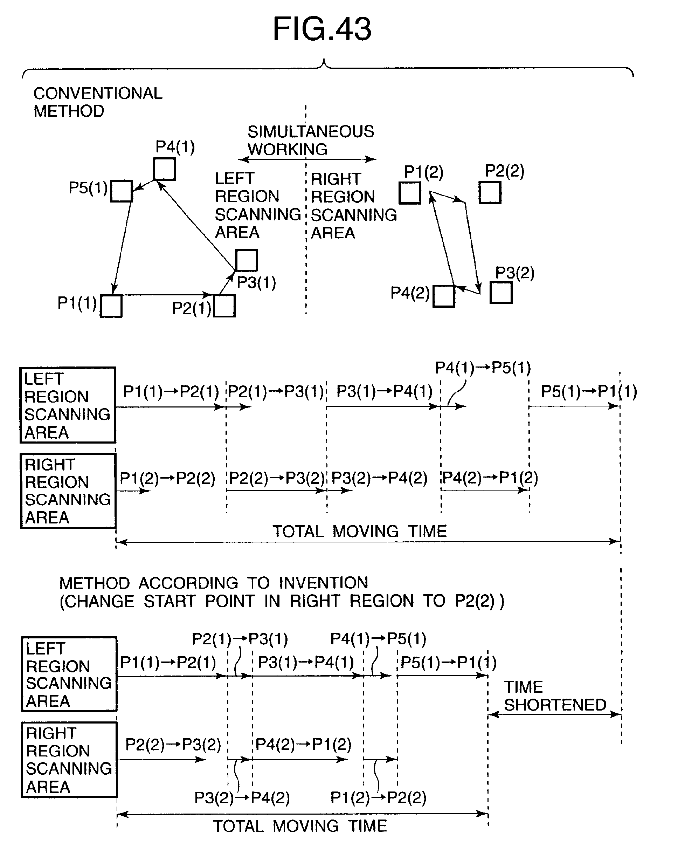

More specifically, if points P1(1) to P5(1) in the left area and points P1(2) to P4(2) in the right area as shown in the upper part in Fig. 43 are to be worked for example, the start point in the right region is changed from P1 to P2 as shown in the lower part rather than in the middle part in Fig. 43, so that the total moving time period can be significantly shortened.

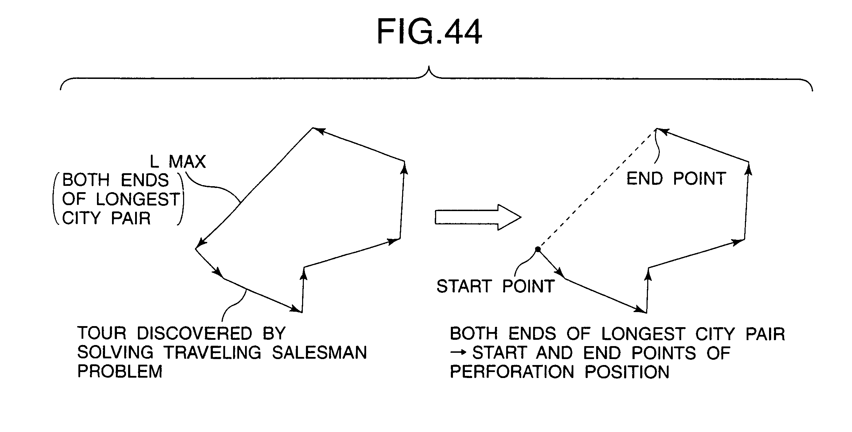

With regard to the start and end points of the galvano path, the start and end points can be determined as shown in detail in Fig. 44 by applying the traveling salesman problem to determine a tour, so that the longest distance (the most time consuming) movement Lmax can be removed.

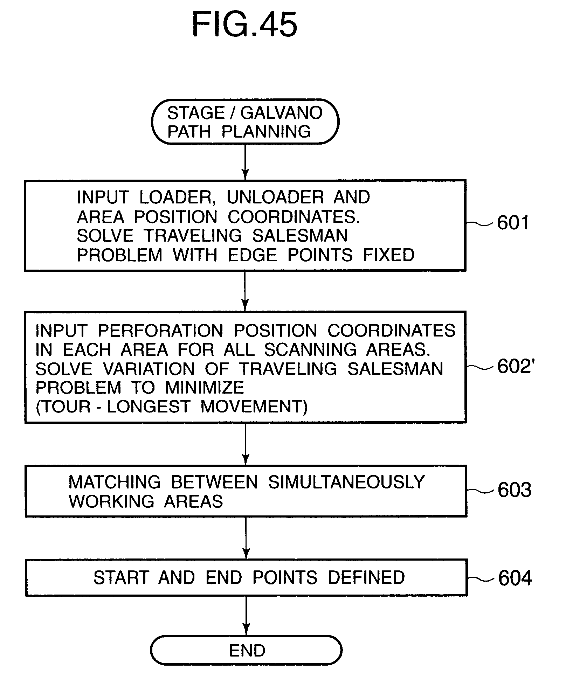

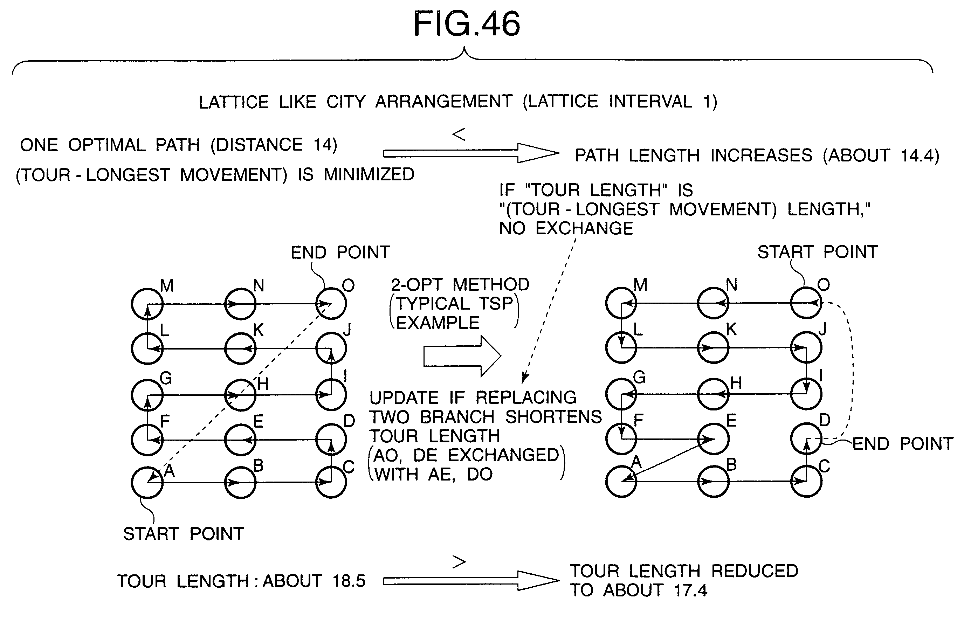

Alternatively, if the number of positions to visit is small, a tour is determined as a substitute processing so as to minimize "(tour length)-(largest moving length)," and the longest movement can be excluded, in practice, as shown in Figs. 45 and 46. Among methods using a traveling salesman problem, k-opt or Lin and Kernighan (LK) algorithm allows iteration of the loop of "searching the neighborhood of a solution (tour) and updating with a neighbor" and the solution is sequentially improved. As a result, if "(tour length)-(largest moving length)" is evaluated as the "solution" of each loop rather than the "tour length", "(tour length)-(largest moving length)" is minimum as the final solution. In Fig. 46, the tour length is smaller on the right side, while if compared based on the "(tour length)-(largest moving length)," the left side is the optimal solution.

As possible approaches in the traveling salesman problem used in steps 601 and 602, Nearest Neighbor, Multiple fragment, 2-opt, 3-opt, Lin-Kerrighan, Iterated Lin-Kerrighan, Chained Lin-Kerringhan, Iterated 3-opt, and Chained-3-opt algorithms can be used separately in consideration of the calculation time and effect (path length).

Embodiments

(1) Two-unit area placement planning device

(a) Effect of area placement planning device

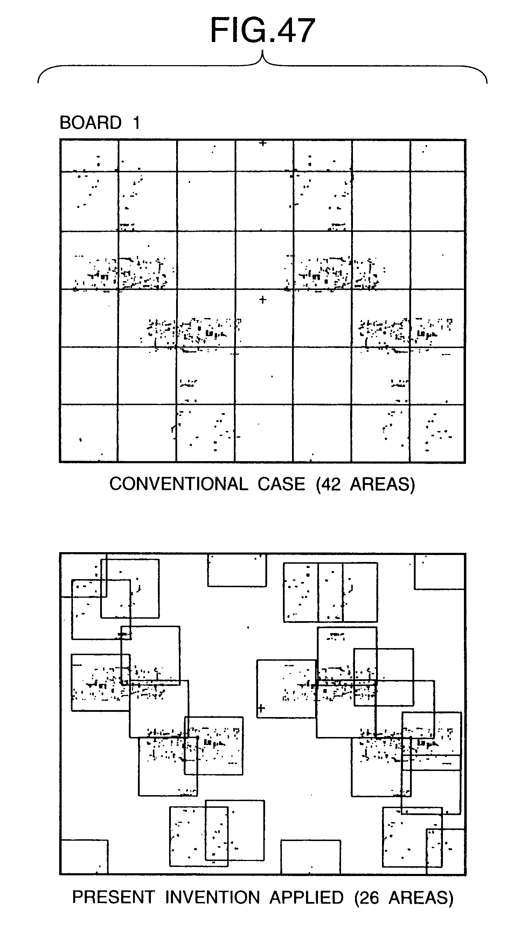

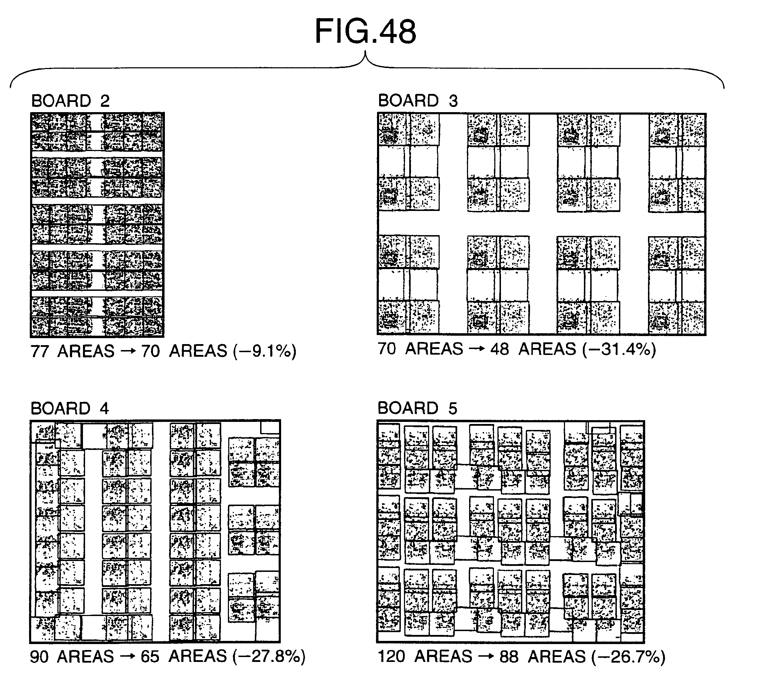

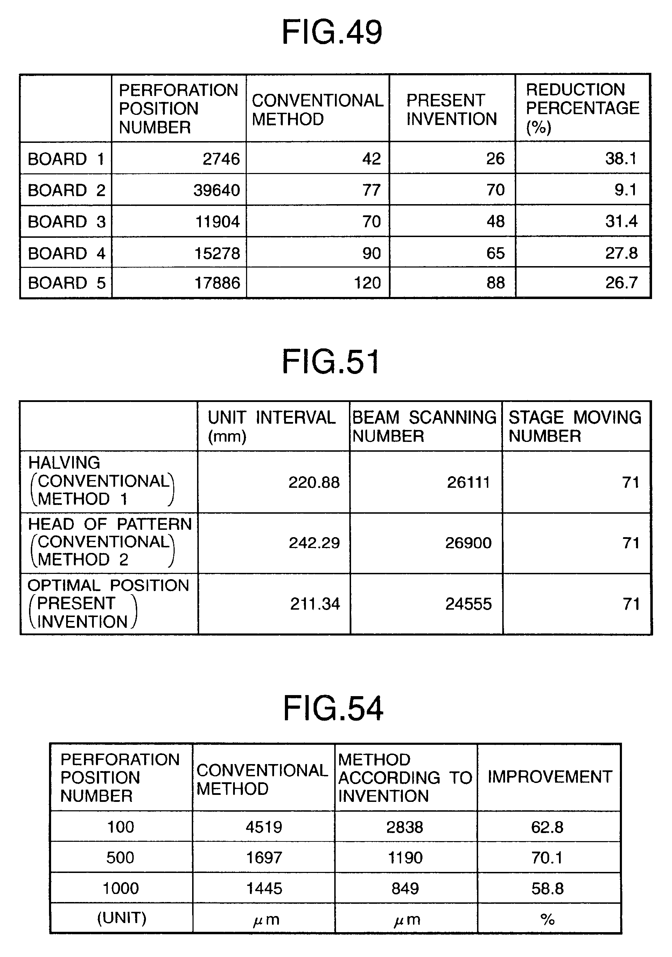

For some real board data, the results of applying the area placement planning device 74 to the entire board are given in Figs. 47 and 48. Here, in order to focus on changes in the area number, the processing of dividing the region into two with two units is not employed, and the entire board is used as a single area. The numerical results are given in Fig. 49. While the result differed depending upon various conditions such as the perforation position number and the density of points, a reduction from 10% to 30% in average in the area number was observed.

(b) Effect of unit interval optimization

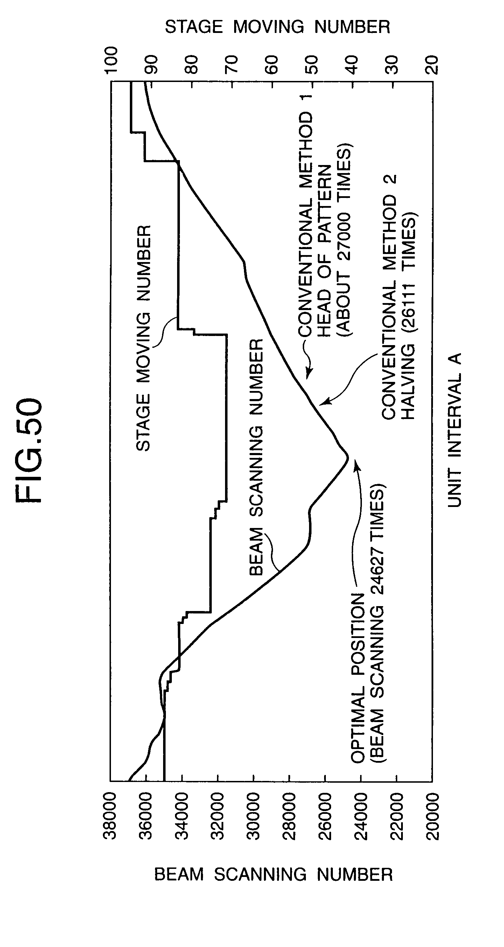

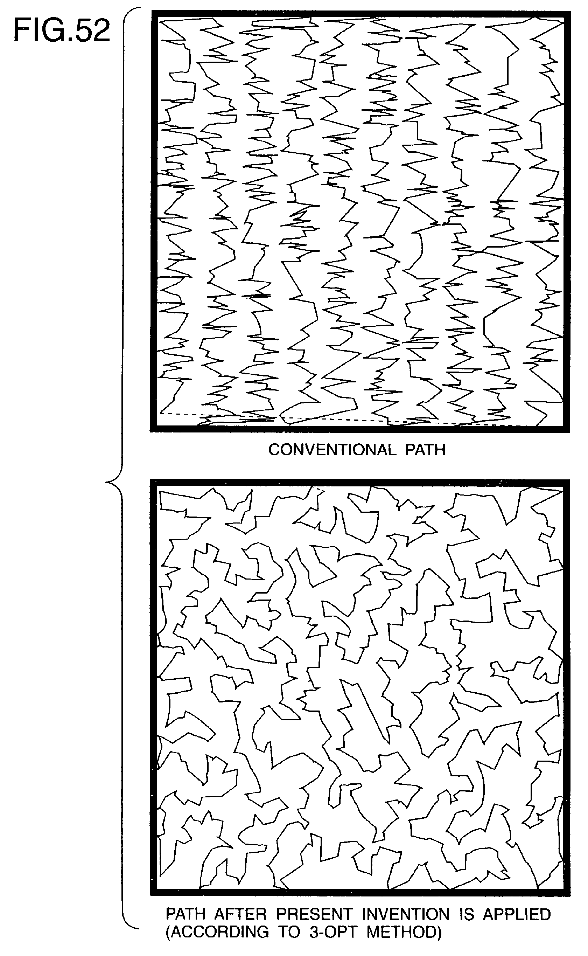

For real board data (perforation position number: 48490), the graph having the unit interval A for the abscissa as the X-axis is divided into two, the beam scanning number for the first ordinate and the stage moving number for the second ordinate is given in Fig. 50. Here, the area placement planning device 74 is not used, and the scanning areas are determined according to the conventional method. The numerical results are given in Fig. 51. Herein, "halving," "the head of pattern" correspond to the conventional methods.
The beam scanning number is 24627, which is improved by about 5% as compared to those by the conventional methods (26111 for the halving, and about 27000 for the head of pattern). Note that the stage moving number (71) is not much different between the optimal position and those by the conventional methods. This is because the area placement was determined based on the conventional area placement method which depends only on the longitudinal and transverse sizes. If the area placement is determined using the area placement planning device according to the present invention, the stage moving number should be different.

(2) Stage/galvano path planning device

(c) Effect of applying traveling salesman problem

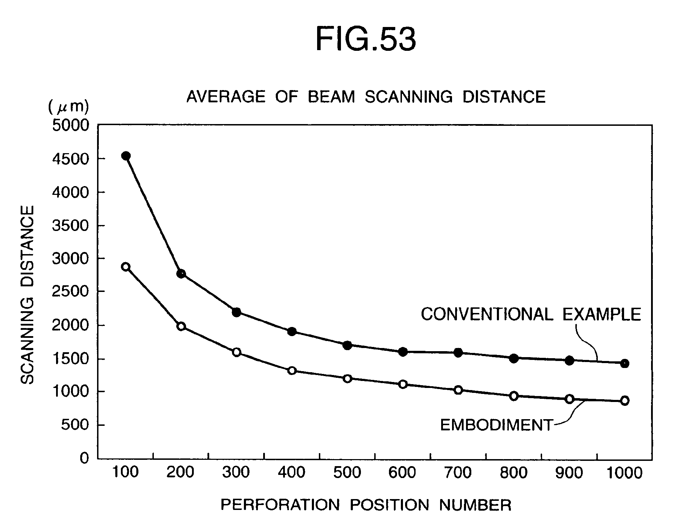

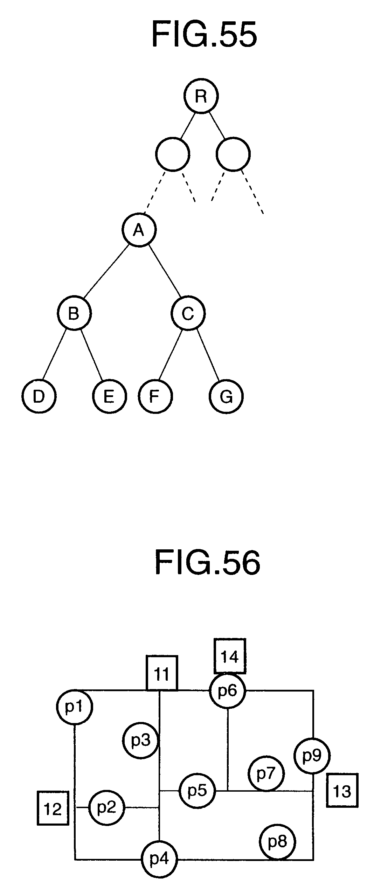

In a foursquare region of 40 mm × 40 mm, perforation positions were generated using random numbers for simulation. Figs. 52 and 53 are diagrams where the abscissa represents the number of perforation positions, and the ordinate represents the average value of one movement by the galvano scanner. As the distance measurement used for experiment, the distance for the same moving speed in the X- and Y- directions is used for the stage and galvano scanners where $\alpha = \alpha' = 1$ in the expressions (2) and (4). Here, the result by the conventional methods and that by the application of 3-opt well known as one of traveling salesman problem approaches are compared. A part of the result is given in Fig. 54. Regardless of the difference in the number of perforation positions, the average value of the distance by one movement of the galvano scanner was improved by about 30% to 40%.
As described above, along with the effect of reducing the area number using the area placement planning device, the stage total moving time is surely reduced and improved about by 20 to 30%.
As describe above, application of the stage/galvano path planning device according to the present invention surely reduces the total moving time of the galvano scanner approximately by 30% to 40%.
Note that the planning device is characterized by an aspect related to combinatorial optimization such as traveling salesman problem, and a computational geometry aspect such as data search in a two-dimensional plane. In general, these problems require enormous calculation time if the processing method is wrong. More specifically, when the geometrical point data such as perforation positions is analyzed and planned, improvement to the precision of plans is tradeoff for time necessary for computation (operation by a CPU) in planning. In order to achieve good planning, the time consumed for computation should be enormous regardless of whether planning is executed as off-line or on-line processing, which increases the time necessary for the planning itself.
An embodiment directed to a solution to the problem will be now described in detail.
According to the embodiment, the position data of points in a two-dimensional plane is for example represented in a tree data structure such as a k-dimensional binary search tree (abbreviated as kd-tree), so that the following processings at the working planning device for a laser drilling machine is operated at higher speed, and the time required for planning itself can be shortened.

(1) An orthogonal range query listing points present in a rectangular region

(2) A nearest neighbor query to search the nearest point to a certain point

(3) Constructing a neighbor-list sequentially including a prescribed number of neighbor points to a certain point

(4) Constructing a traveling path by nearest neighbor which is one of solutions of the traveling salesman problem

(5) Exact match query to determine whether a point placement of a region and another region is exactly matched

The kd-tree will be now described. The kd-tree is one of data structures used for effectively performing point data search in a multi-dimensional space and expressed in the structure of a binary search tree well known as a data structure for effectively searching in a one-dimensional region in a multi-dimensionally generalized manner. The binary search tree is expressed in one of binary tree structures according to the graph theory. The searches include for example basic queries using database such as orthogonal range query, exact match query and partial match query.

Here, for the binary tree as shown in Fig. 55, the terms will be briefly described (which is minimum necessary description; please read reference books on graph theory for more precise definitions of the terms). The binary tree is expressed in a form systematically widening downwardly from a special node (o) called root (denoted by R in the figure) arranged in the uppermost part. Therefore, the relation between nodes of a binary tree is typically expressed by terms for the kinship of animals and organisms as follows. For example, A is a "parent (father)" of C, D and E are "children" of B, D and E are "brothers," A is an "ancestor" of F, and F is a "descendent" of A. Based on the definition of a binary tree, each node has two or less child nodes. A node without a child is called "leaf" node while the other nodes are called internal nodes (including roots).

Briefly speaking, a typical binary search tree has the following structure.

(1) An internal node of a tree (including a root) has two child nodes, and stores a dividing value for aiding search.
(2) A leaf node of a tree stores a point(s).

This is extended into the following definition of a multi-dimensional binary search tree, i.e., kd-tree.

(1) An internal node of a tree (including a root) has two child nodes, and stores an axis (X- or Y- axis) to be divided by a line to aid searching and a dividing value.
(2) A leaf node of a tree stores a point(s).

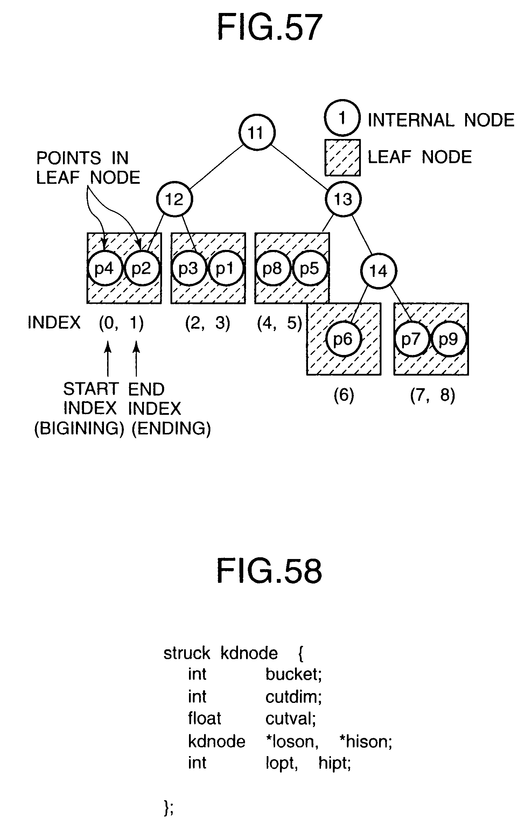

More specifically, in a typical binary search tree, the internal node holds section information (segment) and a dividing value for dividing the segment into two (a position to divide the segment), while the kd-tree holds region information (rectangular region) and a dividing line for dividing the region into two (a line dividing the region into two and parallel to the length or width of the rectangle). For example, nine pieces of point data (P1 to P9) scattered in a two-dimensional plane as shown in Fig. 56 are expressed as shown in Fig. 57 using the k-d tree. As can be seen, each point data piece is sequentially divided into two by a dividing line stored at the internal nodes from the root and formed into a leaf node when the number of the data pieces is finally two or less.

The two-dimensional kd-tree allows variations in how to set a dividing axis, which is determined as follows according to the embodiment.

(1) A dividing axis at an internal node (11, 12, 13, and 14 in Fig. 57) is set to divide the larger one of the width and length of a rectangular region corresponded to the nodes. "A rectangular region corresponded to a node" refers to a region before being divided into two by a dividing line stored by the node. The region corresponded to the root is for example the range of the original point data itself.

(2) The dividing value at the internal node is the value of the n/2-th element counting all the points (n points) i.e., in the rectilinear region corresponded to the node from the smallest value of the dividing axis (which refers to the Y-coordinates if the dividing axis is Y-coordinate), i.e., the element in the center.

(3) A node is turned into a leaf node (P1,...,P9 in Fig. 57) if the number of point data pieces represented by the node is a prescribed number or less (two or less in Fig 57).

(4) Therefore, a leaf node has two number indexes (the start and end positions) allocated to the point data (assuming point data are stored in an array with indices) as shown in Fig. 57.

Each node can be expressed as shown in Fig. 58 using structure types in the C language (C++ language). Here, "struct kdnode" is a node, "bucket" (integer type) represents distinction between a leaf node (1 for example) and an internal node (0 for example), "cutdim" (integer type) represents the direction of a dividing axis (parallel to the X- or Y- axis), "cutval" (floating point type or integer type) represents a dividing value, "*loson", "*hison" are pointers to a child node, "lopt" (integer type) is a starting index, "hipt" (integer type) is an ending index. Actual point data belonging to a region corresponded to each leaf node is for example stored in "perm[lopt,...,hipt]" for example using array.

In a kd-tree, minimum necessary items to be held by each node are as follows.

(1) Internal node ...information about a dividing line (a dividing axis and a dividing value) and a child

(2) Leaf node ...starting and ending indexes for a perforation position

Therefore, for the internal node (bucket=0), there need only be "cutdim", "cutval", "*loson", and "*hison" in Fig. 58. Meanwhile for the leaf node (bucket =1), there need only be "lopt" and "hipt".

The effective processing using the kd-tree in the working planning device for the laser drilling machine will be now described.

1. Rectangular (Orthogonal) range query

Rectangular range query is a process of listing points in a rectangular region within and a range of the rectangular region parallel to the frame as Fig. 57 shows. The search is used to list points in an area during or after the step of determining area positions on the process of determining the placement using the area placement planning device.

More specifically, according to the conventional method, all the point data is accessed, whether or not the points are within a search region is judged and the result is reported. Meanwhile, according to the present invention, top-down search is executed from the root node to leaf nodes of a tree. More specifically, if the node is an internal node, it is judged whether or not to search both child nodes of the node depending upon the degree of overlapping between the region corresponded to the node and the search region. The judgment is made as follows.

(1) When the search region is within the region corresponded to the node, all the point data within a partial tree having the node as a root is reported.

(2) When the search region and the region represented by the node partially overlap, the search is continued.

(3) when there is no overlapping region between the search region and the region corresponded to the node, no search is conducted.

If the node is a leaf node, all the point data of the node is accessed and it is judged whether or not the points are within the search region and the points within the search region are sequentially reported.

According to the conventional method, all the points must be accessed, and as the number of perforation positions increases, the time required for searching expands. Meanwhile, according to the kd-tree search method according to the present invention, the point data is not directly accessed but top-down search from the root node to leaf nodes of a tree is conducted, and the judgment at each node is only about the degree of overlapping with the search region (inclusion, overlapping, no overlapping). Point data is directly accessed only when a leaf node is reached, so that the time for searching is surely reduced.

(2) Nearest neighbor query

(3) Constructing neighbor-list

(4) Nearest neighbor (traveling salesman problem)

The processings (2) to (4) are each closely related with increase in the operation speed for a traveling salesman problem. The processings (3) and (4) in particular both repeatedly use the processing (2), and therefore will be described together as follows.

(2) Nearest neighbor query

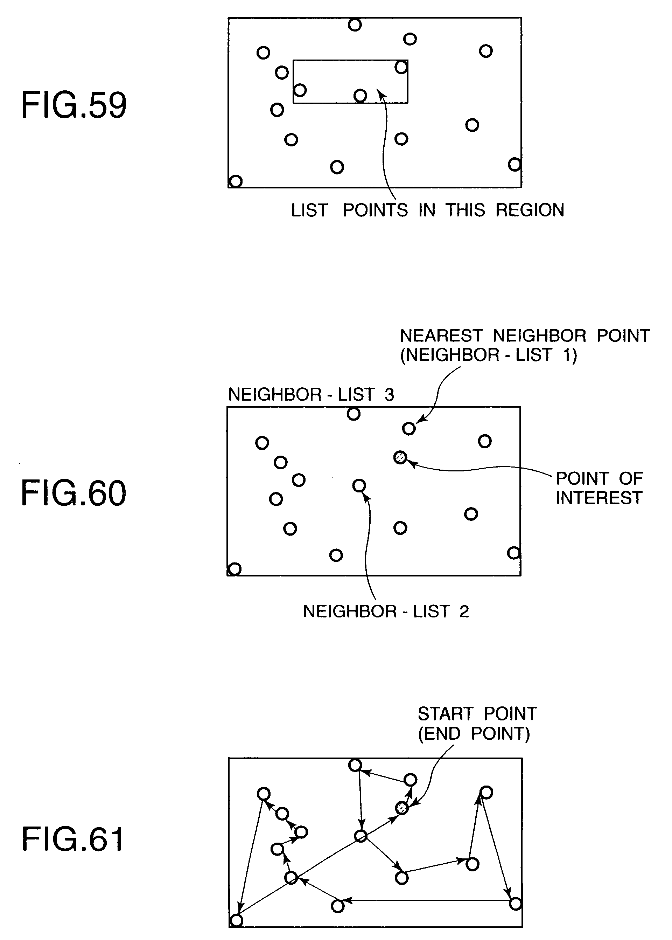

As shown in Fig. 60, the nearest neighbor query is a processing to search the point nearest to a point of interest in a region. The processing is repeatedly used in the process of (3) constructing a neighbor-list, and (4) the nearest neighbor.

(3) Producing neighbor point list

As shown in Fig. 60, a prescribed number (list length: three in the example in Fig. 60) of points found are listed in the order of their nearness to the point of interest in the region. The processing is achieved by iteration of the nearest neighbor query and deleting temporarily removing a found neighbor from a tree. The processing is performed as a preparation of producing data to be attached to each point data so that the traveling salesman problem is solved at higher speed, and the processing is performed to all the points in the region.

(4) Nearest neighbor

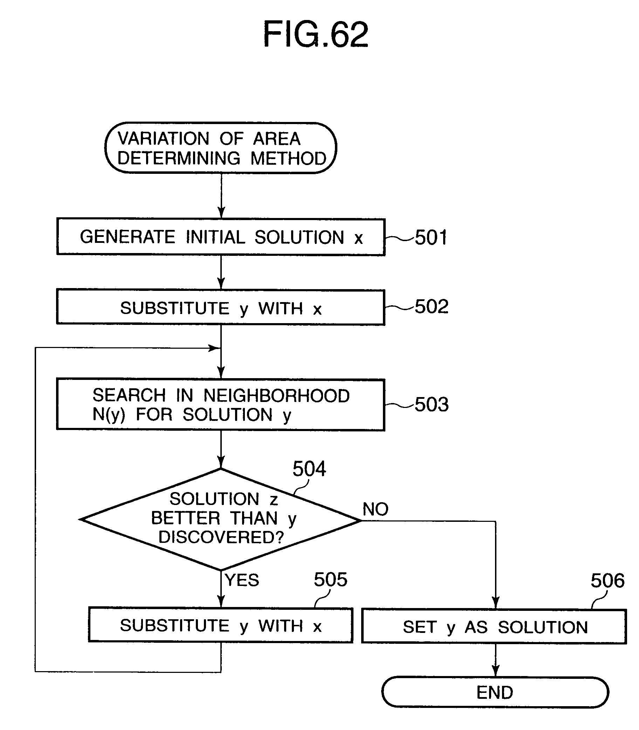

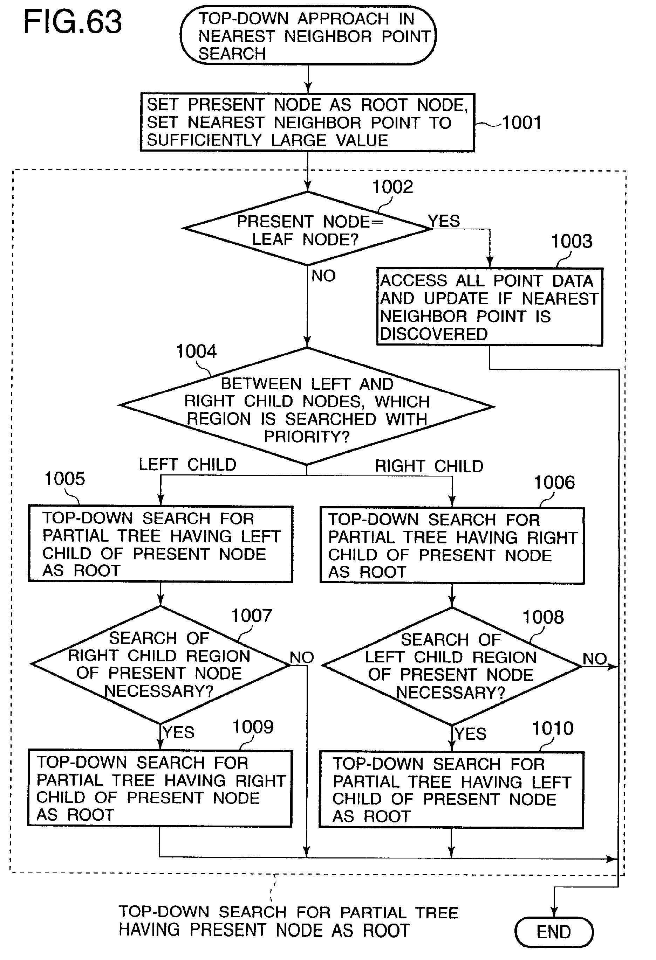

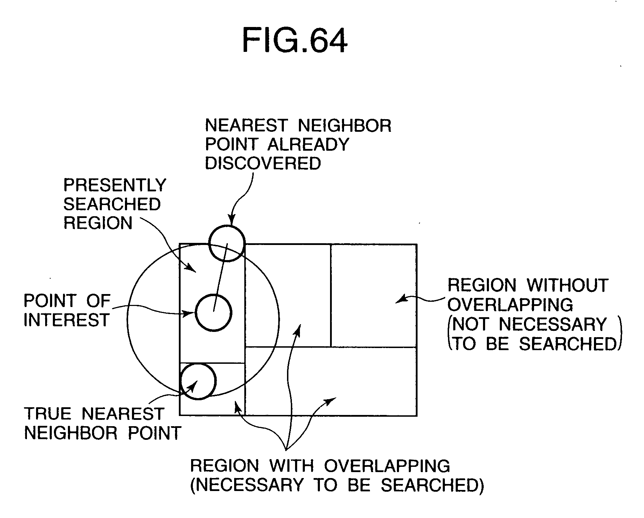

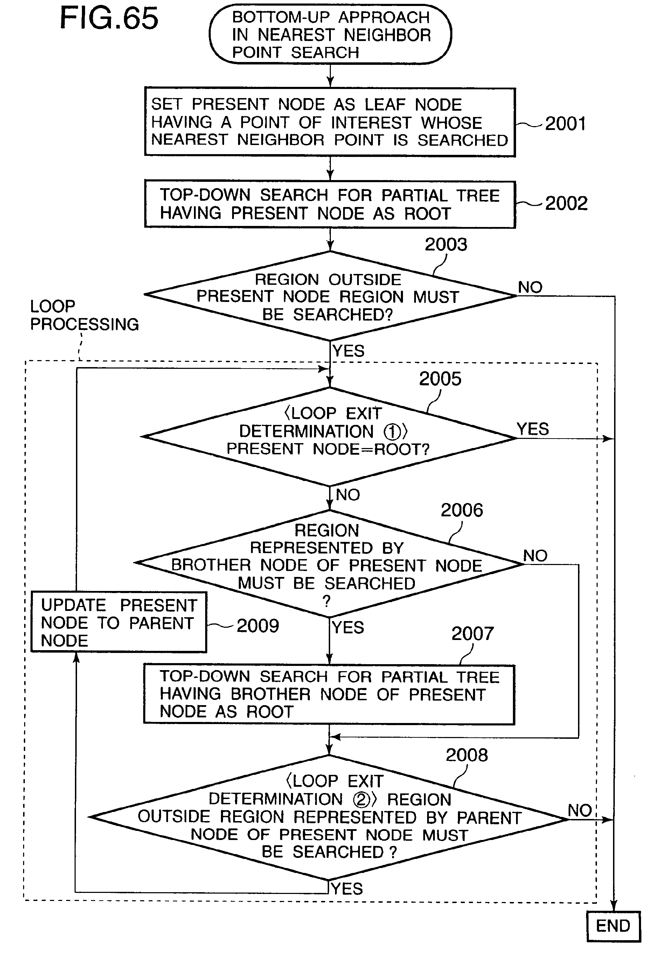

As shown in Fig. 61, according to the nearest neighbor, an initial point is appropriately determined as a point of interest, and the processing of "the neighbor point nearest to the point of interest and yet to be connected to a path is searched, and the found point is set as a new point of interest" is repeated until making a tour. The processing is achieved by iteration of the nearest neighbor query and the temporal deletion of a found nearest neighbor from a tree.
The processing is advantageous because high speed processing is enabled, and a solution with relatively high precision (tour length) is secured. Therefore, the solution can be used as an initial solution (step 501) in using a solving method belonging to the kind of an iterated improvement method for the traveling salesman problem shown in Fig. 62.
For the nearest neighbor query, according to the conventional method, the distances between a point of interest in a region and all the points other than the point of interest in the region are calculated to obtain the nearest point.
For constructing the neighbor-list, according to the conventional method, the distances between a point of interest in a region and all the points other than the point of interest in the region are calculated and arranged in a list starting from the point with the shortest distance for a list length.
According to the conventional method of achieving the nearest neighbor, the distances between a point of interest and all the points yet to be connected to a path are calculated in each iteration and the nearest point is searched to update the point of interest.
These processings all apply (2) the nearest neighbor query, while according to the method of nearest neighbor query by the invention, there are roughly two ways of tracking a tree. They are a top-down search from the root of the tree and a bottom-up (search) from a leaf node where a point of interest is located.
The top-down search will be described with reference to a particular processing process in conjunction with Fig. 63.
The search is performed by recursively calling "the top-down search processing for a partial tree having the present node as a root." More specifically, the part enclosed by the broken line corresponds to "the top-down search processing for a partial tree having the present node as a root," while in the processing, the present node is updated to the left or right node, so that the broken line part can be processed (steps 1005, 1006, 1009, 1010).
In step 1001, the present node is set as a root and the distance to the nearest neighbor point is set to a huge value. Then, in "the top-down search processing for a partial tree having the present node as a root," it is judged in step 1002 whether the present node is a leaf node. If the present node is a leaf node, all the point data is accessed in step 1003, and if the nearest neighbor is found, updating is performed with the found point. If the present node is an internal node, it is determined in step 1004 which is to be searched with priority between left and right child node regions. The determination is based on the comparison between the dividing value of a dividing line for the present node ("cutval" in Fig. 58) and the value of the dividing axis of the dividing line for the point of interest whose nearest neighbor point is searched. Steps 1007 and 1008 are performed to judge whether it is necessary or not to search a region corresponded to a brother node to the node searched immediately before. Here, as shown in Fig. 64, it is judged whether or not there is an overlap between a circle centered on a point of interest whose nearest neighbor point is searched and having a radius as long as the distance to the present nearest neighbor point (here, the word "circle" refers to a closed curve consisting of points at an equal distance from the center and the distance measure does not have to be Euclidean distance) and the region corresponded to the node. (one may include the other.)
The bottom-up method will be now detailed with reference to the specific process in conjunction with Fig. 65.
According to the method, a leaf node having a point of interest is set as the initial node for search, and a brother or parent node to the present node is searched as required. In this case, each node must be attached with a pointer to point the parent node. Therefore, in Fig. 58, a kdnode type pointer, "*father" is added as a structure type element. Note however that the root node does not have a father node, and therefore points "NULL".
In step 2001, the present node is set to a leaf node having a point of interest whose nearest neighbor is searched (therefore, each point data must have a pointer to point the leaf node where the data belongs), and the distance to the nearest neighbor is set to a huge value. In step 2002, the present node is at a leaf node in practice, and therefore all the points in the present node are accessed to update the nearest neighbor. In step 2003, it is judged whether or not search must be conducted outside the region represented by the present node. More specifically, it is judged whether or not a circle centered on a point of interest (whose nearest neighbor point is searched) and having a radius as long as the distance to the present nearest neighbor point is included in the region corresponded to the present node. If the circle is not included, the process enters the loop processing enclosed by the broken line.

There are two criteria for judging exit from the loop. One is judgment in step 2005 in which it is judged whether or not the present node updated in step 2006 is a root node. The other is judgment in step 2008 in which it is judged whether or not search must be conducted outside the region corresponded to the parent node of the present node. More specifically, similarly to step 2003, it is judged whether or not a circle centered on a point of interest whose nearest neighbor point is searched and having a radius as long as the distance to the present nearest neighbor is included in the region corresponded to the present node.

In step 2006 in the loop processing, it is judged whether it is necessary or not to search a region corresponded to a brother node to the present node. More specifically, it is judged whether or not a circle centered on a point of interest whose nearest neighbor is searched and having a radius as long as the distance to the present nearest neighbor point overlaps the region corresponded to the present node. If there is an overlap, actual search is executed in step 2007.

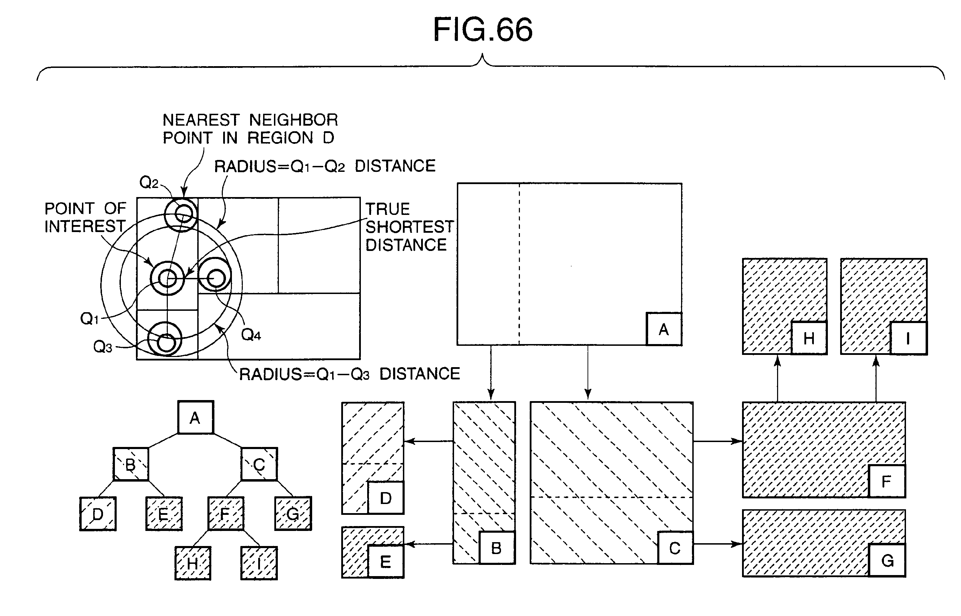

More specifically, as shown in Fig. 66, if a point of interest is in a region D, search is started from the region D having the point of interest Q1 according to the bottom-up method (step 2001). In the region, the distances from all the points to the point of interest Q1 are checked (step 2002), and if the found nearest neighbor point is Q2, then it is determined whether or not a circle centered at Q1 and having a radius as long as the distance between Q1 and Q2 is partly outside the region D (step 2003). In this example, the circle is not entirely within the region D, and therefore further search is necessary. The region D is not a region corresponded to a root node (entire region)(step 2005), and therefore it is then judged whether or not a region E, a brother region to the region D should be searched (step 2006). The judgment is based on the degree of overlapping with the circle, and since there is an overlap in this example, search is performed in the region E (step 2007). In this example, a point Q3 nearer to Q1 than Q2 is found in the region E. Thus, search in the regions D and the region E (i.e., in the region B) has been completed, while there is a possibility of a point existing even nearer than Q3 outside the region B and therefore it is then determined whether or not a circle having a radius as long as the distance between the point of interest Q1 and the nearest neighbor point Q3 and centered on point Q1 is partly outside the region B (step 2008). In this example, the circle is partly outside, and a brother region C to the region B must be searched, and therefore the present node is updated to a node representing region B (i.e., updated to a parent region to the region D) (step 2009), and the process returns to the step 2005. After repeating the above steps, the nearest neighbor point Q4 is finally found in the region H, and the process is completed.

(3) Constructing neighbor-list

A neighbor-list is constructed by alternately repeating the above two processings i.e., (2) nearest neighbor search, and the processing of "temporarily deleting a found nearest neighbor (point) from a tree."

A point data may temporarily be deleted from the tree as follows. More specifically, as shown in Fig. 58, a leaf node of a tree has the start and end numbers of an index attached to each point data. Therefore, basically, to delete a point, reduce (or increase) the end number (or the start number) by one, and exchange the data with the data at the position resulting from the reduction (or increase). If the point is removed and then the point data in the leaf node entirely disappear, information for the node is provided to indicate the disappearance of points in the region represented by its node ("empty" (integer type) is added to the element of a structure type for each node as shown in Fig. 58 in order to indicate the presence/absence of points) in order to eliminate the necessity of visiting the leaf node

(4) Nearest neighbor method

The nearest neighbor method is realized by alternately performing the nearest neighbor query in the above (2) and the processing of temporarily deleting a found nearest neighbor point from the tree similarly to (3). Unlike (3) according to which a point of interest is usually fixed, according to (4), a found nearest neighbor point is updated to a point of interest.

According to the conventional nearest neighbor query, all the other point data is accessed to calculate the distances from a point of interest, and the smallest result must be kept. For constructing a neighbor-list, all the other data must be accessed to operate to obtain the distances to the point of interest, and they must be sorted by the distance. The operation is performed to all the point data, and therefore the distances calculation operation is conducted to all the point data sets. For the solution method by nearest neighbor method, points yet to be connected to a path must be recognized, all the point data must be accessed for distance calculation and the smallest data must be kept.

These methods are not particularly refined, especially in producing a neighbor-list, the method without using the kd-tree consumes enormous time for calculation, and therefore a traveling salesman problem must directly be solved rather than performing the preparation for high speed processing, in other word without constructing a kd-tree. By this method without the preparation, however, a precise solution cannot be provided in a limited calculation time, and the working time cannot be effectively reduced.

Meanwhile, by the kd-tree search according to the present invention, the nearest neighbor query includes the top-down approach and the bottom-down approach. The bottom-up approach particularly allows direct access to a leaf node having a point of interest, which can significantly increase the operation speed.

In producing a neighbor-list, deleting point data from a tree can be achieved at high speed, and therefore the processing can be executed at much higher speed. The neighbor-list is produced as a preparation for increasing the speed of a method belonging to local search methods for a traveling salesman problem, and therefore though indirectly the speed of solving the traveling salesman problem could be increased.

For a solution method for nearest neighbor method, the operation speed can be increased for the same reason. The nearest neighbor method provides an initial solution to a method belonging to local search methods for a traveling salesman problem, and therefore the processing of solving the traveling salesman problem can partly be achieved at higher speed.

(5) Exact match query

Exact match query is to ask about the presence of a points having coordinates in exact match with a certain points in a region. Using the query, it can be judged whether or not the relative arrangement patterns in a certain scanning area and another scanning area are in exact match.

All the perforation positions belong to one scanning area. For points in a scanning area, the visiting order (galvano path) is optimized using a traveling salesman problem. The amount of calculation by a traveling salesman problem is relatively larger than the rest, and therefore areas whose point positions are entirely equal among all the scanning areas, and an area which does not necessitate solution of a traveling salesman problem are searched. If such an area can be found and the necessity of solving a traveling salesman problem is eliminated, it immediately means an increase in the calculation speed.

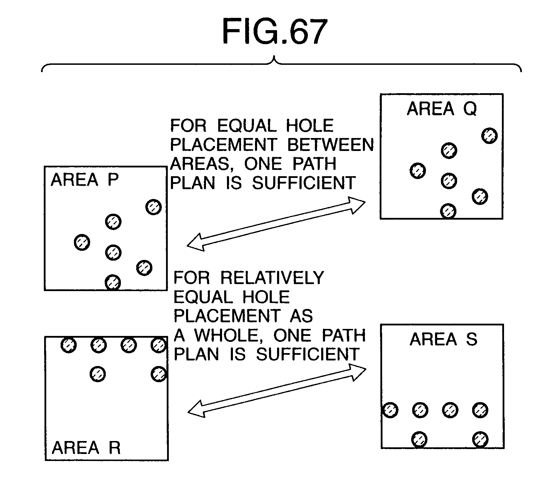

For the purpose of eliminating the necessity of solving a traveling salesman problem, all the point positions do not have to be entirely the same for areas, and relative positional relation needs only be in coincidence for each points. More specifically, as shown in the upper part in Fig. 67, if all the point positions are exactly the same, and the galvano path for the area P is determined, there is no need to re-plan a path in the area Q. Similarly, when one point position is offset to the other point position like the relation between areas R and S in the lower part in Fig. 67, the path in the area R needs only be determined and the path in the area S does not have to be planned. The offset amount may be the difference between the absolute coordinates of representative points in both areas such as the minimum x and minimum y.

The processing of judging point arrangement matching between scanning areas using the exact match query is performed when the area position is determined.

According to the conventional method, all the points in a region are accessed and compared one by one with the coordinate values of a point of interest for matching.

Meanwhile, according to the present invention using the kd-tree, the offset amount between an area of interest and another area of interest is calculated, and then the presence of coordinates produced by adding the offset amount to the coordinates of each point in the area of interest in the other area of interest is searched from the root node of the other area of interest to a child node to the present node. The search is sequentially executed to the child node having the coordinates being searched. When the search is reached to a leaf node, all the points in the node are compared one by one for matching.

Thus, all the point data is not accessed while the top-down search from the binary tree root node is performed, which reduces the number of comparison and the calculation speed increases.

The kd-tree used according to the present invention is built from point position data, and a region in which the point position data is present. According to the embodiment, a kd-tree is built after a temporary region is produced using two-unit area placement planning device and the area position is defined.

More specifically, the orthogonal range query at the time of producing a temporary region is applied to point listing and the like in an area during the area position determination in the process of "area placement planning device." Therefore, every time the loop is called by the optimal unit interval value determination processing, and the temporary region is produced, a tree related to the temporary region and the temporary point position data is formed.

The nearest neighbor search, constructing a neighbor-list, and the nearest neighbor method are all related to the traveling salesman problem. The traveling salesman problem is generally used to optimize an area position visiting order (stage path) and a perforation position visiting order (galvano path) in a scanning area. Therefore, when an area position is defined, one tree related to a provisional region with the optimal unit interval value and point data is produced, while a tree related to a scanning area region and perforation positions as point data belonging to the scanning area is produced for each area. The tree related to each of the scanning areas is also used for exact match query described above.

Programs in the working planning as described above are normally incorporated in software used by a laser working machine, but the calculation load is large and could adversely affect the operation of the working machine which cannot afford a high speed processing computer for calculation. Meanwhile, in order to use up-to-date programs, they must always be upgraded which may impose some costs on users. This also applies to the case of extracting a program for working planning and providing a single kind of software. Note that the working position data could be mailed from the user using a storage medium such as a flexible disc, and a working plan can be produced based on the data at the manufacturer's support center and sent back by mail. The exchange by mail takes too long a time period.

An embodiment directed to a solution to this problem will be now described in detail.

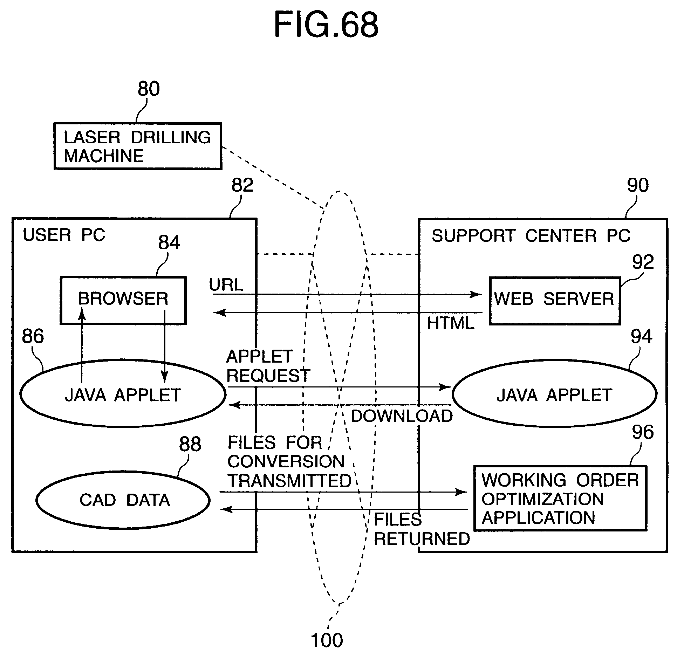

According to the embodiment, as shown in Fig. 68, the user's personal computer (hereinafter simply as "user PC") 82 provided on the side of a laser working machine 80, and a PC 90 capable of high speed processing provided at the laser working machine manufacturer's support center (referred to as "support center PC") for working planning only are connected through the Internet 100. Based on working position data received from the user PC 82 through the Internet 100, the support center PC 90 determines working plans, and the determined plans are returned to the user PC 82 through the Internet 100.

Referring to Fig. 68, a browser 84 connects the user PC 82 to the Internet 100, and a web server 92 provides a home page on the Internet 100. Reference numerals 86 and 94 represent JAVA® applet, 88 CAD data for working positions, and 96 a working order optimization application used to determine working plans for the CAD data 88 transmitted from the user PC 82.

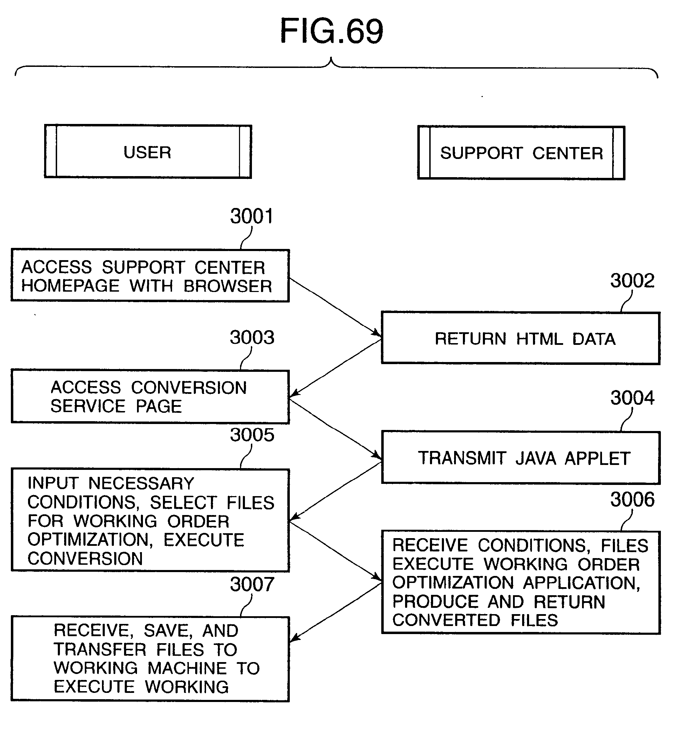

The function will be now described in conjunction with Fig. 69.

In step 3001, the user uses the browser 84 in the user PC 82 to access the homepage provided by the support center, and in step 3003, further accesses a conversion service page using HTML data returned from the support center in step 3002. Then, in response to a JAVA® applet instruction transmitted in step 3004, necessary conditions for conversion are input in step 3005, files whose working order is to be optimized are selected and transmitted to the support center PC 90 through the Internet 100.

On the support center side, in step 3006, the order of working data is optimally converted by the working order optimization application 96 based on the received data, and data files for the machine is produced. The files are returned again through the Internet 100.

In step 3007, the user transfers the received, converted data files to the laser working machine, and executes working.

Thus, the conversion is executed on the support center side, and therefore the user can always use the up-to-date version of working plans, and use the high speed processing computers provided at the support center.

Meanwhile, on the support center side, the working planning programs for the machine handed to the user do not have to be frequently updated, in other words, the programs can readily be updated. In addition, the user information can easily be collected/stored.

Although only a limited number of the embodiments of the present invention have been described, it should be understood that the present invention is not limited thereto, and various modifications and variations can be made without departing from the sprit and scope of the invention defined in the accompanying claims.

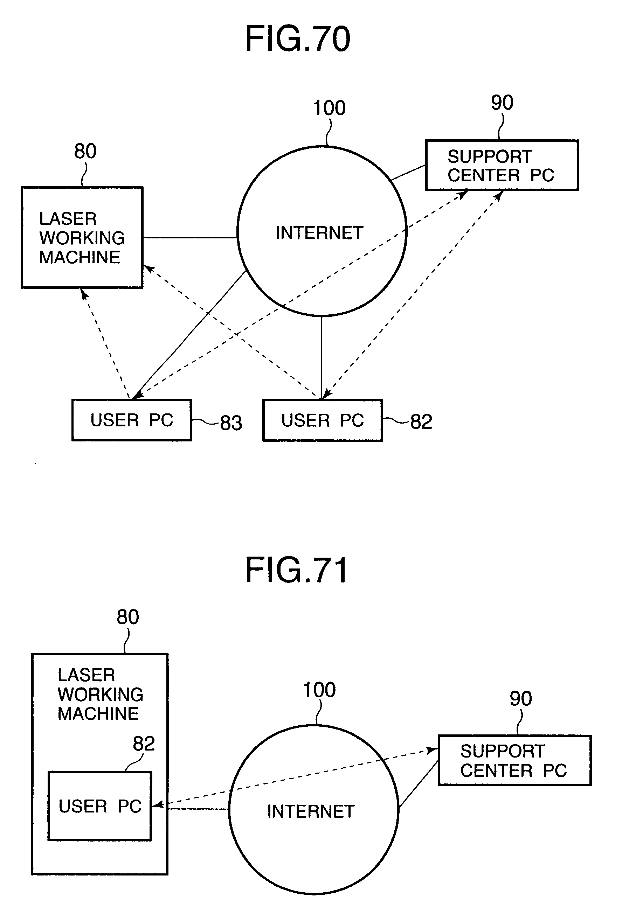

More specifically, according to the embodiment, the user PC is supposed to be a single machine, separately provided from the laser working machine 80, while the number of user PCs or the placement positions thereof are not limited to those. As in a first variation shown in Fig. 70, a user PC 83 for CAD can be separately provided or as in a second variation shown in Fig. 71, the user PC 82 can be stored in the laser working machine 80.

In the foregoing, the number of galvano units is two, while the number of galvano units is not limited to this, and may be one, three or more.

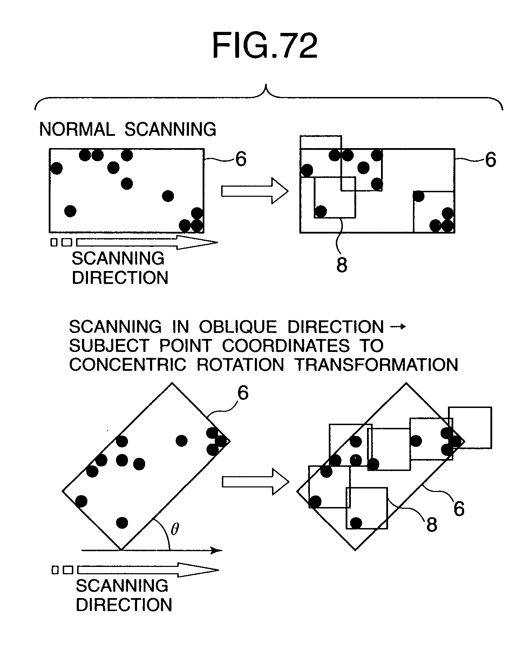

In the foregoing, the areas each have a regular square shape of 40 mm × 40 mm, while the shape is not limited to this, and the areas may be a regular square, an oblong rectangle or a circle of a different size. The scanning direction is not limited to the typical scanning direction parallel to one side of the area as shown in the upper part in Fig. 72, but scanning may be performed in an oblique direction obtained by concentrically rotating the point coordinates as shown in the lower part in Fig 72.

In addition, the means for scanning scanning areas with a laser beam is not limited to the device with a galvano scanner, and may be a hybrid working system (so-called "screen cut system" or "flush cut system") including a combination of a linear monitor XY stage and a high speed working head as suggested by the applicant in Japanese Patent Laid-Open Nos. 2000-71089, and 2000-334637.

The invention is by all means applicable to general working machines (such as a drilling machine with a mechanical drill) using working means other than those with a laser beam such as the laser drilling machine described above.

The communication line is not limited to the Internet but a private line or a telephone line may be used.

**Claims**

1. A method of working planning in allocating a plurality of working positions scattered on a workpiece to a plurality of working areas to be simultaneously worked, said method comprising the steps of:

   determining an optimal working path for working positions in each working area; and
   subsequently determining order of working at the working positions in each working area so that the total working time is minimized in the working areas to be simultaneously worked.

2. A method of working planning in determining order of working at a plurality of working areas scattered on a workpiece, said method comprising the step of:

   shifting an start point of a working path in each of the plurality of simultaneous working areas so that time for scanning or moving simultaneously performed can be equal, thereby shortening a total working time.

3. A working planning method in determining order of working by applying a traveling salesman problem to a plurality of working positions scattered on a workpiece or working areas set in a workpiece, said method comprising the steps of:

   solving the traveling salesman problem, thereby minimizing a length of a tour; and
   subsequently detecting a longest movement, and determining start and end points so that the longest movement is removed.

4. A working planning method in determining order of working by applying a traveling salesman problem to a plurality of working positions scattered on a workpiece or working areas set in a workpiece, said method comprising the steps of:

   solving a traveling salesman problem to minimize a value produced by removing a longest movement from a tour, thereby obtaining a new tour, and
   eventually removing the longest movement, and determining start and end points.

5. A working planning method in determining placement of working areas to be worked by working means based on working positions scattered on a workpiece, said method comprising the steps of:

   provisionally setting a next working area so as to enclose an end point in a first direction not yet enclosed by the working area;
   moving said provisionally set working area in a second direction different from said first direction to enclose an end point in the second direction;
   again moving said moved working area in the first direction so as to enclose the end point in said first direction in positions after the movement; and
   again moving the re-moved working area in the second direction so as to enclose the end point in said second direction in positions after the re-movement, wherein
   said steps of moving are repeated to define the next working area.

6. The working planning method according to claim 5, wherein said working area has a square frame orthogonal to said first and second directions.

7. The working planning method according to claim 5 or 6, wherein said first and second directions are set to correspond to the moving direction of a workpiece.

8. A method of working planning in determining placement of working areas to be worked by working means based on working positions scattered on a workpiece, said method comprising the steps of:

   simply dividing an entire surface of the workpiece into the working areas; and
   subsequently removing all the working areas without any working position.

9. A working planning method in determining placement of working areas to be worked by working means based on working positions scattered on a workpiece, said method comprising the step of:

repeating the step of placing a working area in a position with a largest number of working positions not yet enclosed until all the working positions are enclosed.

10. A working planning method, in determining placement of working areas to be worked by working means based on working positions scattered on a workpiece, said method comprising the steps of:

provisionally determining area placement; and
subsequently shifting a working area to a neighborhood and
removing an unnecessary working area.

11. The working planning method according to claim 10, wherein said area placement is provisionally determined by the method according to claim 5.

12. The working planning method according to claim 10, wherein said area placement is provisionally determined by the method according to claim 8.

13. The working planning method according to claim 10, wherein said area placement is provisionally determined by the method according to claim 9.

14. The working planning method according to claim 10, wherein said working area is shifted to a neighborhood and an unnecessary neighboring area is removed, provided that a point independently belonging to said working area stays within the area.

15. The working planning method according to claim 10, wherein among said working areas, at least two areas joined at an overlapping location are each shifted to a neighborhood and an unnecessary neighboring area is removed, provided that a point independently belonging to said at least two areas stays within said working areas.

16. A working planning method in determining placement of working areas to be worked by working means based on working positions scattered on a workpiece, said method comprising,
when the same working position belongs to a plurality of areas, determining said areas to be worked so that number of working positions belonging to each of a plurality of simultaneous working areas is equal.

17. The working planning method according to claim 16, wherein

some of the working positions belonging to said plurality of areas are allocated to an area having a greater difference among a plurality of simultaneous working areas, some of the remaining working positions are allocated to a area having a smaller difference, and
eventually remaining working positions are distributed equally among both areas.

18. A working planning method in determining placement of working areas to be worked by working means based on working positions scattered on a workpiece, said method comprising the step of:

adjusting an area position so that working positions are gathered to center of each working areas.

19. The working planning method according to claim 18, wherein area position is adjusted so that center of an extent of said working positions matches center of the working area.

20. The working planning method according to claim 18, wherein area position is set as near as center of gravity of the working positions, provided that the working positions are within the working area.

21. A working planning method in working a workpiece placed on a stage, said stage being movable in a plurality of directions, said method comprising the step of:

determining a moving path for said stage by solving a traveling salesman problem with fixed edge points in which a position to load the workpiece to the stage from a loader is set as a start point of the moving path for said stage,
a position before moving the workpiece to an unloader is set as an end point.

**22.** A working planning method in simultaneously working a workpiece placed on a movable stage by a plurality of working units capable of scanning or moving working means within a working area, said method comprising the step of:

determining an interval between the working units so that number of scanning or moving the working means or number of moving the stage is minimized.

**23.** The working planning method according to claim 22, wherein the number of scanning or moving said working means and the number of moving the stage are weighted depending on difference in scanning or moving time.

**24.** The working planning method according to claim 22 or 25, further comprising the steps of:

setting the interval of said working units;
overlapping scanning or moving ranges of the working units at that time, thereby obtaining area placement to minimize number of working areas; and
calculating the number of scanning or moving of the working means and the number of moving the stage at the time.

**25.** A working planning method, comprising the steps of:

performing the process according to claim 22 in a different workpiece direction; and
automatically employing the workpiece direction which minimizes the number of scanning or moving the working means or the number of moving the stage.

**26.** A working planning method in working a workpiece using working means capable of scanning or moving in a plurality of directions, wherein point position data representing working positions or working areas scattered on the workpiece is expressed in a tree type data structure.

**27.** The working planning method according to claim 26, wherein said tree is a k-dimensional binary search tree.

**28.** The working planning method according to claim 26 or 27, wherein said tree is used to list point data in each working area after the position of working areas scattered on the workpiece is determined.

**29.** The working planning method according to claim 26, wherein from a root node of said tree, for internal nodes, whether or not to search a child node of a node is judged based on the degree of overlapping between a region corresponding to the child node of the node and a search region, and only when a leaf node is reached, the point data is directly accessed.

**30.** The working planning method according to claim 26 or 27, wherein process of searching nearest neighbor point to a point of interest is conducted using said tree.

**31.** The working planning method according to claim 30, wherein said process of searching the nearest neighbor point is started from a root node of said tree.

**32.** The working planning method according to claim 31, wherein a node is searched when a circle centered on the point of interest and having a radius as long as distance to present nearest neighbor point overlaps a region corresponding to the node.

**33.** The working planning method according to claim 32, wherein if said node is a leaf node, distances to all the points corresponding to the node in the region are obtained, and it is judged whether each distance is short.

**34.** The working planning method according to claim 30, wherein each point data piece has information related to a leaf node to which said data piece belongs, said process of searching the nearest neighbor point is performed by directly accessing the leaf node having the point of interest whose nearest neighborhood is searched, and then the search is performed in a direction toward the root node of said tree, only if there is a node to be searched.

**35.** The working planning method according to claim 34, wherein
if a circle centered on the point of interest and having a radius as long as distance to present nearest neighbor point and a region corresponding to a node are outside a region corresponding to the present node, a brother node thereof or a brother node of a parent node thereof is searched depending on a degree of how much outside they are.

**36.** The working planning method according to claim 30, wherein said process of searching said nearest neighbor point and process of searching next nearest neighbor point, using a tree removed of a found nearest neighbor point are repeated, so that neighbor points are listed in order of their nearness to the point of interest.

**37.** The method of working planning according to claim 30, wherein process of searching the nearest neighbor point not yet connected to a working path by said process of searching the nearest neighbor point and connecting a new found point of interest to the working path, and process of searching next nearest neighbor point using the tree removed of the found point of interest and connecting a next new found point of interest to the working path are repeated from a start point to an end point to produce the working path.

**38.** The working planning method according to claim 36 or 37, wherein the process of removing a found point from said tree is performed by reducing ending number of an index attached to each point data or by increasing starting number.

**39.** The working planning method according to claim 38, wherein
if a found point is removed from said tree, and all point data in a node disappears, the node is attached with information indicating that it is not necessary to visit the node.

**40.** A working planning method, wherein a working path determined by a working planning method according to any one of claims 37 to 39 is set as an initial solution in determining order of working by applying a traveling salesman problem.

**41.** A working planning method, wherein
an unnecessary, high load operation is removed by finding a set of areas in which placement of point data in one of the working areas and placement of point data in another working area are relatively matched.

**42.** The working planning method according to claim 41, wherein said process of searching a set of areas having relatively matched point data placements is performed by the steps of:

producing point position data by adding a prescribed coordinate shift to all the points in one area;
visiting one node after another corresponding to a region having said point position data from a root node of a tree in the other area; and
checking whether or not there is point position data matched with said point position data only when a leaf node is reached.

**43.** The working planning method according to claim 26 or 27, wherein
in the process of enclosing point data in the working area with the minimum number of equal size rectangles, every time a provisional working area is produced by calling a loop, said tree is built both for the provisional working area and provisional point position data in each working area.

**44.** The working planning method according to claim 26 or 27, wherein said tree is built both for the working area and point position data in each working area when the working area is defined.

**45.** A working method performing working determined by the working planning method according to any one of claims 1 to 44.

**46.** A computer program for implementing the working planning method according to any one of claims 1 to 44.

**47.** A working planning device for allocating a plurality of working positions scattered on a workpiece to a plurality of working areas to be simultaneously worked, said device comprising:

working path determining means for determining an optimal working path for working positions in each working area; and

working order determining means for determining order of working in the working positions in each working area so that the total working time in the working areas to be simultaneously worked is minimized.

48. A working planning device for planning working in determining order of working in a plurality of working areas scattered on a workpiece, comprising,
working order shift means for shifting a start point of a working path for each of the plurality of simultaneous working areas so that time for scanning or moving performed simultaneously can be equal among the simultaneous working areas, and shortening the total working time.

49. A working planning device for planning working in determining order of working by applying a traveling salesman problem to a plurality of working positions scattered on a workpiece or working areas set in the workpiece, comprising,
scanning path determining means for detecting a longest movement after minimizing a round path by solving the traveling salesman problem, and determining start and end points so that the longest movement is removed.

50. A working planning device for planning working in determining order of working by applying a traveling salesman problem to a plurality of working positions scattered on a workpiece or working areas set in the workpiece, comprising,
scanning path determining means for solving a traveling salesman problem improved to minimize a value produced by removing longest movement from a tour, thereby obtaining tour, and eventually removing the longest movement to determine start and end points.

51. A working planning device for planning working in determining placement of working areas to be worked by working means based on working positions scattered on a workpiece, said device comprising,
area placement determining means for repeating a process for defining a next working area,
said process including provisionally setting the next working area so as to enclose an end point in a first direction not yet enclosed by the working area; moving the provisionally set working area in a second direction different from the first direction so that the area encloses an end point in the second direction; again moving said moved working area in the first direction so that the area encloses the end point in said first direction, and again moving said re-moved working area in said second direction so that the area encloses the end point in said second direction in a position after the re-movement.

52. A working planning device for planning working in determining placement of working areas to be worked by working means based on working positions scattered on a workpiece, comprising,
area placement determining means for simply dividing an entire surface of a workpiece into working areas, and removing all the working areas having no working position.

53. A working planning device for planning working in determining placement of working areas to be worked by working means based on working positions scattered on a workpiece, comprising,
area placement determining means for repeating a process of placing a working area in a position having the largest number of working positions not yet enclosed until all the working positions are enclosed.

54. A working planning device for planning working in determining placement of working areas to be worked by working means based on working positions scattered on a workpiece, comprising,
area placement determining means for provisionally determining area placement, shifting a working area to a neighborhood, and removing an unnecessary working area.

55. A working planning device for planning working in determining placement of working areas to be worked by working means based on working positions scattered on a workpiece, comprising,
belonging area determining means for determining a working area, when same working positions belong to a plurality of working areas, said means determining the areas so that number of working positions belonging to each of the plurality of simultaneous working areas is equal.

56. A working planning device for working planning in determining placement of working areas to be worked by working means based on working positions scattered on a workpiece, comprising,
area placement adjusting means for adjusting area positions so that working positions are gathered around the center of each working area.

**57.** A working planning device for planning working in working a workpiece placed on a stage movable in a plurality of directions, comprising, moving path determining means for determining a moving path for said stage by solving a traveling salesman problem with fixed edge points wherein a position to load a workpiece to the stage from a loader being set as an start point of the moving path for said stage, a position before transferring the workplace to an unloader being set as an end point.

**58.** A working planning device for planning working in working a workpiece placed on a movable stage simultaneously using a plurality of working units capable of scanning working means in a working area, comprising, unit interval determining means for determining an interval of the working units so that number of scanning or moving the working means or number of moving the stage is minimized.

**59.** The working planning device according to claim 58, further comprising, workpiece direction determining means for performing the processing by said unit interval determining means in a different workpiece direction, and automatically employing a workpiece direction allowing the number of scanning or moving the working means or the number of moving the stage to be minimized.

**60.** A working planning device for planning working in working a workpiece using working means capable of scanning or moving in a plurality of directions, comprising:

means for storing point position data on points representing working positions or working areas scattered on the workpiece, said data being expressed in a tree type data structure; and
means for determining working area positions and/or order of working using the position data expressed in said tree type data structure.

**61.** A working device comprising the working planning device according to any one of claims 47 to 60.

**62.** A computer program for implementing the working planning device according to any one of claims 47 to 60.

**63.** A working data producing method, comprising the steps of:

determining a working plan based on working position data received from a working device side through a communication line; and
returning the plan to said working device side.

**64.** The working data producing method according to claim 63, wherein said working plan is determined by the method according to any one of claims 1 to 44.

**65.** A computer program for implementing the working data producing method according to claim 63 or 64.

**66.** A working data producing device, comprising:

means for receiving working position data from a working device side through a communication line;
planning means for determining a working plan based on the received working position data; and
transmission means for transmitting the determined working plan back to said working device side.

**67.** The working data producing device according to claim 66, wherein said working plan is determined by the method according to any one of claims 1 to 44.

**68.** A computer program for implementing the working data producing device according to claim 66 or 67.

**69.** A computer readable recording medium recorded with the computer program according to any one of claims 46, 62, 65 and 68.

# FIG.1

# FIG.2

# FIG.3

XY STAGE MOVEMENT

LEFT UNIT SCANNING RANGE

RIGHT UNIT SCANNING RANGE

TIME

WORKING IN SCANNING AREA (BEAM SCANNING + LASER IRRADIATION)

# FIG.4

LASER IRRADIATION

TIME

BEAM SCANNING

RIGHT UNIT, 1ST SCANNER

RIGHT UNIT, 2ND SCANNER

LEFT UNIT, 1ST SCANNER

LEFT UNIT, 2ND SCANNER

LASER IRRADIATION

RIGHT UNIT STAND-BY TIME

LEFT UNIT STAND-BY TIME

# FIG.5

WINDOW ON PC ~52

CAD DATA 50

PLANNING START INSTRUCTION

PLANNING END SIGNAL

INPUT DATA

WORKING START INSTRUCTION

WORKING END SIGNAL

WORKING STATE

FLEXIBLE DISC OR NETWORK

60

PLANNING DEVICE

DATA

LASER DRILLING MACHINE

CONTROL DEVICE ~62

DATA

OSCILLATION END SIGNAL

OSCILLATION INSTRUCTION

LEFT AND RIGHT UNITS INTERVAL DATA

LASER OSCILLATOR ~12

DRIVING INSTRUCTION

28L, 28R, 32L, 32R

SCANNING AREA POSITION DATA

MOVEMENT END SIGNAL

GALVANO SCANNER

WITHIN AREA

DRIVING INSTRUCTION

AREA VISITING ORDER DATA

PERFORATION POSITION DATA

MOVEMENT END SIGNAL

XY STAGE ~40

PERFORATION POSITION VISITING ORDER DATA

DRIVING INSTRUCTION

MOVEMENT END SIGNAL

GALVANO RIGHT UNIT

22R

EP 1 211 583 A2

# FIG.6

M 25            ← PATTERN START SIGNAL

X · · · , Y · · ·

⋮                } PERFORATION POSITION DATA FOR PATTERN A1

X · · · , Y · · ·

M 01           ← PATTERN END SIGNAL

M 02 X · · · , Y · · ·   ← SHIFT AMOUNT FROM PATTERN A1 TO A2

M 02 X · · · , Y · · ·   ← SHIFT AMOUNT FROM PATTERN A1 TO A3

⋮

# FIG.7

CAD DATA —50

60

WINDOW ON PC —52

INPUT DATA

PLANNING DEVICE

(PERFORATION POSITION DATA)

POINT DATA X-Y COORDINATE TRANSFORMATION (IN RESPONSE TO PC INPUT)

(INPUT DATA)

SET UNIT INTERVAL ┈┈▶ UNIT INTERVAL DATA A

(PERFORATION POSITION DATA)

(PERFORATION POSITION DATA)

UNIT INTERVAL

XY STAGE MOVEMENT PATH DATA

(SCANNING AREA POSITION DATA B, SCANNING AREA VISITING ORDER DATA C, PERFORATION POSITION DATA D IN EACH AREA)

SET STAGE PATH ┈┈▶

AREA POSITION DATA PERFORATION POSITION DATA

SET GALVANO PATH

GALVANO WORKING PATH DATA WITHIN SCANNING AREA

(PERFORATION POSITION VISITING ORDER DATA E)

PLANNING END SIGNAL

CONTROL DEVICE —62

EP 1 211 583 A2

# FIG.8

40

40

6

8L
②
①

②
①

8R

Y

X

LEFT UNIT SCANNING RANGE

RIGHT UNIT SCANNING RANGE

# FIG.9

6

Y

UNIAXIAL SORT

40mm

4mm

O PERFORATION POSITION POINT

INTERVAL OF 4mm

X

SCANNING AREA (40mm×40mm)

# FIG.10

50 CAD DATA

52 WINDOW ON PC

SELECT

PERFORATION POSITION DATA

INPUT DATA

70 PLANNING DEVICE

72 2-UNIT AREA PLACEMENT PLANNING DEVICE

DIVING AXIS UNIT INTERVAL

OPTIMIZATION LOOP

AREA NUMBER BEAM SCANNING NUMBER

AREA PLACEMENT PLANNING DEVICE — 74

UNIT INTERVAL A

SCANNING AREA POSITION DATA B

EACH AREA PERFORATION POSITION DATA D

AREA POSITION DATA B
PERFORATION POSITION DATA D

76 STAGE / GALVANO PATH PLANNING DEVICE

SCANNING AREA POSITION VISITING ORDER DATA C

PERFORATION POSITION VISITING ORDER DATA E

EP 1 211 583 A2

# FIG.11

72

Y=F(X) MINIMIZATION

SUBSTITUTION X WITH UNIT INTERVAL

RETURN G+β×S AS Y

$\left.\begin{array}{l} G\cdots \text{BEAM SCANNING NUMBER}\\ \quad (4{\sim}5 \text{ DIGITS})\\ S\cdots \text{STAGE MOVEMENT NUMBER}\\ \quad (2{\sim}3 \text{ DIGITS})\\ \beta\cdots \text{WEIGHT} (100{\sim}400) \end{array}\right\}$

X | Y MINIMIZING LOOP | Y

SUPERPOSE LEFT AND RIGHT REGIONS ON EACH OTHER

↓

ALGORITHM TO ENCLOSE POINT POSITIONS IN REGION WITH MINIMUM NUMBER OF REGULAR SQUARES

⟹ · UNIT INTERVAL A DETERMINED
· ROUGH POSITIONS OF AREAS DETERMINED

74

| OVERLAP DISTRIBUTION | + | FINE ADJUSTMENT |

⟹ · AREA POSITION DEFINED B
· BELONGING AREA OF PERFORATION POSITIONS IS DETERMINED D

| TSP (TOUR) | + | EDGE POINT | OR | VARIANT OF TSP (TOUR - LONGEST MOVEMENT) |

⟹ AREA VISITING ORDER DEFINED C

| TSP | + | MATCHING (SHIFT) | + | EDGE POINT |

OR | VARIANT OF TSP | + | MATCHING |

⟹ PERFORATION POSITION VISITING ORDER DEFINED E

76

# FIG.12

INPUT COORDINATE VALUE OF PERFORATION POINT POSITION ~101

SET UNIT INTERVAL A TO MINIMUM VALUE ~102

SUPERPOSE OPERATION REGIONS OF 2 UNITS TO REGISTER THEIR LEFT SIDES ~103

CALCULATE AREA NUMBER WITH AREA PLACEMENT PLANNING DEVICE ~104

SET UNIT INTERVAL A TO MAXIMUM VALUE ~105

SUPERPOSE OPERATION REGIONS OF 2 UNITS TO REGISTER THEIR LEFT SIDES ~106

CALCULATE AREA NUMBER WITH AREA PLACEMENT PLANNING DEVICE ~107

RE-SET UNIT INTERVAL A TO SUITABLE VALUE ~108

SUPERPOSE OPERATION REGIONS OF 2 UNITS TO REGISTER THEIR LEFT SIDES ~109

CALCULATE AREA NUMBER WITH AREA PLACEMENT PLANNING DEVICE ~110

LOOP ENDS? ~111  NO  YES

X-Y COORDINATE TRANSFORMATION OF POINT DATA ~112

AGAIN EXECUTE PROCESSING IN BROKEN LINE PART ~113

POSITION WITH MINIMUM AREA NUMBER DEFINED
(IF X-AXIS DIVIDED, ANOTHER COORDINATE TRANSFORMATION) ~114

AREA LABELS DEFINED FOR ALL PERFORATION POINTS ~115

FINE-ADJUSTMENT TO AREA POSITION ~116

END

# FIG.13

REGION OF ENTIRE BOARD

TEMPORARY REGION

UNIT INTERVAL

AREA PLACEMENT ON ORIGINAL BOARD

AREA PLACEMENT WITH MINIMUM AREA NUMBER

# FIG.14

BEAM SCANNING NUMBER G

OPTIMAL UNIT INTERVAL
$$\left(\begin{array}{l}\text{SOLID \& BROKEN LINES}\\\text{BOTH AT MINIMUM}\end{array}\right)$$

STAGE MOVING NUMBER S

UNIT INTERVAL A

# FIG.15

6

● PERFORATION POSITION

# FIG.16

AXIS TO BE DIVIDED WITH DIVIDING LINE→ TRY BOTH AXES

6

AREA NUMBER,
UNIT INTERVAL OPTIMIZATION
→ AREA NUMBER, BEAM SCANNING
NUMBER COUNT

⇩ POINT DATA X-Y COORDINATE
TRANSFORMATION

6

AREA NUMBER,
UNIT INTERVAL OPTIMIZATION
→ AREA NUMBER, BEAM SCANNING
NUMBER COUNT

SELECT OPTIMAL ONE

# FIG.17

AREA F1

AREA G1

W₁ (OVERLAP REGION)
AREA F1? G1?

(LEFT UNIT)

AREA G2

AREA F2

W₂ (OVERLAP REGION)
AREA F2? G2?

(RIGHT UNIT)

# FIG.18

| CONDITIONS | LEFT UNIT | | | RIGHT UNIT | | |

ONLY F1 30 HOLES | OVERLAP 60 HOLES | ONLY G1 20 HOLES | ONLY F2 10 HOLES | OVERLAP 50 HOLES | ONLY G2 40 HOLES

CONVENTIONAL | LEFT UNIT | RIGHT UNIT

90 HOLES TO F1 | 20 HOLES TO G1 | 60 HOLES TO F2 | 40 HOLES TO G2

CONVENTIONAL→DISTRIBUTE TO AREAS DETERMINED EARLIER

GALVANO SHOT NUMBER FOR F : 90,
GALVANO SHOT NUMBER FOR G : 40 (130 IN TOTAL)

INVENTION | LEFT UNIT | RIGHT UNIT | 20LESS

55 HOLES TO F1 | 55 HOLES TO G1 | 55 HOLES TO F2 | 45 HOLES TO G2

PRESENT INVENTION
→ EQUAL HOLE NUMBER AMONG SIMULTANEOUS WORKING AREAS

GALVANO SHOT NUMBER FOR F : 55, GALVANO SHOT NUMBER
FOR G : 55, (110 IN TOTAL)

# FIG.19

```
        ( OVERLAP  DISTRIBUTION )
                    |
                    v
   ┌──────────────────────────────────┐
   │ CALCULATE  f(1),  f(2),  g(1),  g(2), AND │ ~201
   │ ABSOLUTE  VALUES  THEREOF         │
   └──────────────────────────────────┘
                    |
                    v
   ┌──────────────────────────────────┐
   │ SUPPLEMENT  HOLES  FROM  OVERLAP  │
   │ PART  TO  AREA  WITH  LESS  HOLES │ ~202
   │ WITH  LARGER  ABSOLUTE  VALUE     │
   └──────────────────────────────────┘
                    |
                    v
   ┌──────────────────────────────────┐
   │ SUPPLEMENT  HOLES  FROM  OVERLAP  │
   │ PART  TO  AREA  WITH  LESS  HOLES │ ~203
   │ WITH  SMALLER  ABSOLUTE  VALUE    │
   └──────────────────────────────────┘
                    |
                    v
   ┌──────────────────────────────────┐
   │ DISTRIBUTE  HOLES  REMAINING  AT  │
   │ OVERLAP   PART  EQUALLY  AMONG    │ ~204
   │ LEFT  AND  RIGHT  AREAS           │
   └──────────────────────────────────┘
                    |
                    v
             (      END      )
```

# FIG.20

LEFT AREA

| f(1) | w(1) | g(1) |
|---|---|---|
| f(2) | w(2) | g(2) |

RIGHT AREA

A : SUPPLEMENT TO AREA WITH LARGER DIFFERENCE

B : SUPPLEMENT TO AREA WITH SMALLER DIFFERENCE

C : DISTRIBUTE REMAINING HOLES EQUALLY

| 100 | 120 | 200 | A | 100 | 120 | 200 | B | 150 | 70 | 200 | C | 185 | 0 | 235 |
|---|---|---|---|---|---|---|---|---|---|---|---|---|---|---|
| 150 | 60 | 30 | | 150 | 0 | 90 | | 150 | 0 | 90 | | 150 | 0 | 90 |

| 50 | 20 | 100 | A | 50 | 20 | 100 | B | 50 | 20 | 100 | C | 60 | 0 | 110 |
|---|---|---|---|---|---|---|---|---|---|---|---|---|---|---|
| 10 | 140 | 20 | | 10 | 60 | 100 | | 50 | 20 | 100 | | 60 | 0 | 110 |

# FIG.21

EP 1 211 583 A2

# FIG.22

EXTENT OF ACTUAL
PERFORATION POSITION

8

8'

CENTER
OF AREA

CENTER
OF AREA

# FIG.23

○ PERFORATION
POSITION

8 (ORIGINAL AREA)

8' (AREA AFTER CORRECTION)

P

P

CENTER OF
GRAVITY OF Y-AXIS

CENTER OF
GRAVITY
OF Y-AXIS

AREA CENTERED
ON CENTER OF
GRAVITY

CENTER

CENTER OF
GRAVITY
OF X-AXIS

CENTER

CENTER OF
GRAVITY
OF X-AXIS

46

# FIG.24

SUBSTITUTE FOR 2-UNIT PLACEMENT PLANNING DEVICE

INPUT COORDINATE VALUE OF PERFORATION POINT POSITION ~101

SET UNIT INTERVAL TO DISTANCE FROM END OF BOARD TO POSITION RIGHT-SHIFTED FROM A POSITION CORRESPONDING TO HALF WIDTH OF BOARD TO POSITION WITH POINT /302

SUPERPOSE OPERATION REGIONS OF 2 UNITS TO REGISTER THEIR LEFT SIDES /303

CALCULATE AREA NUMBER WITH AREA PLACEMENT PLANNING DEVICE /304

EXECUTE PROCESSING IN SOLID LINE FRAME TO ALL SHIFT AMOUNTS OF PATTERN BETWEEN MINIMUM AND MAXIMUM VALUES OF UNIT INTERVAL /305

X-Y COORDINATE TRANSFORMATION OF POINT DATA /112

AGAIN EXECUTE PROCESSING IN BROKEN LINE FRAME /113

DEFINE POSITION WITH MINIMUM AREA NUMBER (IF X-AXIS DIVIDED, ANOTHER COORDINATE TRANSFORMATION) /114

UNIT INTERVAL, AREA POSITION, AREA LABELS FOR ALL PERFORATION POINTS DEFINED /115

FINE-ADJUSTMENT TO AREA POSITION /116

END

# FIG.25

PATTERN A
PATTERN B
PATTERN C

① HALVING 280mm
② SHIFT 260mm
③ SHIFT 240mm
④ SHIFT 120mm

260mm
120mm
240mm
300mm
100mm

HORIZONTAL SIZE OF BOARD 560mm

## FIG.26

```
┌─────────────────────────────┐  18/54
( INPUT COORDINATE            )──── 401
( VALUE OF PERFORATION        )
( POINT POSITION              )
└─────────────────────────────┘
              │
              ▼
┌─────────────────────────────┐
│ SORT ACCORDING TO           │──── 402
│ X-COORDINATE VALUE          │
└─────────────────────────────┘
              │
```

FIRST LOOP

```
┌─────────────────────────────┐
│ SEARCH POINT WHOSE          │
│ COVERING AREA IS YET TO BE  │──── 403
│ DEFINED IN SORTED ORDER     │
└─────────────────────────────┘
              │
              ▼
        ◇ DISCOVERED? ◇ ──── 404 ── NO ──▶ ( END ) ──── 405
              │ YES
              ▼
```

SECOND LOOP

```
┌─────────────────────────────┐
│ SET COORDINATES (X, Y) OF   │──── 405
│ FOUND POINT AS POINT OF     │
│ INTEREST. FOR ONE SIDE      │
│ LENGTH OF AREA D,           │
│ ENCLOSING AREA IS REGULAR   │
│ SQUARE WITH FOUR CORNERS    │
│ : (X, Y), (X+D, Y), (X+D, Y),│
│ (X+D, X+D)                  │
└─────────────────────────────┘
              │
              ▼
┌─────────────────────────────┐
│ ⟨AREA POSITION UPDATING ①⟩  │──── 406
│ SEARCH POINT POSITION WITH  │
│ MINIMUM Y-COORDINATE IN     │
│ POSITION UNDER PRESENT      │
│ AREA. IF FOUND POINT        │
│ POSITION AREA HAS LARGE     │
│ OVERLAP WITH AREA           │
│ ALREADY DEFINED, SEARCH     │
│ AGAIN FOR AREA WITH         │
│ MINIMUM Y-COORDINATE IN     │
│ LARGELY OVERLAPPING AREA    │
│ WITH NON-OVERLAPPING TOP    │
│ PORTION. IF FOUND, UPDATE   │
│ Y-COORDINATE VALUE          │
└─────────────────────────────┘
              │
              ▼
        ◇ Y-COORDINATE ◇ ──── 407 ── YES ──▶
        ◇ VALUE UPDATED? ◇
              │ NO ──── 408
              ▼
┌─────────────────────────────┐
│ REGULAR SQUARE HAVING       │
│ PRESENT (X, Y) AT LOWER     │
│ LEFT CORNER THEREOF AND     │
│ ONE SIDE OF LENGTH D IS     │
│ NEW AREA. POINTS IN THIS    │
│ AREA ARE ENCLOSED           │
└─────────────────────────────┘
```

```
┌─────────────────────────────┐
│ ⟨AREA POSITION UPDATING ②⟩  │──── 409
│ UPDATE X-COORDINATE VALUE   │
│ WITH MINIMUM X-COORDINATE   │
│ VALUE AMONG PRESENT AREA    │
└─────────────────────────────┘
              │
              ▼
   NO ◀── ◇ X-COORDINATE ◇ ──── 410
        ◇ VALUE UPDATED? ◇
              │ YES ──── 411
              ▼
┌─────────────────────────────┐
│ ⟨AREA POSITION UPDATING ③⟩  │
│ SEARCH POINT POSITION       │
│ WITH MINIMUM Y-COORDINATE   │
│ IN REGION BETWEEN PRESENT   │
│ POSITION AND UPPER END OF   │
│ AREA AT HIGHEST POSITION    │
│ AMONG ALREADY DEFINED       │
│ AREAS UNDER AREA AT         │
│ PRESENT POSITION. IF FOUND, │
│ UPDATE Y-COORDINATE VALUE   │
└─────────────────────────────┘
              │
              ▼
   NO ◀── ◇ Y-COORDINATE ◇ ──── 412
        ◇ VALUE UPDATED? ◇
              │ YES
```

# FIG.27

# FIG.28

ALL POINTS ENCLOSED

# FIG.29

P₁

E₅

P₂

# FIG.30

e (REGION WITH NON-OVERLAPPING TOP PORTION)

EXPECTED DOWNWARD
UPDATED AREA POSITION

(X, Y')

Y'

DEFINED AREA    OVERLAPPING
LOCATION

# FIG.31

# FIG.32

FIXED WIDTH

AREA IGNORED

Y

B2

UPPER SIDE OF
DEFINED AREA

Y'

DEFINED AREAS

# FIG.33

# FIG.34A

CONVENTIONAL AREA

6

8

# FIG.34B

REMOVE AREAS
WITHOUT POINT

6

8

NOT ALL POSITIONS
HAVE POINTS

AREA NUMBER
DECREASES BY 2

# FIG.34C

6

8

EP 1 211 583 A2

# FIG.35

```
   ╭──────────────────────╮
   │  VARIATION  OF  AREA  │
   │  DETERMINING  METHOD  │
   ╰──────────────────────╯
              │
              ▼
   ┌──────────────────────────┐
   │ INITIAL SOLUTION x GENERATED │──501
   └──────────────────────────┘
              │
              ▼
   ┌──────────────────────────┐
   │   SUBSTITUTE  y  WITH  x  │──502
   └──────────────────────────┘
              │
              ▼
   ┌──────────────────────────┐
   │ SEARCH  IN  NEIGHBORHOOD │──503
   │  N(y)  FOR  SOLUTION  y   │
   └──────────────────────────┘
              │
              ▼
        504
        ◇ SOLUTION z
          BETTER THAN y      NO
          DISCOVERED? ─────────────┐
              │ YES                 │
        505   ▼            506      ▼
   ┌──────────────────┐   ┌────────────────────┐
   │ SUBSTITUTE y WITH z │  │  SET  y  AS SOLUTION │
   └──────────────────┘   └────────────────────┘
                                    │
                                    ▼
                              ╭───────────╮
                              │    END    │
                              ╰───────────╯
```

# FIG.36

Ei (AREA OF INTEREST)

Ej (NEIGHBOR AREA)

AREA NEIGHBORHOOD _1 ⋯
REGION IN WHICH CERTAIN AREA CAN MOVE
WITHOUT GETTING OUT POINT INDEPENDENTLY
BELONGING TO THE AREA.

AREA NEIGHBORHOOD _1

ALL POINTS IN NEIGHBOR AREA OF AREA OF
INTEREST ARE INCLUDED IN THE AREA OF INTEREST
→ UNNECESSARY NEIGHBOR AREA REMOVED

# FIG.37

2 AREAS OF INTEREST

$E_i$

$E_{i+1}$

$E_k$

$E_j$

NEIGHBOR AREA

AREA NEIGHBORHOOD _2 ··· REGION IN WHICH 2 AREAS CAN MOVE WITHOUT GETTING OUT POINT INDEPENDENTLY BELONGING TO THE 2 AREAS

NEIGHBORHOOD _2 EXAMPLE

COVER THIS REGION WITH TWO AREAS

EXAMPLE OF PRESENTLY EFFECTIVE NEIGHBORHOOD _2

ALL POINTS IN NEIGHBOR AREA OF 2 AREAS OF INTEREST ARE INCLUDED IN THE 2 AREAS OF INTEREST → UNNECESSARY NEIGHBOR AREA REMOVED

# FIG.38

STAGE / GALVANO
PATH PLANNING

INPUT LOADER, UNLOADER AND
AREA POSITION COORDINATES.
SOLVE TRAVELING SALESMAN
PROBLEM WITH EDGE POINTS FIXED — 601

INPUT PERFORATION POSITION
COORDINATES IN EACH AREA FOR ALL
SCANNING AREA.
SOLVE TRAVELING SALESMAN PROBLEM — 602

MATCHING BETWEEN SIMULTANEOUSLY
WORKING AREAS — 603

START AND END POINTS DEFINED — 604

END

# FIG.39

# FIG.40

| LOADER → STAGE | WORKING STATION | UNLOADER → STAGE |
|---|---|---|

8R

8L

(TRANSFERRED ON STAGE)

6

20L 20R

VALUE A

OPTIMAL PATH WITH START AND END POINTS MATCHED

(STAGE PATH)

START POINT

END POINT

START POINT

(AREA VISITING ORDER ON BOARD)

2

1

3

# FIG.41

MOVING TIME T (msec) vs MOVING DISTANCE M (mm)

- 2ND GALVANO
- 1ST GALVANO

1msec

0.8msec

1mm    5mm

# FIG.42

TIME

BEAM SCANNING

P1(1)          P3(1)

LEFT UNIT                    P2(1)

RIGHT UNIT

P1(2)      P2(2)      P3(2)

SHIFTING

P1(1)   P2(1)

P3(1)

LEFT UNIT

RIGHT UNIT

P1(2)                    P3(2)          TIME
                                        SHORTENED
P2(2)              P4(2)

# FIG.43

CONVENTIONAL METHOD

SIMULTANEOUS WORKING

P4(1)

P5(1)

LEFT REGION SCANNING AREA | RIGHT REGION SCANNING AREA

P1(2)     P2(2)

P3(1)

P1(1)     P2(1)

P4(2)     P3(2)

LEFT REGION SCANNING AREA

P1(1)→P2(1) | P2(1)→P3(1) | P3(1)→P4(1) | P4(1)→P5(1) | P5(1)→P1(1)

RIGHT REGION SCANNING AREA

P1(2)→P2(2) | P2(2)→P3(2) | P3(2)→P4(2) | P4(2)→P1(2)

TOTAL MOVING TIME

METHOD ACCORDING TO INVENTION
(CHANGE START POINT IN RIGHT REGION TO P2(2))

LEFT REGION SCANNING AREA

P1(1)→P2(1) | P2(1)→P3(1) | P3(1)→P4(1) | P4(1)→P5(1) | P5(1)→P1(1)

TIME SHORTENED

RIGHT REGION SCANNING AREA

P2(2)→P3(2) | P3(2)→P4(2) | P4(2)→P1(2) | P1(2)→P2(2)

TOTAL MOVING TIME

# FIG.44

L MAX
$\left(\begin{array}{l}\text{BOTH ENDS}\\\text{OF LONGEST}\\\text{CITY PAIR}\end{array}\right)$

TOUR DISCOVERED BY
SOLVING TRAVELING SALESMAN
PROBLEM

END POINT

START POINT

BOTH ENDS OF LONGEST CITY PAIR
→ START AND END POINTS OF
PERFORATION POSITION

EP 1 211 583 A2

# FIG.45

```
        ╭─────────────────╮
        │ STAGE / GALVANO  │
        │ PATH  PLANNING   │
        ╰─────────────────╯
                 │
                 ▼
   ┌─────────────────────────────────┐
   │ INPUT  LOADER,  UNLOADER  AND    │
   │ AREA  POSITION  COORDINATES.     │
   │ SOLVE  TRAVELING  SALESMAN       │──── 601
   │ PROBLEM  WITH  EDGE  POINTS  FIXED│
   └─────────────────────────────────┘
                 │
                 ▼
   ┌─────────────────────────────────┐
   │ INPUT  PERFORATION  POSITION  COORDINATES │
   │ IN  EACH  AREA  FOR  ALL  SCANNING  AREAS. │
   │ SOLVE  VARIATION  OF  TRAVELING  SALESMAN  │──── 602'
   │ PROBLEM  TO  MINIMIZE            │
   │ (TOUR - LONGEST  MOVEMENT)       │
   └─────────────────────────────────┘
                 │
                 ▼
   ┌─────────────────────────────────┐
   │ MATCHING  BETWEEN  SIMULTANEOUSLY │──── 603
   │ WORKING  AREAS                   │
   └─────────────────────────────────┘
                 │
                 ▼
   ┌─────────────────────────────────┐
   │ START  AND  END  POINTS  DEFINED │──── 604
   └─────────────────────────────────┘
                 │
                 ▼
        ╭─────────────────╮
        │       END        │
        ╰─────────────────╯
```

# FIG.46

LATTICE LIKE CITY ARRANGEMENT (LATTICE INTERVAL 1)

ONE OPTIMAL PATH (DISTANCE 14)
(TOUR - LONGEST MOVEMENT) IS MINIMIZED

$<$ ⟹ PATH LENGTH INCREASES (ABOUT 14.4)

IF "TOUR LENGTH" IS
"(TOUR - LONGEST MOVEMENT) LENGTH,"
NO EXCHANGE

END POINT

START POINT

2-OPT METHOD
(TYPICAL TSP
EXAMPLE)

⟹

UPDATE IF REPLACING
TWO BRANCH SHORTENS
TOUR LENGTH
(AO, DE EXCHANGED)
WITH AE, DO

END POINT

START POINT

TOUR LENGTH : ABOUT 18.5 $>$ ⟹ TOUR LENGTH REDUCED
TO ABOUT 17.4

# FIG.47

BOARD 1

CONVENTIONAL CASE (42 AREAS)

PRESENT INVENTION APPLIED (26 AREAS)

# FIG.48

BOARD 2

77 AREAS → 70 AREAS (−9.1%)

BOARD 3

70 AREAS → 48 AREAS (−31.4%)

BOARD 4

90 AREAS → 65 AREAS (−27.8%)

BOARD 5

120 AREAS → 88 AREAS (−26.7%)

EP 1 211 583 A2

# FIG.49

|  | PERFORATION POSITION NUMBER | CONVENTIONAL METHOD | PRESENT INVENTION | REDUCTION PERCENTAGE (%) |
|---|---|---|---|---|
| BOARD 1 | 2746 | 42 | 26 | 38.1 |
| BOARD 2 | 39640 | 77 | 70 | 9.1 |
| BOARD 3 | 11904 | 70 | 48 | 31.4 |
| BOARD 4 | 15278 | 90 | 65 | 27.8 |
| BOARD 5 | 17886 | 120 | 88 | 26.7 |

# FIG.51

|  | UNIT INTERVAL (mm) | BEAM SCANNING NUMBER | STAGE MOVING NUMBER |
|---|---|---|---|
| HALVING (CONVENTIONAL METHOD 1) | 220.88 | 26111 | 71 |
| HEAD OF PATTERN (CONVENTIONAL METHOD 2) | 242.29 | 26900 | 71 |
| OPTIMAL POSITION (PRESENT INVENTION) | 211.34 | 24555 | 71 |

# FIG.54

| PERFORATION POSITION NUMBER | CONVENTIONAL METHOD | METHOD ACCORDING TO INVENTION | IMPROVEMENT |
|---|---|---|---|
| 100 | 4519 | 2838 | 62.8 |
| 500 | 1697 | 1190 | 70.1 |
| 1000 | 1445 | 849 | 58.8 |
| (UNIT) | $\mu$m | $\mu$m | % |

# FIG.50

STAGE MOVING NUMBER

BEAM SCANNING NUMBER

OPTIMAL POSITION
(BEAM SCANNING 24627 TIMES)

CONVENTIONAL METHOD 1
HEAD OF PATTERN
(ABOUT 27000 TIMES)

CONVENTIONAL METHOD 2
HALVING (26111 TIMES)

BEAM SCANNING NUMBER

STAGE MOVING NUMBER

UNIT INTERVAL A

EP 1 211 583 A2

FIG.52

CONVENTIONAL PATH

PATH AFTER PRESENT INVENTION IS APPLIED
(ACCORDING TO 3-OPT METHOD)

# FIG.53

# FIG.55

# FIG.56

EP 1 211 583 A2

# FIG.57

# FIG.58

```
struck kdnode  {
     int          bucket;
     int          cutdim;
     float        cutval;
     kdnode  *loson,   *hison;
     int          lopt,   hipt;

};
```

74

FIG.59

LIST POINTS IN THIS REGION

FIG.60

NEAREST NEIGHBOR POINT
(NEIGHBOR - LIST 1)

NEIGHBOR - LIST 3

POINT OF INTEREST

NEIGHBOR - LIST 2

FIG.61

START POINT
(END POINT)

# FIG.62

VARIATION OF AREA
DETERMINING METHOD

GENERATE INITIAL SOLUTION x — 501

SUBSTITUTE y WITH x — 502

SEARCH IN NEIGHBORHOOD
N(y) FOR SOLUTION y — 503

504

SOLUTION z
BETTER THAN y
DISCOVERED?

NO

YES 505

SUBSTITUTE y WITH x

506

SET y AS SOLUTION

END

# FIG.63

TOP-DOWN APPROACH IN NEAREST NEIGHBOR POINT SEARCH

SET PRESENT NODE AS ROOT NODE, SET NEAREST NEIGHBOR POINT TO SUFFICIENTLY LARGE VALUE — 1001

1002
PRESENT NODE= LEAF NODE? — YES

NO

1003
ACCESS ALL POINT DATA AND UPDATE IF NEAREST NEIGHBOR POINT IS DISCOVERED

1004
BETWEEN LEFT AND RIGHT CHILD NODES, WHICH REGION IS SEARCHED WITH PRIORITY?

LEFT CHILD | RIGHT CHILD

1005
TOP-DOWN SEARCH FOR PARTIAL TREE HAVING LEFT CHILD OF PRESENT NODE AS ROOT

1006
TOP-DOWN SEARCH FOR PARTIAL TREE HAVING RIGHT CHILD OF PRESENT NODE AS ROOT

1007
SEARCH OF RIGHT CHILD REGION OF PRESENT NODE NECESSARY? — NO

1008
SEARCH OF LEFT CHILD REGION OF PRESENT NODE NECESSARY? — NO

YES 1009

YES 1010

1009
TOP-DOWN SEARCH FOR PARTIAL TREE HAVING RIGHT CHILD OF PRESENT NODE AS ROOT

1010
TOP-DOWN SEARCH FOR PARTIAL TREE HAVING LEFT CHILD OF PRESENT NODE AS ROOT

TOP-DOWN SEARCH FOR PARTIAL TREE HAVING PRESENT NODE AS ROOT

END

# FIG.64

NEAREST NEIGHBOR
POINT ALREADY
DISCOVERED

PRESENTLY
SEARCHED
REGION

POINT OF
INTEREST

REGION WITHOUT
OVERLAPPING
(NOT NECESSARY
TO BE SEARCHED)

TRUE NEAREST
NEIGHBOR POINT

REGION WITH OVERLAPPING
(NECESSARY TO BE SEARCHED)

# FIG.65

BOTTOM-UP APPROACH
IN NEAREST NEIGHBOR
POINT SEARCH

SET PRESENT NODE AS LEAF NODE
HAVING A POINT OF INTEREST WHOSE
NEAREST NEIGHBOR POINT IS SEARCHED — 2001

TOP-DOWN SEARCH FOR PARTIAL TREE
HAVING PRESENT NODE AS ROOT — 2002

2003
REGION OUTSIDE
PRESENT NODE REGION MUST
BE SEARCHED?  NO

YES

LOOP
PROCESSING

2005
⟨LOOP EXIT
DETERMINATION ①⟩
PRESENT NODE=ROOT?  YES

NO

2006
REGION
REPRESENTED BY
BROTHER NODE OF PRESENT NODE
MUST BE SEARCHED
?  NO

UPDATE PRESENT
NODE TO PARENT — 2009  YES
NODE

2007
TOP-DOWN SEARCH FOR PARTIAL TREE
HAVING BROTHER NODE OF PRESENT
NODE AS ROOT

2008
⟨LOOP EXIT
DETERMINATION ②⟩ REGION
OUTSIDE REGION REPRESENTED BY PARENT
NODE OF PRESENT NODE MUST
BE SEARCHED ?  NO

YES

END

FIG.66

NEAREST NEIGHBOR
POINT IN REGION D

RADIUS=Q₁−Q₂ DISTANCE

POINT OF
INTEREST

Q₂

TRUE
SHORTEST
DISTANCE

Q₁

Q₃

Q₄

RADIUS=Q₁−Q₃ DISTANCE

A

A

B          C

D    E    F    G

H    I

D

E

B

C

H          I

F

G

EP 1 211 583 A2

# FIG.67

AREA Q

FOR EQUAL HOLE
PLACEMENT BETWEEN
AREAS, ONE PATH
PLAN IS SUFFICIENT

AREA P

FOR RELATIVELY
EQUAL HOLE
PLACEMENT AS
A WHOLE, ONE PATH
PLAN IS SUFFICIENT

AREA S

AREA R

# FIG.68

80

LASER DRILLING
MACHINE

82

USER PC

84

BROWSER

86

JAVA APPLET

88

CAD DATA

URL

HTML

APPLET
REQUEST

DOWNLOAD

FILES FOR
CONVERSION
TRANSMITTED

FILES
RETURNED

90

SUPPORT CENTER PC

92

WEB SERVER

94

JAVA APPLET

96

WORKING ORDER
OPTIMIZATION
APPLICATION

100

# FIG.69

USER

SUPPORT CENTER

3001

ACCESS SUPPORT CENTER
HOMEPAGE WITH BROWSER

3002

RETURN HTML DATA

3003

ACCESS CONVERSION
SERVICE PAGE

3004

TRANSMIT JAVA APPLET

3005

INPUT NECESSARY
CONDITIONS, SELECT FILES
FOR WORKING ORDER
OPTIMIZATION, EXECUTE
CONVERSION

3006

RECEIVE CONDITIONS, FILES
EXECUTE WORKING ORDER
OPTIMIZATION APPLICATION,
PRODUCE AND RETURN
CONVERTED FILES

3007

RECEIVE, SAVE, AND
TRANSFER FILES TO
WORKING MACHINE TO
EXECUTE WORKING

# FIG.70

# FIG.71

# FIG.72

NORMAL SCANNING

SCANNING
DIRECTION

SCANNING IN OBLIQUE DIRECTION →
SUBJECT POINT COORDINATES TO
CONCENTRIC ROTATION TRANSFORMATION

$\theta$

SCANNING
DIRECTION